# EUROPEAN PATENT APPLICATION

(11) **EP 2 636 940 A1**
(43) Date of publication of application: **11.09.2013**
(21) Application number: 11837715.9
(22) Date of filing: 18.10.2011
(51) Int. Cl.: F21S 2/00, F21S 8/04, F21Y 101/02

(54) **BULB-TYPE LAMP AND ILLUMINATING DEVICE**

(30) Priority: 04.11.2010 JP 2010247933; 04.11.2010 JP 2010247932; 04.11.2010 JP 2010247921; 04.11.2010 JP 2010247920
(71) Applicant: Panasonic Corporation, Osaka 571-8501 (JP)
(72) Inventor: TAKEUCHI, Nobuyoshi, Osaka 540-6207 (JP); MATSUDA, Tsugihiro, Osaka 540-6207 (JP); NAGAI, Hideo, Osaka 540-6207 (JP); MIKI, Masahiro, Osaka 540-6207 (JP); UEMOTO, Takaari, Osaka 540-6207 (JP); KAKUNO, Yoshinori, Osaka 540-6207 (JP)
(74) Representative: Appelt, Christian W.
(86) International application number: PCT/JP2011/005808
(87) International publication number: WO 2012/060061

(57) **Abstract**

A light bulb shaped lamp (100) includes: an LED module (200) including: a base mount (210); and a semiconductor light-emitting device (300) mounted on the base mount (210); and lead wires (170a, 170b) for supplying power to the LED module (200). The base mount (210) is supported by the lead wires (170a, 170b).

## Description

### [Technical Field]

The present invention relates to a light bulb shaped lamp having a semiconductor light-emitting device and a lighting apparatus which includes the light bulb shaped lamp.

### [Background Art]

Compared to conventional illumination light source, light-emitting diodes (LED) which are semiconductor light-emitting devices are small, have high efficiency and long product life. Recent market needs for saving energy and resource boosts the demand for light bulb shaped lamps using LEDs (hereafter simply referred to as "LED light bulb") and lighting apparatuses including the LED light bulbs, replacing conventional incandescent light bulbs using filament coils.

Known properties of LEDs include reduced light output as temperature increases, which lead to shorter product life. In response to this problem, a metal case is provided between a semispherical globe and a base in a conventional LED light bulb so as to suppress the increase in the temperature of LED (for example, see Patent Literature 1). The metal case functions as a heat sink for radiating heat generated in LED to outside, making it possible to suppress the increase in the temperature of LED and prevent reduction in the light output.

### [Citation List]

[Patent Literature 1] Japanese Unexamined Patent Application Publication No. 2006-313717

### [Summary of Invention]

### [Technical Problem]

However, in the conventional LED light bulb described above, LEDs are provided on the surface of the metal case in the globe. More specifically, the conventional LED light bulb has a configuration in which all of the light emitted by the LED travelling toward the base is blocked. Accordingly, there is a problem with the conventional LED light bulb that the most of the light emitted by the LED (semiconductor light-emitting device) is blocked by the case.

The present invention has been conceived to solve the problem described above, and it is an object of the present invention to provide a light bulb shaped lamp and others which suppresses the possibility of most of the light emitted by the semiconductor light-emitting device being blocked.

### [Solution to Problem]

In order to solve the problem described above, the lightbulb-shaped lamp according to an aspect of the present invention includes a light-emitting module including: a base mount; and a semiconductor light-emitting device mounted on the base mount; and a lead wire for supplying power to the light-emitting module, in which the base mount is supported by the lead wire.

Accordingly, it is possible to suppress that a large amount of light emitted by the semiconductor light-emitting device is blocked.

It is preferable that the lead wire includes an elastic part which is elastic.

Stated differently, the lightbulb-shaped lamp includes a base mount and a light-emitting module having a semiconductor light-emitting device mounted on the base mount, and the lead wire for supplying power to the light-emitting module. The base mount on which the semiconductor light-emitting device is mounted is supported by the lead wire having an elastic part which is elastic.

Accordingly, even when the lightbulb-shaped lamp is shaken at the time of transportation by a truck, the elastic part suppresses (reduces) the vibration transmitted to the base mount. Accordingly, even when the lightbulb-shaped lamp is shaken, it is possible to reduce the possibility of malfunction caused by the vibration.

Here, for example, a lightbulb-shaped lamp (hereafter referred to as a solder-connected lamp) having a structure in which the end portion of the lead wire and the base mount are connected by solder is listed as an example. Furthermore, the lead wire of the solder-connected lamp does not have an elastic part.

In this case, when the solder-connected lamp is shaken, the vibration transmitted to the base mount is not suppressed. Accordingly, stress is exerted on the part connecting the lead wire and the base mount, and there is a possibility that the lead wire and the base mount are disconnected. Stated differently, the malfunction due to the vibration is a malfunction such as disconnection between the lead wire and the base mount.

Accordingly, the lightbulb-shaped lamp according to an aspect of the present invention can suppress the possibility of malfunction when the lightbulb-shaped lamp is shaken.

It is preferable that the elastic part is provided in the vicinity of the base mount.

With this structure, it is possible to reduce the vibration transmitted to the base mount further.

It is preferable that the base mount has a first surface and a second surface opposite to the first surface, and the base mount has a hole passing through the base mount from the first surface to the second surface.

It is preferable that the lead wire is provided such that a part of the lead wire passes through the hole from the second surface toward the first surface of the base mount, the elastic part is at least a part of the lead wire not passing though the hole, and the base mount is supported by the elastic part of the lead wire.

It is preferable that a hole fixed part inserted into the hole and fixed to the hole is formed at an end portion of the lead wire, the hole fixed part includes a board-shaped supporting part and a conductive lead fixed to a main surface of the supporting part, a part of the lead passes through the hole from the second surface toward the first surface of the base mount and is crimped such that the part of the lead contacts the first surface of the base mount, and the supporting part supports a periphery of the hole on the second surface of the base mount.

With this, the lead wire can be fixed to the base mount firmly.

It is preferable that the hole is filled with a conductive component electrically connected to the semiconductor light-emitting device, and the lead wire is electrically connected to the conductive component from a side closer to the second surface of the base mount.

It is preferable that a bent part clipping an end portion of the base mount is formed at an end portion of the lead wire.

With this, the lead wire can be fixed to the base mount firmly.

It is preferable that an end portion fixing part clipping an end portion of the base mount is provided at the end portion of the base mount, and the end portion of the lead wire is connected to the end portion fixing part.

It is preferable that the light bulb shaped lamp includes a plurality of the lead wires, in which a bent part is formed at an end portion of each of the lead wires, and each of the bent parts in the lead wires clips one of the end portions of the base mount.

With this, the base mount can be fixed firmly.

It is preferable that at least two end portions of the base mount clipped by the bent parts are parallel to the same direction.

It is preferable that at least two end portions of the base mount clipped by the bent parts are corners of the base mount.

It is preferable that the light bulb shaped lamp further includes a plurality of the base mounts, in which the semiconductor light-emitting device is mounted on each of the base mounts, the base mounts are integrated by a connecting part having a shape for integrating the base mounts, and an end portion of at least one of the base mounts integrated is supported by the lead wire.

It is preferable that the light bulb shaped lamp further includes at least two of the lead wires, in which the integrated base mounts are supported by the at least two lead wires.

It is preferable that an end portion fixing part is provided at each of at least two end portions of the integrated base mounts, the end portion fixing part clipping a corresponding one of the two end portions, and the two lead wires are connected to the two end portion fixing parts.

It is preferable that the elastic part is U-shaped.

It is preferable that an end portion clipping part is formed at an end portion of the lead wire, the end portion clipping part clipping an end portion of the base mount, and the base mount is clipped and supported by the end portion clipping part in the lead wire.

Stated differently, in the lightbulb-shaped lamp, the base mount on which the semiconductor light-emitting device is mounted is clipped and supported by the end portion clipping part of the lead wire.

Accordingly, the base mount on which the semiconductor light-emitting device is mounted is fixed firmly.

It is preferable that the end portion clipping part is a bent part which is the end portion of the lead wire bent.

It is preferable that the bent part is U-shaped.

It is preferable that a shape of a main surface of the base mount is a quadrilateral, and the end portion clipping part clips a part of the base mount corresponding to one side of the quadrilateral.

It is preferable that the light bulb shaped lamp further includes a plurality of the lead wires, in which a plurality of the end portion clipping parts are provided such that each of the end portion clipping parts is provided for a corresponding one of the lead wires and clips a corresponding one of a plurality of end portions of the base mount.

It is preferable that each of the end portion clipping parts is a bent part which is the end portion of the lead wire corresponding to the end portion clipping part.

It is preferable that at least two end portions of the base mount clipped by the bent parts are parallel to the same direction.

It is preferable that at least two end portions of the base mount clipped by the bent parts are corners of the base mount.

It is preferable that the light bulb shaped lamp further includes a plurality of the base mounts, in which the semiconductor light-emitting device is mounted on each of the base mounts, the base mounts are integrated by a connecting part having a shape for integrating the base mounts, the end portion clipping part clipping at least one of the base mounts integrated is formed at the end portion of the lead wire, and at least one of the base mounts integrated is supported by the lead wire.

It is preferable that the light bulb shaped lamp further includes at least two of the lead wires, in which the end portion clipping part is formed at the end portion of each of the two lead wires, the end portion clipping part being for clipping a different end portion of the integrated base mounts, and
the integrated base mounts are supported by the at least two lead wires.

It is preferable that a shape of a main surface of each of the base mounts is a quadrilateral, and the end portion clipping part clips a part corresponding to one side of a quadrilateral of a different base mount.

It is preferable that the base mount has a hole passing through the base mount, the hole is filled with a conductive component electrically connected to the semiconductor light-emitting device, the conductive component is connected to the lead wire, and the base mount is supported by the lead wire connected to the conductive component.

The base mount has the hole and the hole is filled with conductive component. The base mount on which the semiconductor light-emitting device is mounted is supported by the lead wire connected to the conductive component.

Accordingly, the conductive component filling the hole of the base mount is fixed to the base mount firmly. The base mount is supported by the lead wire connected to the conductive component. Accordingly, the base mount on which the semiconductor light-emitting device is mounted is fixed firmly.

It is preferable that the base mount has a first surface and a second surface opposite to the first surface, an end portion of the lead wire is bent such that a part parallel to the second surface is formed, and the part of the end portion of the lead wire parallel to the second surface is connected to the conductive component.

It is preferable that the base mount has a first surface and a second surface opposite to the first surface, and the lead wire is electrically connected to the conductive component from a side closer to the second surface of the base mount.

It is preferable that the conductive component is composed of cermet.

It is preferable that the base mount has a hole passing through the base mount, a hole fixed part inserted into the hole and fixed to the hole is formed at an end portion of the lead wire, and the base mount is supported by the lead wire.

The base mount has the hole. The base mount on which the semiconductor light-emitting device is mounted is supported by the lead wires having the hole fixed part inserted into the hole and fixed with the hole at the end.

Stated differently, the hole fixed part is fixed in the hole in the base mount. The base mount is supported by the lead wire having the hole fixed part at the end. Accordingly, the base mount on which the semiconductor light-emitting device is mounted is fixed firmly.

It is preferable that the base mount has a first surface and a second surface opposite to the first surface, the hole passes through the first surface and the second surface, and the hole fixed part is fixed to the hole by clipping the base mount in a peripheral part of the hole on the first surface and in a peripheral part of the hole on the second surface.

Accordingly, the hole fixed part is firmly fixed to the hole.

It is preferable that the hole fixed part and the lead wire are integrally formed.

It is preferable that the base mount has a first surface and a second surface opposite to the first surface, the light bulb shaped lamp further comprises a fixing part which fixes the lead wire, with a part of the lead wire exposed, the fixing part includes a rod part which is rod-shaped, the fixing part is provided on a side closer to the second surface of the base mount, and the second surface of the base mount is fixed to a tip of the rod part of the fixing part.

With this, the base mount can be fixed more firmly.

It is preferable that the second surface of the base mount is fixed to the tip of the rod part of the fixing part by adhesive.

With this, the base mount can be fixed more firmly.

It is preferable that the fixing part is made of a material transparent to visible light.

With this, it is possible to suppress the amount of light emitted by the semiconductor light-emitting device lost by the fixing part.

It is preferable that the light bulb shaped lamp further includes a plurality of the base mounts, in which the semiconductor light-emitting device is mounted on each of the base mounts, each of the base mounts has a first hole and a second hole that pass through the base mount, a plurality of the hole fixed parts are fixed to the first hole and the second hole in the base mount, the base mounts are arranged such that one end portions of the base mounts are close to one another, the second holes are provided in the one end portions of the base mounts close to one another, the base mounts are integrated by a connecting part integrating the hole fixed parts fixed to the second holes in the base mounts, the hole fixed part fixed to the first hole provided in at least one of the base mounts integrated is formed at an end portion of the lead wire, and at least one of the base mounts integrated is supported by the lead wire.

It is preferable that the light bulb shaped lamp further includes at least two of the lead wires, in which a plurality of the hole fixed parts are formed at end portions of the two lead wires and at the base mounts integrated, and
the integrated base mounts are supported by the at least two lead wires.

The lighting apparatus according to an aspect of the present invention includes the lightbulb-shaped lamp.

### [Advantageous Effects of Invention]

According to the present invention, it is possible to suppress that a large amount of light emitted by the semiconductor light-emitting device is blocked.

### [Brief Description of Drawings]

[FIG. 1] FIG. 1 is a perspective view of the light bulb shaped lamp according to the embodiment 1.
[FIG. 2] FIG. 2 is an exploded perspective view of the light bulb shaped lamp according to the embodiment 1.
[FIG. 3] FIG. 3 is a front view of the light bulb shaped lamp according to the embodiment 1.
[FIG. 4] FIG. 4 is a cross-sectional view illustrating the configuration of an LED module.
[FIG. 5] FIG. 5 is a diagram for describing the shape of base mount.
[FIG. 6] FIG. 6 is a diagram illustrating the configuration of a semiconductor light-emitting device and the part around the semiconductor light-emitting device.
[FIG. 7] FIG. 7 illustrates the configuration of a lighting circuit.
[FIG. 8] FIG. 8 is a diagram for describing the fixing structure according to the embodiment 1.
[FIG. 9] FIG. 9 is a diagram for describing the fixing structure according to the variation 1 of the embodiment 1.
[FIG. 10] FIG. 10 is a cross-sectional view for describing the fixing structure according to the variation 2 of the embodiment 1.
[FIG. 11] FIG. 11 is a cross-sectional view for describing the fixing structure according to the variation 3 of the embodiment 1.
[FIG. 12] FIG. 12 is a cross-sectional view for describing the fixing structure according to the variation 4 of the embodiment 1.
[FIG. 13] FIG. 13 is a cross-sectional view for describing the fixing structure according to the variation 5 of the embodiment 1.
[FIG. 14] FIG. 14 is a diagram for describing the fixing structure according to the variation 6 of the embodiment 1.
[FIG. 15] FIG. 15 is a diagram for describing the fixing structure according to the variation 7 of the embodiment 1.
[FIG. 16] FIG. 16 is a diagram for describing the fixing structure according to the variation 8 of the embodiment 1.
[FIG. 17] FIG. 17 is a diagram for describing the fixing structure according to the variation 9 of the embodiment 1.
[FIG. 18] FIG. 18 is a diagram for describing the fixing structure according to the variation 10 of the embodiment 1.
[FIG. 19] FIG. 19 is a diagram for describing the fixing structure according to the variation 11 of the embodiment 1.
[FIG. 20] FIG. 20 is a diagram for describing the fixing structure according to the variation 12 of the embodiment 1.
[FIG. 21] FIG. 21 is a diagram for describing the fixing structure according to the variation 13 of the embodiment 1.
[FIG. 22] FIG. 22 is a diagram for describing the fixing structure according to the variation 14 of the embodiment 1.
[FIG. 23] FIG. 23 is a perspective view of the light bulb shaped lamp according to the embodiment 2.
[FIG. 24] FIG. 24 is an exploded perspective view of the light bulb shaped lamp according to the embodiment 2.
[FIG. 25] FIG. 25 is a front view of the light bulb shaped lamp according to the embodiment 2.
[FIG. 26] FIG. 26 is a cross-sectional view illustrating the configuration of an LED module.
[FIG. 27] FIG. 27 is a diagram for illustrating the shape of base mount.
[FIG. 28] FIG. 28 is a cross-sectional view for describing the fixing structure according to the variation 1 of the embodiment 2.
[FIG. 29] FIG. 29 is a diagram for describing the fixing structure according to the variation 2 of the embodiment 2.
[FIG. 30] FIG. 30 is a diagram for describing the fixing structure according to the variation 3 of the embodiment 2.
[FIG. 31] FIG. 31 is a diagram for describing the fixing structure according to the variation 4 of the embodiment 2.
[FIG. 32] FIG. 32 is a diagram for describing the fixing structure according to the variation 5 of the embodiment 2.
[FIG. 33] FIG. 33 is a diagram for describing the fixing structure according to the variation 6 of the embodiment 2.
[FIG. 34] FIG. 34 is a diagram for describing the fixing structure according to the variation 7 of the embodiment 2.
[FIG. 35] FIG. 35 is a diagram for describing the fixing structure according to the variation 8 of the embodiment 2.
[FIG. 36] FIG. 36 is a diagram for describing the fixing structure according to the variation 9 of the embodiment 2.
[FIG. 37] FIG. 37 is a diagram for describing the fixing structure according to the variation 10 of the embodiment 2.
[FIG. 38] FIG. 38 is a perspective view of the light bulb shaped lamp according to the embodiment 3.
[FIG. 39] FIG. 39 is an exploded perspective view of the light bulb shaped lamp according to the embodiment 3.
[FIG. 40] FIG. 40 is a front view of the light bulb shaped lamp according to the embodiment 3.
[FIG. 41] FIG. 41 is a cross-sectional view illustrating the configuration of an LED module.
[FIG. 42] FIG. 42 is a diagram for illustrating the shape of base mount.
[FIG. 43] FIG. 43 is a cross-sectional view for describing the fixing structure according to the variation 1 of the embodiment 3.
[FIG. 44] FIG. 44 is a cross-sectional view for describing the fixing structure according to the variation 2 of the embodiment 3.
[FIG. 45] FIG. 45 is a diagram for describing the fixing structure according to the variation 3 of the embodiment 3.
[FIG. 46] FIG. 46 is a perspective view of the light bulb shaped lamp according to the embodiment 4.
[FIG. 47] FIG. 47 is an exploded perspective view of the light bulb shaped lamp according to the embodiment 4.
[FIG. 48] FIG. 48 is a front view of the light bulb shaped lamp according to the embodiment 4.
[FIG. 49] FIG. 49 is a cross-sectional view illustrating the configuration of an LED module.
[FIG. 50] FIG. 50 is a diagram for describing the fixing structure according to the embodiment 4.
[FIG. 51] FIG. 51 is a cross-sectional view for describing the fixing structure according to the variation 1 of the embodiment 4.
[FIG. 52] FIG. 52 is a cross-sectional view for describing the fixing structure according to the variation 2 of the embodiment 4.
[FIG. 53] FIG. 53 is a diagram for describing the fixing structure according to the variation 3 of the embodiment 4.
[FIG. 54] FIG. 54 is a schematic cross-sectional view of the lighting apparatus according to an aspect of the present invention.

### [Description of Embodiments]

The following shall describe embodiments of the present invention with reference to the drawings. In the following description, the same reference numerals are assigned to the same components. The names and the functions of the components are the same as well. Accordingly, detailed description for these components may be omitted.

Note that the size, material, shape and relative arrangement of the components illustrated in the embodiments are appropriately changed depending on the configuration of the device to which the present invention is applied and various conditions. Accordingly, the present invention is not limited by the example. Furthermore, the size of the components in the drawings may be different from the actual size.

### Embodiment 1

### (Overall structure of light bulb shaped lamp)

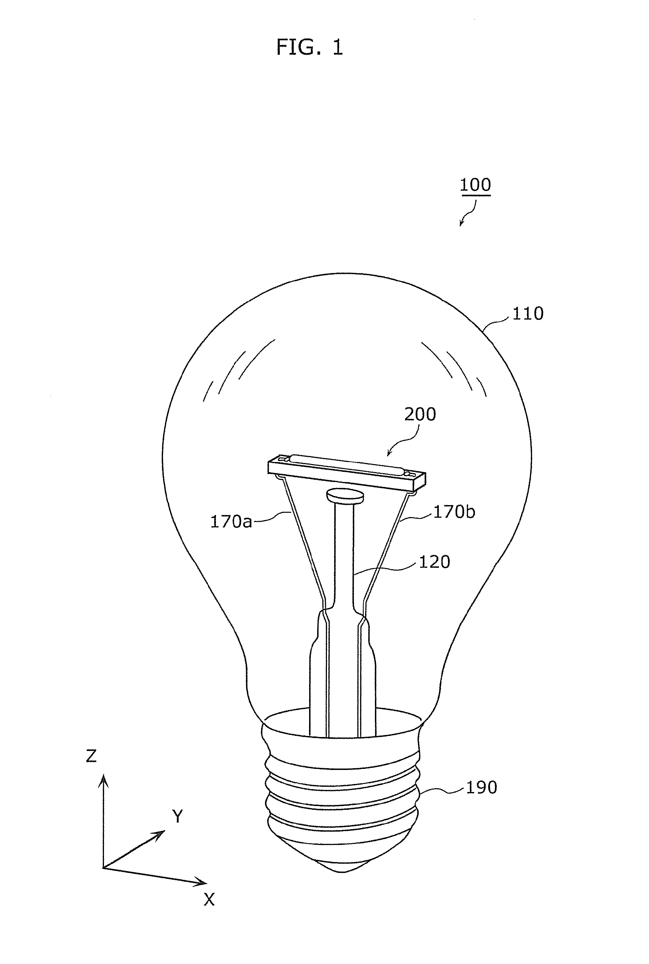

The overall structure of the light bulb shaped lamp 100 according to the embodiment 1 shall be described with reference to FIG. 1 to FIG. 3.

FIG. 1 is a perspective view of the light bulb shaped lamp according to the embodiment 1. In FIG. 1 to FIG. 3, the X, Y, and Z-axis directions are orthogonal to each other. The X, Y, and Z-axis directions in the drawings below are orthogonal to each other.

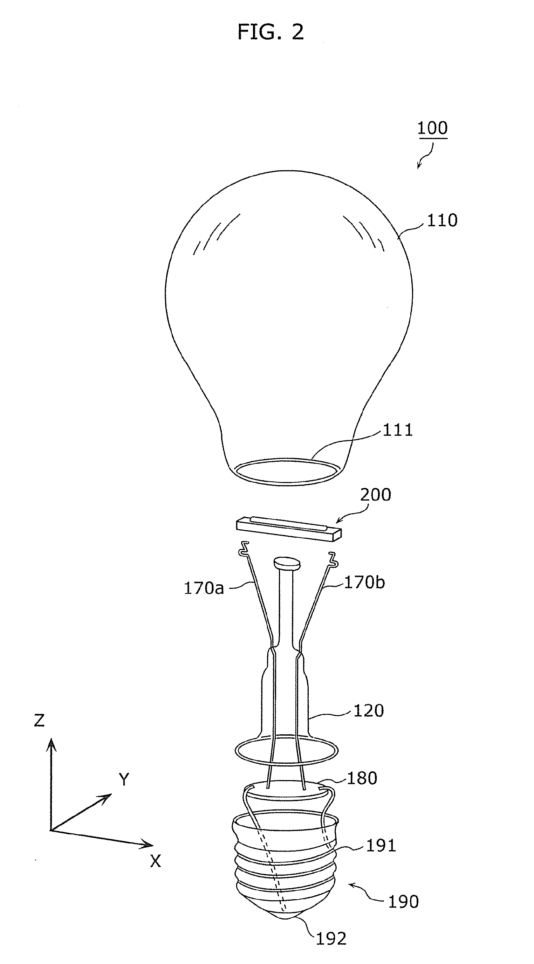

FIG. 2 is an exploded perspective view of the light bulb shaped lamp according to the embodiment 1.

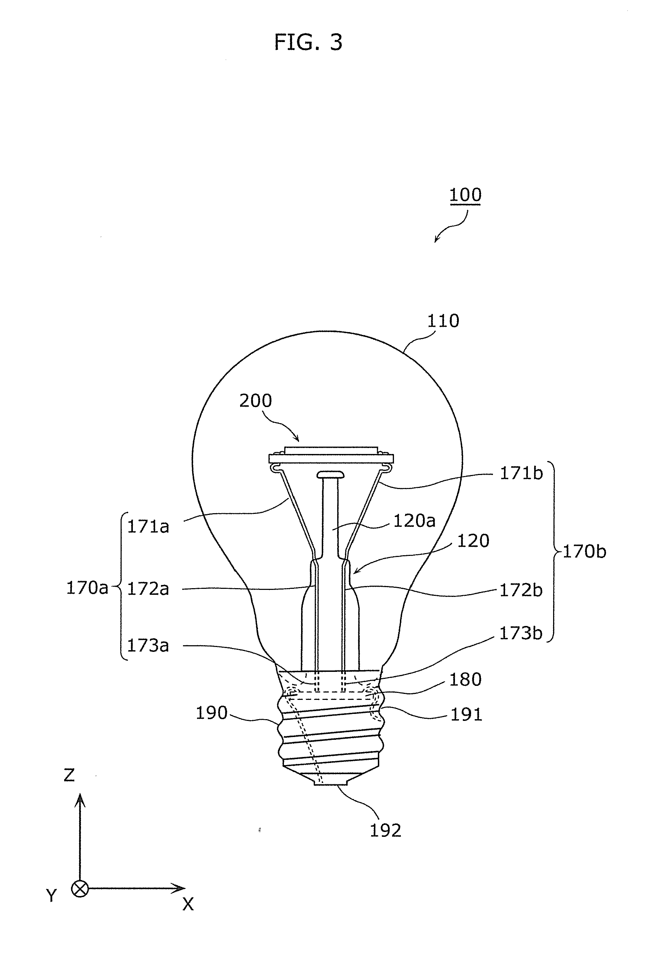

FIG. 3 is a front view of the light bulb shaped lamp according to the embodiment 1. Note that, in FIG. 3, a lighting circuit 180 and part of lead wires 170a and 170b for power supply and for support which are positioned inside a base 190 are illustrated in dotted lines.

The light bulb shaped lamp 100 is a light bulb including a translucent globe 110 and a base 190 attached to the globe 110. An LED module 200 in which a semiconductor light-emitting device is mounted is housed in the globe 110.

More specifically, as illustrated in FIG. 1 to FIG. 3, the light bulb shaped lamp 100 includes the LED module 200, the lead wires 170a and 170b, the globe 110, a fixing part 120, the base 190, and the lighting circuit 180.

The LED module 200 is a light-emitting module which emits illuminating light of a predetermined color. The detailed configuration of the LED module 200 shall be described later. Note that, the LED modules 200A, 201A, 202A, 200N, 200B, 200C, 200D, and 200E are the light-emitting modules similar to the LED module 200.

The lead wires 170a and 170b are electric wires for supplying power to the semiconductor light-emitting device to be described later, and for holding (fixing) the LED module in a specific position in the globe 110. The LED module 200 is electrically connected to the lead wires 170a and 170b.

The lead wire 170a is a composite wire including an internal lead wire 171a, a Dumet wire 172a, and an external lead wire 173a joined in order. The lead wire 170b is a composite wire including an internal lead wire 171b, a Dumet wire 172b, and an external lead wire 173b joined in order.

In the following description, each of the lead wires 170a and 170b may be simply referred to as a lead wire 170. Furthermore, in the following description, each of the internal lead wires 171a and 171b may be simply referred to as an internal lead wire 171. Furthermore, in the following description, each of the Dumet wires 172a and 172b may be simply referred to as a Dumet wire 172. Furthermore, in the following description, each of the external lead wires 173a and 173b may be simply referred to as an external lead wire 173.

The internal lead wire 171 is an electric wire extending from the fixing part 120 to be described later to the LED module 200. The internal lead wire 171 is joined with the base mount 210 to be described later, and supports the LED module 200 (the base mount 210). Stated differently, the base mount 210 to be described later is supported by the lead wires 170a and 170b.

The Dumet wire 172 is sealed in the fixing part 120. The external lead wire 173 is an electric wire extending from the lighting circuit 180 to the fixing part 120. The internal lead wire 171 and the external lead wire 173 are, for example, metal wires containing copper.

Here, it is preferable that the lead wire 170 is a metal wire including copper having high thermal conductivity. With this, the heat generated at the LED module 200 can be actively transferred to the base 190 through the lead wire 170. The lead wire 170 also has strength sufficient for supporting the LED module 200.

Note that, the lead wire 170 is not limited to a composite wire, but may be a single wire composed of the same metal wire. In addition, two lead wires 170 do not have to be provided. For example, when the light bulb shaped lamp 100 includes a plurality of the LED modules 200 in the globe 110, two lead wires 170 may be provided for each of the LED modules 200. Accordingly, the light bulb shaped lamp 100 may include the lead wires 170 twice in number as the number of the LED modules 200.

The fixing part 120 is a stem made of a material transparent to visible light. The transparent material is, for example, soft glass.

With this, the light bulb shaped lamp 100 can reduce the loss of light emitted by the semiconductor light-emitting device 330 to be described later caused by the fixing part 120. The light bulb shaped lamp 100 can also prevent a shadow cast by the fixing part 120. Since the fixing part 120 shines through the light emitted by the semiconductor light-emitting device 300, the light bulb shaped lamp 100 also achieves visually superior appearance.

Note that, it is not necessary for the fixing part 120 to be transparent to the visible light, or to be made of soft glass. For example, the fixing part 120 may be a component made of a highly heat-conductive resin. As the highly heat-conductive resin, silicone resin in which metal particles such as alumina or zinc oxide are mixed may be used.

In this case, the light bulb shaped lamp 100 can actively transfer the heat generated at the LED module 200 to the base 190 through the fixing part 120. As a result, the light bulb shaped lamp 100 is capable of suppressing reduction in light-emission efficacy and reduction in product life of the semiconductor light-emitting device 300 due to increased temperature.

Among the internal lead wire 171, the Dumet wire 172, and the external lead wire 173 composing the lead wire 170, the fixing part 120 seals the Dumet wire 172. To put it differently, the fixing part 120 fixes the lead wire 170 exposing a part of the lead wire 170 (the internal lead wire 171).

The fixing part 120 is provided extending from the opening 110 of the globe 110 toward the inside of the globe 110. More specifically, the fixing part 120 is joined to an edge 111 of the opening of the globe 110 such that the longer direction of the fixing part 120 coincides with the Z-axis direction. In other words, the fixing part 120 according to the embodiment 1 is a component that would be obtained by extending the stem used for a common incandescent light bulb toward the inside of the globe 110

The fixing part 120 includes a rod part 120a having a rod shape.

Note that, the material composing the fixing part 120 is not limited to glass, but may be resin such as acrylic, metal, ceramic, or others.

The globe 110 covers the LED module 200, part of the lead wires 170a and 170b, a part of the fixing part 120, and others. The LED module 200 is positioned at a part around the center of the globe 110. The globe 110 is made of a translucent material. The translucent material is, for example, silica glass transparent to the visible light.

Accordingly, the user can see the LED module 200 housed in the globe 110 from outside of the globe 110. With this, the light bulb shaped lamp 100 can reduce the loss of light emitted by the semiconductor light-emitting device 300 to be described later caused by the globe 110. Furthermore, the light bulb shaped lamp 100 can achieve high heat resistance.

The light from the LED module 200 passes through the globe 110, and is emitted to outside.

Since the LED module 200 is positioned around the center of the globe 110, omnidirectional light distribution property is achieved when the LED module 200 emits light.

Note that, the material composing the globe 110 is not limited to glass, but may be resin such as acrylic.

The globe 110 has a shape with one end closed in a spherical shape, and the other end has an opening. In other words, the shape of the globe 110 is that a part of hollow sphere is narrowed down while extending away from the center of the sphere. The shape of the globe 110 is Type A (JIS C7710) which is the same as a common incandescent light bulb.

Note that, the shape of the globe 110 is not limited to Type A, but may also be Type G, Type E, or others. The globe 110 does not have to be transparent to visible light either, or made of silica glass. For example, the globe 110 may be a component made of resin such as acrylic.

The lower portion of the fixing part 120 is formed in a flared shape coinciding with the shape of the edge 111 at the opening. The lower portion of the fixing part 120 formed in the flared shape is joined to the edge 111 at the opening of the globe 110 so as to close the opening of the globe 110.

With this structure, the inside of the globe 110 is kept airtight, and it is possible to prevent water or vapor from entering the inside of the globe 110. Therefore, it is possible to suppress degradation in the LED module 200 and degradation in the part connected with the lead wire 170 caused by moisture.

Part of the two lead wires 170 are sealed in the fixing part 120. Accordingly, it is possible to supply power to the LED module 200 in the globe 110 from outside of the globe 110 while keeping the globe 110 airtight.

Note that, the fixing part 120 does not necessarily close the opening at the globe 110, and may be attached to the edge 111 of the opening 111.

The base 190 is attached to the globe 110 using an adhesive such as cement to cover the opening of the globe 110. The base 190 is a power receiving part for receiving the AC power. A conductive screw part 191 is formed on an outer side surface of the base 190. An eyelet 192 is formed at the bottom part of the base 190.

The base 190 is an E26 base, for example. The base 190 is attached to a socket for E26 base which is not illustrated. The AC power is supplied to the socket for E26 base from a commercial AC power supply which is not illustrated. More specifically, the screw part 191 and the eyelet 192 in the base 190 are supplied with the AC power from the socket for E26 base which is not illustrated.

Note that, the base 190 is not limited to an E26 base. The base 190 is, for example, an E17 base. Furthermore, the base 190 is not necessarily a screw-in base, but may be a plug-in base, for example.

The lighting circuit 180 is housed inside the base 190. The lighting circuit 180 is electrically connected to the screw part 191 and the eyelet 192. The lighting circuit 180 receives the AC power from the screw part 191 and the eyelet 192. The lighting circuit 180 is electrically connected to the lead wires 170a and 170b.

Although the details shall be described later, the lighting circuit 180 is a circuit for converting the AC power to the DC power.

Note that, the power supplied to the base 190 is not limited to the AC power from a commercial AC power source. The power supplied to the base 190 may be the DC power supplied from a battery, for example. In this case, the lighting circuit 180 is not necessary.

Note that, the base 190 has a structure which allows the base 190 to be directly attached to the opening of the globe 110. However, the structure is not limited to this example. The base 190 may be attached to the globe 110 indirectly. For example, the base 190 may be attached to the globe 110 through a resin part such as a resin case. The resin case may store the lighting circuit and others, for example.

### (The configuration of LED module)

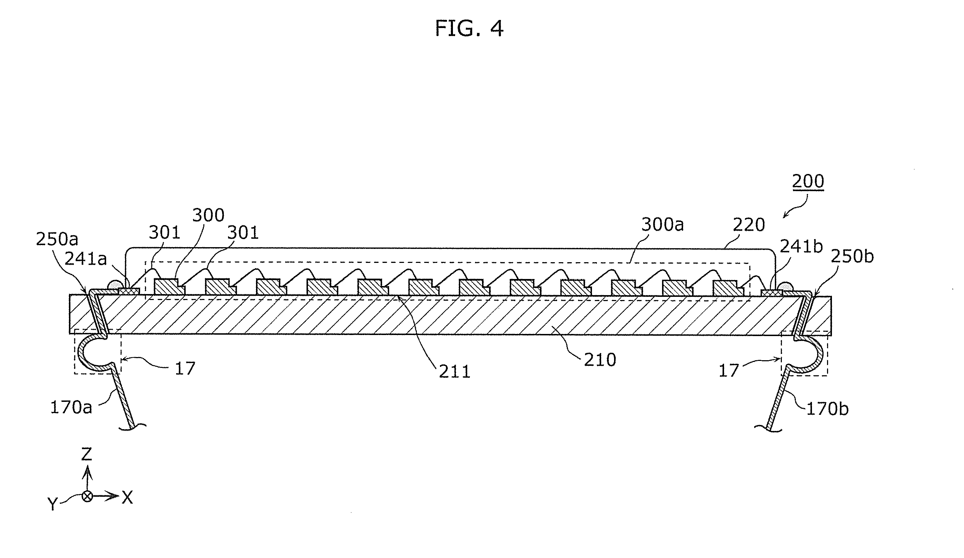

FIG. 4 is a cross-sectional view illustrating the configuration of the LED module 200. Note that, the lead wires 170a and 170b not included in the LED module 200 are also illustrated in FIG. 4.

Note that, the details on the shape of the lead wires 170a and 170b shall be described later.

The LED module 200 is housed in the globe 110, and is preferably positioned at the center of the sphere defined by the globe 110. The center is the center inside of the globe 110 at a part having a large inner-diameter. Since the LED module 200 is provided at the center, the light bulb shaped lamp 100 can achieve omnidirectional light distribution property when the light bulb shaped lamp 100 is switched on. The omnidirectional light distribution property is approximated to a common incandescent light bulb using conventional filament coil.

As shown in FIG. 4, the LED module 200 includes a base mount 210 and a plurality of semiconductor light-emitting devices 300, and a sealing part 220.

The base mount 210 is a component having translucent property with respect to visible light. The component is made of ceramic containing alumina, for example.

Note that, the translucent material is not limited to ceramic, and may be resin, glass, or others.

It is preferable that the base mount 210 is a component having high transmittance of visible light. With this, the light emitted from the semiconductor light-emitting device 300 passes through the inside of the base mount 210, and the light is emitted from a part on which no semiconductor light-emitting device 300 is mounted.

Accordingly, even when the semiconductor light-emitting device 300 is mounted only on one side of the base mount, the light is emitted from the other surfaces, allowing to achieve the light distribution property equivalent to that of an incandescent light bulb.

Note that, only a part of the base mount 210 may be translucent with respect to visible light, instead of the entire base mount 210.

Note that, the base mount 210 does not have to be translucent. In this case, the semiconductor light-emitting device 300 may be mounted on more than one side of the base mount 210, for example.

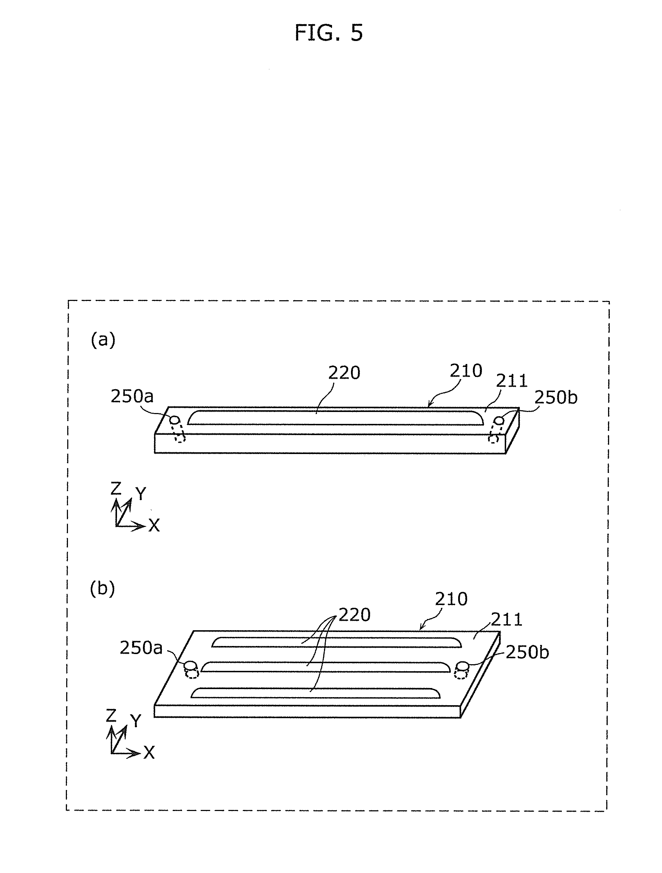

The shape of the base mount 210 is a quadrangular prism, as illustrated in (a) in FIG. 5. Here, the length of the base mount 210 in the X-axis direction is 20 mm, for example. The length (width) of the base mount 210 in the Y-axis direction is 1 mm, for example. The thickness of the base mount 210 in the Z-axis direction is 0.8 mm, for example.

Note that, the shape of the base mount 210 is not limited to the quadrangular prism, and may be other shape. The shape of the base mount 210 may be like a board, as illustrated in FIG. 5 (b). Here, the length of the base mount 210 in the X-axis direction is 20 mm, for example. The length (width) of the base mount 210 in the Y-axis direction is 10 mm, for example. The thickness of the base mount 210 in the Z-axis direction is 0.8 mm, for example.

If the shape of the base mount 210 is a quadrangular prism, the LED module 200 in the light bulb shaped lamp 100 can imitate the filament of an incandescent light bulb.

Note that, the shape and size of the base mount 210 are merely example, and may be in other shapes and sizes. The shape of the base mount 210 may be a hexagonal prism or an octagonal prism, for example.

Conductive power supply terminal 241a or 241b is provided on each of the ends of the base mount 210 in the longer direction (X-axis direction).

End portions of the lead wires 170a and 170b are fixed to the power supply terminals 241a and 241b by solder, respectively. Accordingly, the lead wires 170a and 170b are electrically connected to the power supply terminals 241a and 241b, respectively. Stated differently, the lead wires 170a and 170b are fixed to the base mount 210 (LED module 200).

The base mount 210 has a main surface 211. The semiconductor light-emitting devices 300 are mounted in a straight line on the main surface 211. Stated differently, the semiconductor light-emitting devices 300 are mounted on the main surface 211 of the base mount 210 such that the semiconductor light-emitting devices 300 are arranged in a straight line between the power supply terminal 241a and the power supply terminal 241b.

In the following description, the main surface of the quadrilateral or board-shaped base mount may also be referred to as the first surface. In addition, the surface of the base mount opposite to the first surface is referred to as the second surface. The first surface is the main surface 211, for example. The second surface is the surface opposite to the main surface 211 of the base mount 210. Accordingly, the base mount 210 has the first surface and the second surface.

A group of light-emitting devices 300a is composed of the semiconductor light-emitting devices 300 mounted on the main surface 211 on the base mount 210 in a straight line. The semiconductor light-emitting devices 300 composing the group of the light-emitting devices 300a are connected in series electrically.

The power is supplied to the semiconductor light-emitting devices 300 composing the group of light-emitting devices 300a from the lead wires 170a and 170b. To put it differently, the lead wires 170a and 170b are electric wires for supplying power to the semiconductor light-emitting devices 300. More specifically, the lead wires 170a and 170b are electric wires for supplying power to the LED module 200 as the light-emitting module.

Note that, if the shape of the base mount 210 is a quadrangular prism, the semiconductor light-emitting devices 300 composing the group of light-emitting devices 300a may be formed on a side surface of the base mount 210 different from the main surface 211.

The base mount 210 has holes 250a and 250b. Each of the holes 250a and 250b is a through hole passing through the base mount 210 from the main surface 211 (the first surface) of the base mount 210 toward the second surface opposite to the main surface 211.

In the following description, each of the holes 250a and 250b may be simply referred to as the hole 250 as well. Each of the holes 250 extends diagonal to the Z-axis direction.

Note that, structure of the hole 250 is not limited to the structure in which the hole 250 extends diagonal to the Z-axis direction, and may extend along the Z-axis direction.

Note that, the fixing part 120 is provided on a side closer to a side of the base mount 210 (the second surface) opposite to the main surface 211 (the first surface).

In the following description, the semiconductor light-emitting device 300 on the left end of the semiconductor light-emitting devices 300 composing the group of light-emitting devices 300a in FIG. 4 is also referred to as a left-end semiconductor light-emitting device. In addition, the semiconductor light-emitting device 300 at the right end of the semiconductor light-emitting devices 300 composing the group of light-emitting devices 300a is also referred to as a right-end semiconductor light-emitting device.

The semiconductor light-emitting device 300 is an LED chip which emits blue light, and shall be described in detail later.

The semiconductor light-emitting devices 300 mounted on the main surface 211 are connected in series electrically by the wire 301. The wire 301 is, for example, a gold wire.

The left-end semiconductor light-emitting device is electrically connected to the power supply terminal 241a (lead wire 170a) through the wire 301. The right-end semiconductor light-emitting device is electrically connected to the power supply terminal 241b (lead wire 170b) through the wire 301.

The number of the semiconductor light-emitting device 300 composing the group of light-emitting devices 300a is, for example, 12. Note that the number of semiconductor light-emitting devices 300 composing the group of light-emitting devices 300a is not limited to 12, and may be changed appropriately according to the purpose of the LED module.

The semiconductor light-emitting devices 300 arranged in a straight line and the wires 301 connected to the semiconductor light-emitting devices 300 are sealed by the sealing part 220. The sealing part 220 seals the group of light-emitting devices 300a. The sealing part 220 extends in the X-axis direction. Accordingly, the shape of the sealing part 220 is the straight-line shape. Stated differently, the shape of the sealing part 220 is an elongated shape.

Note that, if the semiconductor light-emitting device 300 is firmly fixed to the base mount 210, the semiconductor light-emitting device 300 may not be sealed by the sealing part 220.

The sealing part 220 is, for example, a translucent resin such as silicone resin. In the sealing part 220, phosphor particles (not illustrated) which is a wavelength conversion material and light diffusion material (not illustrated) are dispersed. The phosphor is a YAG (yttrium, aluminum, and garnet) phosphor ((Y, Gd)₃Al₅O₁₂:Ce³⁺, Y₃Al₅O₁₂:Ce³⁺), for example. The light diffusion material is silica, for example.

The cross-section in X-axis direction of the sealing material 220 formed as described above is dome-shaped, for example. The width of the cross-section is 1 mm, and the height of the cross-section is 0.2 mm, for example.

Note that, as illustrated in (b) in FIG. 5, if the base mount 210 is board-shaped, three sealing parts 220 for sealing the group of light-emitting devices 300a are formed on the main surface 211, for example. Accordingly, three groups of light-emitting devices 300a are formed on the main surface 211 of the base mount 210. In this case, the three groups of the light-emitting devices 300a are electrically connected in series.

Note that, the number of the group of the light-emitting devices 300a formed on the board-shaped base mount (base mount 210) is not limited to three, and may be two or four or more.

The LED module 200 is fixed by the lead wires 170a and 170b such that the main surface 211 of the base mount 210 faces toward the top of the globe 110.

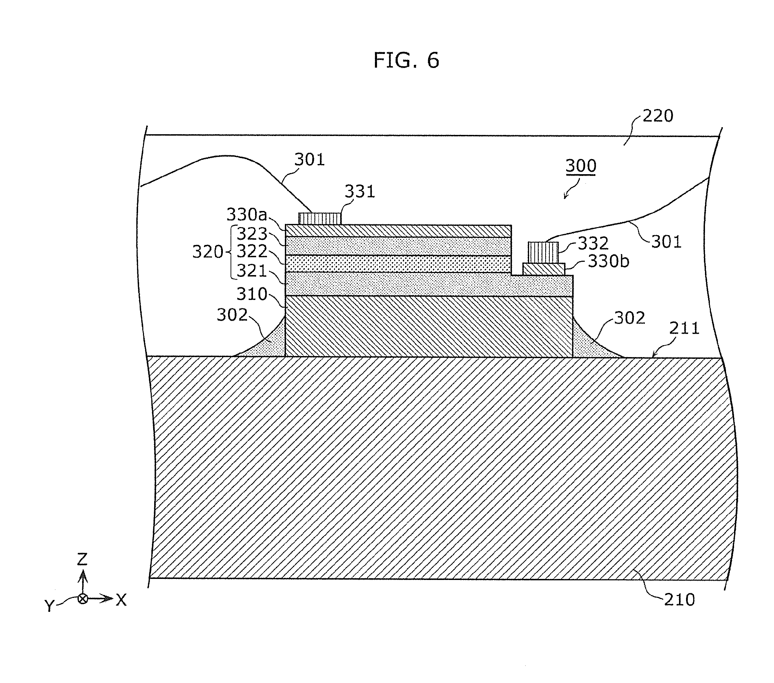

FIG. 6 is a diagram illustrating the configuration of a semiconductor light-emitting device 300 and the part around the semiconductor light-emitting device 300. The semiconductor light-emitting device 300 is a face-up LED chip.

Note that, the semiconductor light-emitting device 300 is not limited to the face-up type, and may be an LED chip of face-down (flip-chip) type. Note that, the semiconductor light-emitting device 300 is not limited to an LED, and may be another device which emits light.

As illustrated in FIG. 6, the semiconductor light-emitting device 300 includes a sapphire board 310, a nitride semiconductor part 320, an anode 330a and a cathode 330b.

The nitride semiconductor part 320 is formed on the sapphire board 310. The nitride semiconductor part 320 includes nitride semiconductor layers 321, 322, and 323, each of which has a different composition. The nitride semiconductor layer 322 is a light-emitting layer (active layer) which emits light.

The anode 330a is formed on the nitride semiconductor part 320 (the nitride semiconductor layer 323). The cathode 330b is formed at an end portion of the nitride semiconductor layer 321.

A wire bonding portion 331 is formed on the anode 330a, and a wire bonding portion 332 is formed on the cathode 330b. The wires 301 are electrically connected to the wire bonding portions 331 and 332. Accordingly, the semiconductor light-emitting device 300 is supplied with power (voltage) through two wires 301.

When power (voltage) is supplied between the anode 330a and the cathode 330b, the light-emitting layer (nitride semiconductor layer 322) emits blue light. Part of the blue light is absorbed by the wavelength conversion material (phosphor) in the sealing part 220, and is converted in to light in another wavelength. If the phosphor is a YAG phosphor, the blue light is converted into yellow light by the wavelength conversion material (phosphor).

The blue light not absorbed by the wavelength conversion material (phosphor) and the yellow light which is converted are diffused and mixed in the sealing part 220. After that, the mixed light is emitted from the sealing part 220 as white light.

Since the base mount 210 is translucent, the white light emitted from the linear sealing part 220 transmits the inside of the base mount 210 and is emitted from the back surface and the side surfaces of the base mount 210.

The sealing part containing the wavelength conversion material is arranged in a straight line on the main surface 211 of the base mount 210. Accordingly, when the light bulb shaped lamp 100 is turned on, the sealing part 220 shines like a filament coil of a conventional incandescent light bulb when viewed from any side of the surface of the base mount 210.

Note that, the sealing part 220 containing the wavelength conversion material may be provided on the back surface of the base mount 210 on which the semiconductor light-emitting devices 300 are not mounted. In this case, the white light is obtained by converting the blue light emitted from the back surface into the yellow light.

The sapphire board 310 is fixed to the main surface of the base mount 210 by the bonding material 302. The semiconductor light-emitting device 300 is fixed to the main surface of the base mount 210 by the bonding material 302.

The bonding material 302 is made of translucent material. The translucent material is, for example, a silicone resin containing filler made of metal oxide. Using the translucent material for the bonding material 302 can reduce the loss of light emitted from the side of the sapphire board 310 and the side surfaces of the sapphire board 310 in the semiconductor light-emitting device 300, preventing the shadow cast by the bonding material 302.

Note that, it is preferable that the base mount 210 is made of a material having a high thermal conductivity and high thermal emissivity in heat radiation. The material is referred to as a hard brittle material, which is a generic term for glass, ceramic, and others.

The emissivity is represented as a value between 0 and 1. 1 is a value representing the black body radiation. The emissivity of the glass or ceramic is in a range from 0.75 to 0.95, which is close to the black body radiation (1), although the value depends on the wavelength band or a state of surface. In terms of practical use, the emissivity of the base mount 210 is preferably 0.8 or higher, and is more preferably 0.9 or higher.

The volume of the LED module 200 is smaller than the entire light bulb shaped lamp 100. Note that, when the heat capacity of the LED module 220 is small, a structure which increases the emissivity of the base mount 210 so as to radiate heat is preferable.

The wavelength conversion material contained in the sealing part 220 is not limited to a YAG phosphor. The wavelength conversion material may be a yellow phosphor such as (Sr, Ba)₂SiO₄:Eu²⁺, Sr₃SiO₅:Eu²⁺, for example. Alternatively, the wavelength conversion material may be a green phosphor such as (Ba, Sr)₂SiO₄:Eu²⁺, Ba₃Si₆O₁₂N₂: Eu²⁺. Alternatively, the wavelength conversion material may be a red phosphor such as CaAlSiN₃:Eu²⁺, Sr₂(Si, Al)₅(N, O)₈:Eu²⁺.

Note that, the material composing the sealing part 220 is not limited to a silicone resin. The material composing the sealing part 220 may be an organic material such as fluorine series resin or an inorganic material such as a low-melting-point glass or a sol-gel glass. Since the inorganic materials are more highly resistant to heat than the organic material, the sealing part 220 made of an inorganic material is advantageous to increase luminance.

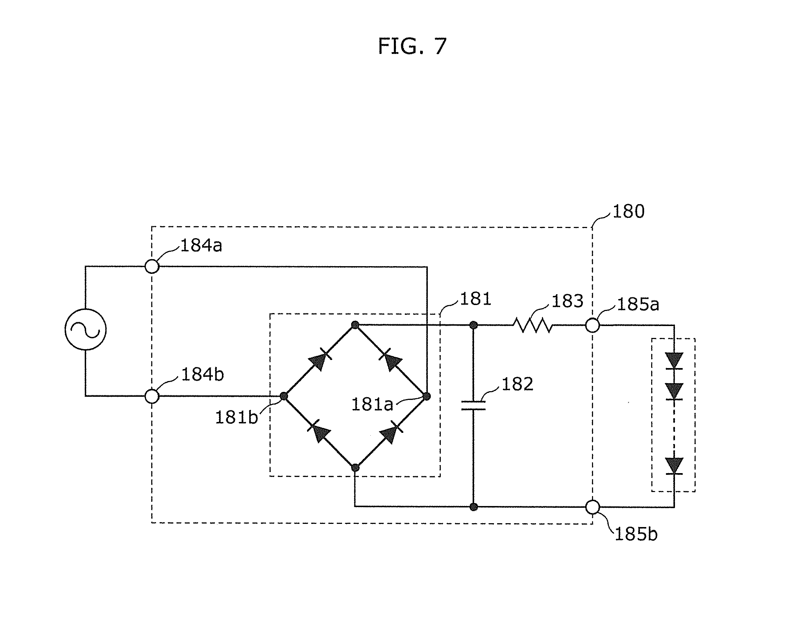

FIG. 7 illustrates the configuration of the lighting circuit 180. The lighting circuit 180 is a full-wave bridge rectification circuit.

As illustrated in FIG. 7, the lighting circuit 180 includes a diode bridge 181, a capacitor 182, a resistor 183, and terminals 184a, 184b, 185a, and 185b.

The input terminals 181a and 181b of the diode bridge 181 are electrically connected to the terminals 184a and 184b, respectively. The terminal 184a is electrically connected to a screw part 191. The terminal 184b is electrically connected to an eyelet 192. With this structure, when the base 190 is attached to a socket of a lighting apparatus not illustrated, the AC power is supplied to the terminals 184a and 184b.

The resistor 183 is a resistor for adjusting the amount of current. An end of the resistor 183 is electrically connected to the terminal 185a. An end of the capacitor 182 is electrically connected to the terminal 185b.

The terminals 185a and 185b are electrically connected to the lead wires 170a and 170b, respectively. The DC power (DC voltage) converted from the AC power by the diode bridge 181 and the capacitor 182 is supplied to the terminals 185a and 185b.

Stated differently, the DC power (DC voltage) converted by the lighting circuit 180 is supplied to the lead wires 170a and 170b.

Note that, the configuration of the lighting circuit 180 is not limited to the configuration including a smoothing circuit illustrated in FIG. 7. The lighting circuit 180 may be a circuit combining a dimming circuit, a boosting circuit, and others.

The following shall describe the structure for fixing the LED module included in the light bulb shaped lamp in detail.

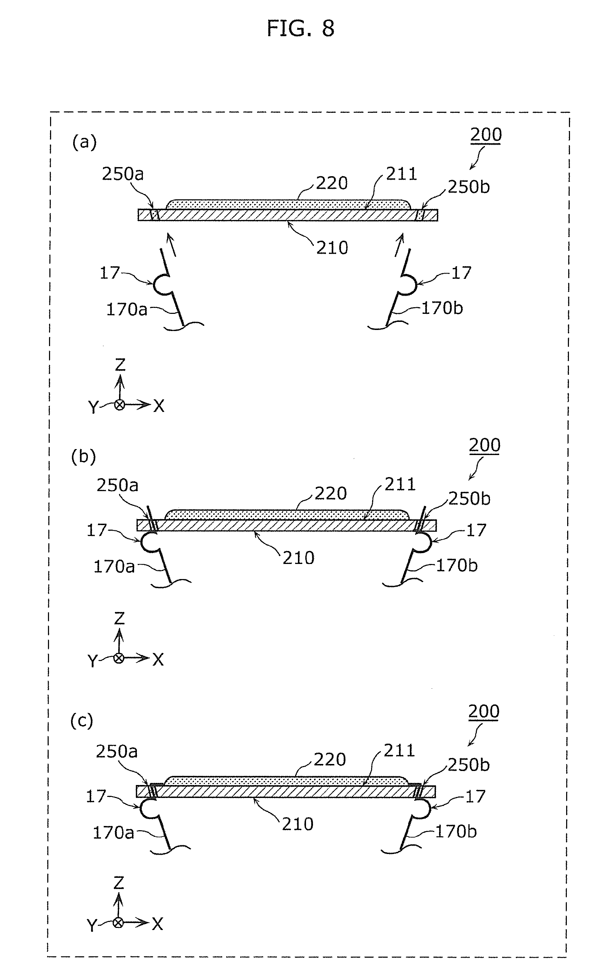

FIG. 8 is a diagram for describing the fixing structure according to the embodiment 1. Here, the fixing structure refers to a structure for fixing the LED module (base mount). The fixing structure for the LED module 200 shall be described in the embodiment 1.

(a) in FIG. 8 is a cross-sectional view illustrating the LED module 200 before being fixed and the lead wires 170a and 170b for fixing the LED module 200.

(b) in FIG. 8 is a cross-sectional view illustrating the LED module 200 before being fixed and the lead wires 170a and 170b.

(c) in FIG. 8 is a cross-sectional view of the LED module 200 supported (held) by the lead wires 170a and 170b. As described before, each of the lead wires 170a and 170b may be simply referred to as the lead wire 170.

As illustrated in FIG. 4 and FIG. 8, the lead wire 170 includes the elastic part 17 which is elastic.

More specifically, the elastic part 17 is formed on each of the lead wires 170a and 170b. The elastic part 17 is a part of each of the lead wires 170a and 170b formed in U-shape. To put it differently, the elastic part 17 is U-shaped.

Note that, as illustrated in (b) in FIG. 8, in each of the lead wires 170, the shape of the part of each of the lead wires 170 closer to the end than the part in which the elastic part 17 is formed is straight before the lead wires 170 are fixed to the base mount 210. In addition, the size of the elastic part 17 in the X-axis direction is larger than the diameter of the holes 250a and 250b.

Accordingly, in the process for fixing each of the lead wires 170 to the base mount 210, when the end portions of the lead wires 170 passes through the hole 250, the uppermost part of the elastic part 17 contacts the base mount 210. With this, the position of the base mount 210 in the globe 110 is fixed (see (b) in FIG. 8).

Stated differently, the elastic part 17 in each of the lead wires 170 is capable of positioning the base mount 210 in the globe 110 in the process for fixing the lead wires 170 to the base mount 210.

Note that, the shape of the elastic part 17 is not limited to the U-shape, and may be in other shape as long as the elastic part 17 is elastic. The elastic part 17 may be spring-shaped or a coil-shaped, for example.

The lead wire 170a is provided such that a part of the lead wire 170a passes through the hole 250a from the second surface which is opposite to the main surface 211 (the first surface) of the base mount 210 toward the main surface 211 (the first surface). The lead wire 170b is provided such that a part of the lead wire 170b passes through the hole 250b from the second surface which is opposite to the main surface 211 (the first surface) of the base mount 210 toward the main surface 211 (the first surface).

The end portion of the lead wire 170a in (b) in FIG. 8 is bent toward the left-end semiconductor light-emitting device in the group of light-emitting devices 300a (see (c) in FIG. 8). The end portion of the lead wire 170a is electrically connected to the wire 301 connected to the wire bonding portion 331 in the left-end semiconductor light-emitting device by solder or others, for example.

The end portion of the lead wire 170b in (b) in FIG. 8 is bent toward the right-end semiconductor light-emitting device in the group of light-emitting devices 300a (see (c) in FIG. 8). The end portion of the lead wire 170b is electrically connected to the wire 301 connected to the wire bonding portion 332 in the right-end semiconductor light-emitting device by solder or others, for example.

The lead wires 170a and 170b are electrically connected to the group of light-emitting devices 300a such that the DC power from the lighting circuit 180 can be supplied to the group of light-emitting group 300a.

The elastic part 17 in each of the lead wires 170 is at least a part of the lead wire 170 not passing through the hole 250.

Stated differently, the base mount 210 is supported by the elastic part 17 of each of the lead wires 170a and 170b. Stated differently, the elastic part 17 is provided in the vicinity of the base mount 210.

With this structure, for example, when the light bulb shaped lamp 100 as a product is transported by a truck, even if the light bulb shaped lamp 100 is shaken, the elastic part 17 absorbs the shake, and suppresses (reduces) the vibration transmitted to the base mount 210 (LED module 200). Accordingly, even if the light bulb shaped lamp is shaken, it is possible to suppress the possibility of malfunction caused by the shake.

Here, as a comparison, a light bulb shaped lamp having a structure in which the end portion of the lead wire and the base mount is connected by solder (hereafter referred to as a solder-connected lamp) shall be described as an example. Unlike the light bulb shaped lamp 100, the lead wire of the solder-connected lamp does not have an elastic part.

In this case, if the solder-connected lamp is shaken, the vibration transmitted to the base mount is not suppressed. This is because the elastic part is not provided. Accordingly, the stress is exerted on the part connecting the lead wire and the base mount, and there is a possibility that the connection between the lead wire and the base mount are disconnected. Stated differently, the malfunction caused by the shake is that the light bulb shaped lamp 100 cannot be turned on due to disconnection between the lead wire and the base mount.

To put it another way, the malfunction caused by the shake is that the solder connecting the lead wire 170 to the base mount 210 comes off and no power is supplied to the semiconductor light-emitting device, resulting in the light bulb shaped lamp 100 unable to be turned on.

Accordingly, the light bulb shaped lamp 100 according to the embodiment 1 can suppress the possibility of the malfunction when the light bulb shaped lamp 100 is shaken.

The base mount 210 on which the semiconductor light-emitting device 300 is mounted is supported by the lead wires 170. With this, it is possible to suppress the large part of the light emitted by the semiconductor light-emitting device 300 mounted on the base mount 210 being blocked.

Furthermore, the base mount 210 is translucent. Accordingly, the base mount 210 transmits the light emitted by the semiconductor light-emitting device 300 mounted on the base mount 210. With this, it is possible to prevent the large part of the light emitted by the semiconductor light-emitting device 300 from being blocked. Accordingly, a sufficient light distribution angle can be achieved.

Note that, the elastic part 17 may be provided in the lead wire 170 at a position away from a predetermined distance from the base mount 210. The predetermined distance corresponds to the length of the elastic part 17 in the Z-axis direction, for example.

### Variation 1 of Embodiment 1

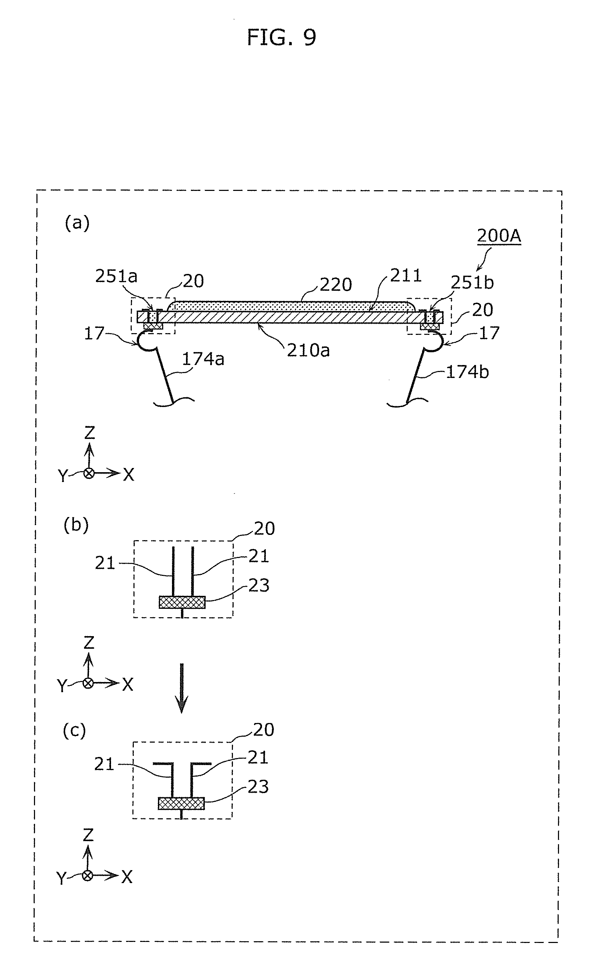

FIG. 9 is a diagram for describing the fixing structure according to the variation 1 of the embodiment 1. The fixing structure for the LED module 200A shall be described in the variation 1 of the embodiment 1.

In the following description, a light bulb shaped lamp having the fixing structure according to the variation 1 of the embodiment 1 may be referred to as a light bulb shaped lamp A11. The light bulb shaped lamp A11 is different from the light bulb shaped lamp 100 in that an LED module 200A is included instead of the LED module 200, and the lead wires 174a and 174b are included instead of the lead wires 170a and 170b. The rest of the structure of the light bulb shaped lamp A11 is identical to the light bulb shaped lamp 100. Accordingly, the description for the structure shall be omitted.

The LED module 200A is different from the LED module 200 illustrated in FIG. 4, FIG. 8, and others in that a base mount 210a is included instead of the base mount 210. The rest of the configuration of the LED module 200A is identical to the LED module 200. Accordingly, the detailed description is not repeated.

The base mount 210a is different from the base mount 210 in that holds 251a and 251b are provided instead of the holes 250a and 250b. The rest of the configuration of the base mount 210a is identical to the base mount 210, and the detailed description is not repeated.

The shape of the base mount 210a is quadrangular prism or board.

Each of the holes 251a and 251b is a through hole passing though the board 210a from the main surface 211 (the first surface) of the base mount 210a toward the second surface which is opposite to the main surface 211. In the following description, each of the holes 251a and 251b may be simply referred to as the hole 251 as well. Each of the holes 251 extends along the Z-axis direction.

(a) in FIG. 9 is a cross-sectional view of the LED module 200A fixed by the lead wires 174a and 174b.

In the following description, each of the lead wires 174a and 174b may be simply referred to as the lead wire 174. The fixing part 120 of the light bulb shaped lamp A11 fixes the lead wire 174 such that a part of the lead wire 174 is exposed, in the same manner as the lead wire 170.

The lead wire 174 is different from the lead wire 170 in FIG. 4 in that a hole fixed part 20 is formed at an end portion of the lead wire 174. Since the rest of the structure and function of the lead wire 174 are identical to those of the lead wire 170, the detailed description shall not be repeated. The lead wires 174a and 174b correspond to the lead wires 170a and 170b, respectively.

The LED module 200A (the base mount 210a) is supported (held) by the lead wires 174a and 174b.

More specifically, the hole fixed part 20 is formed at the end portion of each of the lead wires 174a and 174b. The hole fixed part 20 is a part inserted into the hole 251 and fixed to the hole 251. Stated differently, the hole fixed part 20 is a part which fixes the lead wire 174 to the base mount 210a, using the hole 251.

The hole fixed part 20 is a part in which the end portion of each of the lead wires 174a and 174b is formed in the shape illustrated in (a) and (c) in FIG. 9.

(b) in FIG. 9 is a diagram illustrating the shape of the hole fixed part 20 before fixed to the LED module 200A. As illustrated in (b) in FIG. 9, the hole fixed part 20 includes a plurality of leads 21 and a supporting part 23.

Each of the leads 21 and the supporting part 23 is made of a material (metal) same as the material composing the lead wire 174. The lead 21 is a bendable conductive metal.

The supporting part 23 is board-shaped. The size of the supporting part 23 in the X-axis direction is larger than the diameter of the holes 251a and 251b. The lead 21 is fixed to the main surface of the supporting part 23.

Accordingly, in the process for fixing each of the lead wires 174 to the base mount 210a, when the leads 21 of each of the lead wire 174 pass through the hole 251 of the base mount 210a, the upper surface (main surface) of the supporting part 23 contacts the base mount 210a. With this, the position of the base mount 210a in the globe 110 is fixed. Stated differently, the supporting part 23 holds the part in the periphery of the hole 251 in the second surface opposite to the main surface 211 (the first surface) of the base mount 210a.

Stated differently, in the process for fixing each of the lead wires 174 to the base mount 210a, the hole fixed part 20 (the supporting part 23) in each of the lead wires 174 is capable of positioning the base mount 210a in the globe 110.

Each of the lead wires 174 has the elastic part 17 described above. The elastic part 17 is provided at a position contacting the supporting part 23. Stated differently, the elastic part 17 is provided in the vicinity of the base mount 210a.

Note that, the structure is not limited to this structure, and the elastic part 17 may be provided at a position not contacting the supporting part 23.

As illustrated in (a) and (c) in FIG. 9, the part of the leads 21 in the hole fixed part 20 projecting from the each of the holes 251 in the base mount 210a is crimped (bent) so as to contact the main surface 211 of the base mount 210a.

Stated differently, a part of each of the leads 21 is crimped such that the lead 21 contacts the main surface 211 of the base mount 210a from the second surface opposite to the main surface (the first surface) of the base mount 210a to the main surface 211 (the first surface), through the hole 251.

Furthermore, the lead wires 174a and 174b are electrically connected to the group of light-emitting devices 300a in the same manner as the embodiment 1 such that the DC power from the lighting circuit 180 can be supplied to the group of light-emitting devices 300a.

With the configuration described above, the position of the base mount 210a in the globe 110 is fixed by the lead wires 174a and 174b, and the DC power can be supplied to the group of light-emitting devices 300a using the lead wires 174a and 174b.

Each of the lead wires 174 has the elastic part 17. Accordingly, the same effect achieved by the embodiment 1 is achieved. More specifically, the light bulb shaped lamp A11 according to the variation 1 of the embodiment 1 can suppress the possibility of malfunction when the light bulb shaped lamp A11 is shaken.

### Variation 2 of Embodiment 1

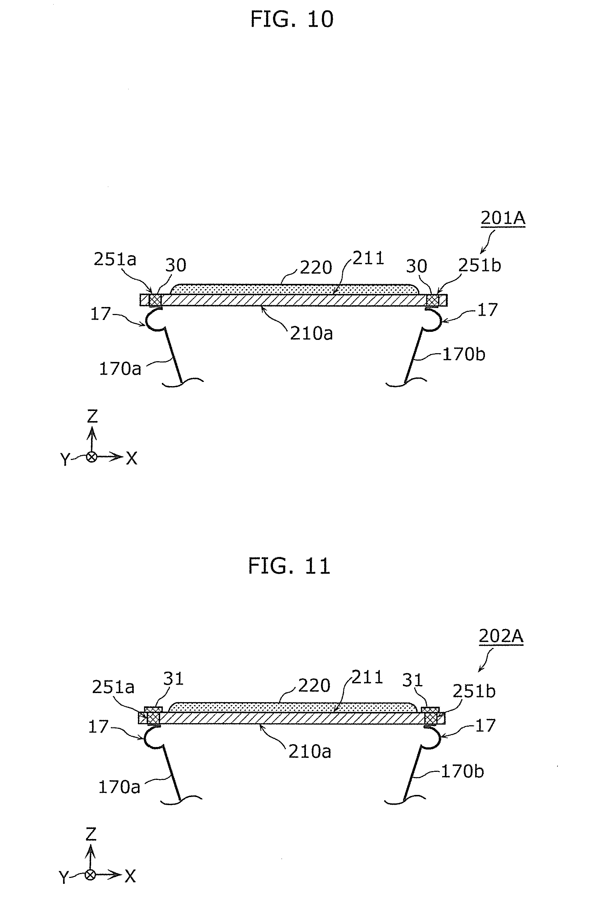

FIG. 10 is a cross-sectional view for describing the fixing structure according to the variation 2 of the embodiment 1. The fixing structure for the LED module 201A shall be described in the variation 2 of the embodiment 1.

In the following description, a light bulb shaped lamp having the fixing structure according to the variation 2 of the embodiment 1 may be referred to as a light bulb shaped lamp A12. The light bulb shaped lamp A12 is different from the light bulb shaped lamp 100 in that an LED module 201 is included instead of the LED module 200. The rest of the structure of the light bulb shaped lamp A12 is identical to the light bulb shaped lamp 120. Accordingly, the description for the structure shall be omitted.

As illustrated in FIG. 10, the LED module 201A is different from the LED module 200A in FIG. 9 in that conductive components 30 are filled in the holes 251a and 251b of the base mount 210a. The rest of the configuration of the LED module 201A is identical to the LED module 200A. Accordingly, the detailed description is not repeated.

The conductive component 30 is, for example, metal such as stainless, cermet, or others. When the conductive component 30 is metal, each of the holes 251a and 251b is filled with (press-fit) the conductive component 30. When the conductive component 30 is cermet, each of the holes 251a and 251b is filled with the conductive component 30 by the thermal shrink-fit of the conductive component 30.

The conductive component 30 filled in the hole 251a is electrically connected to the wire bonding part 331 of the left-end semiconductor light-emitting device in the group of light-emitting devices 300a by a wire 301 which is not illustrated. The conductive component 30 filled in the hole 251b is electrically connected to the wire bonding part 332 of the right-end semiconductor light-emitting device in the group of light-emitting devices 300a by a wire 301 which is not illustrated.

As illustrated in FIG. 10, the end portions of the lead wires 170a and 170b are bent, and the end portions are welded to the conductive component 30 by laser, for example. Stated differently, the lead wire 170 is electrically connected to the conductive component 30 from the side of the second surface opposite to the main surface 211 (the first surface) of the base mount 210a. Accordingly, the LED module 201A (the base mount 210a) is held (supported) by the lead wires 170a and 170b. Stated differently, the elastic part 17 of the lead wire 170 is provided in the vicinity of the base mount 210a.

With this, the lead wire 170a is electrically connected to the left-end semiconductor light-emitting device in the group of light-emitting devices 300a through the conductive component 30. Furthermore, the lead wire 170b is electrically connected to the right-end semiconductor light-emitting device in the group of light-emitting devices 300a through the conductive component 30.

The lead wires 170a and 170b are electrically connected to the group of light-emitting devices 300a such that the DC power from the lighting circuit 180 can be supplied to the group of light-emitting group 300a.

With the configuration described above, the position of the base mount 210a in the globe 110 is fixed by the lead wires 170a and 170b, and the DC power can be supplied to the group of light-emitting devices 300a using the lead wires 170a and 170b.

Each of the lead wires 170 has the elastic part 17. Accordingly, the same effect achieved by the embodiment 1 is achieved. More specifically, the light bulb shaped lamp A12 according to the variation 2 of the embodiment 1 can suppress the possibility of malfunction when the light bulb shaped lamp A12 is shaken.

Note that, the elastic part 17 may be provided in the lead wire 170 at a position away from a predetermined distance from the base mount 210a. The predetermined distance corresponds to the length of the elastic part 17 in the Z-axis direction, for example.

### Variation 3 of Embodiment 1

FIG. 11 is a cross-sectional view for describing the fixing structure according to the variation 3 of the embodiment 1. The fixing structure for the LED module 202A shall be described in the variation 3 of the embodiment 1.

In the following description, a light bulb shaped lamp having the fixing structure according to the variation 3 of the embodiment 1 may be referred to as a light bulb shaped lamp A13. The light bulb shaped lamp A13 is different from the light bulb shaped lamp 100 in that an LED module 202A is included instead of the LED module 200. The rest of the structure of the light bulb shaped lamp A13 is identical to the light bulb shaped lamp 100. Accordingly, the description for the structure shall be omitted.

As illustrated in FIG. 11, the LED module 202A is different from the LED module 201A in FIG. 10 in that a conductive components 31 are embedded instead of the conductive component 30 in the holes 251a and 251b in the base mount 210a. Stated differently, the holes 251a and 251b are filled with the conductive components 31.

The rest of the configuration of the LED module 202A is identical to the LED module 201A. Accordingly, the detailed description is not repeated.

The conductive component 31 is a rivet. Note that, the conductive component 31 is not limited to a rivet, and may be any conductive component that can be embedded in the hole. The conductive component 31 may be a screw, for example.

The conductive component 31 embedded in the hole 251a is electrically connected to the wire bonding part 331 of the left-end semiconductor light-emitting device in the group of light-emitting devices 300a by a wire 301 which is not illustrated. The conductive component 31 filled in the hole 251b is electrically connected to the wire bonding part 332 of the right-end semiconductor light-emitting device in the group of light-emitting devices 300a by a wire 301 which is not illustrated.

As illustrated in FIG. 11, the end portions of the lead wires 170a and 170b are bent, and the end portions are welded to the conductive component 31 by laser, for example. Stated differently, the lead wire 170 is electrically connected to the conductive component 31 from the side of the second surface opposite to the main surface 211 (the first surface) of the base mount 210a. Accordingly, the LED module 202A (the base mount 210a) is held (supported) by the lead wires 170a and 170b. Stated differently, the elastic part 17 of the lead wire 170 is provided in the vicinity of the base mount 210a.

With this, the lead wire 170a is electrically connected to the left-end semiconductor light-emitting device in the group of light-emitting devices 300a through the conductive component 31. Furthermore, the lead wire 170b is electrically connected to the right-end semiconductor light-emitting device in the group of light-emitting devices 300a through the conductive component 31.

The lead wires 170a and 170b are electrically connected to the group of light-emitting devices 300a such that the DC power from the lighting circuit 180 can be supplied to the group of light-emitting group 300a.

With the configuration described above, the position of the base mount 210a in the globe 110 is fixed by the lead wires 170a and 170b, and the DC power can be supplied to the group of light-emitting devices 300a using the lead wires 170a and 170b.

Each of the lead wires 170 has the elastic part 17. Accordingly, the same effect achieved by the embodiment 1 is achieved. More specifically, the light bulb shaped lamp A13 according to the variation 3 of the embodiment 1 can suppress the possibility of malfunction when the light bulb shaped lamp A13 is shaken.

Note that, the elastic part 17 may be provided in the lead wire 170 at a position away from a predetermined distance from the base mount 210a. The predetermined distance corresponds to the length of the elastic part 17 in the Z-axis direction, for example.

### Variation 4 of Embodiment 1

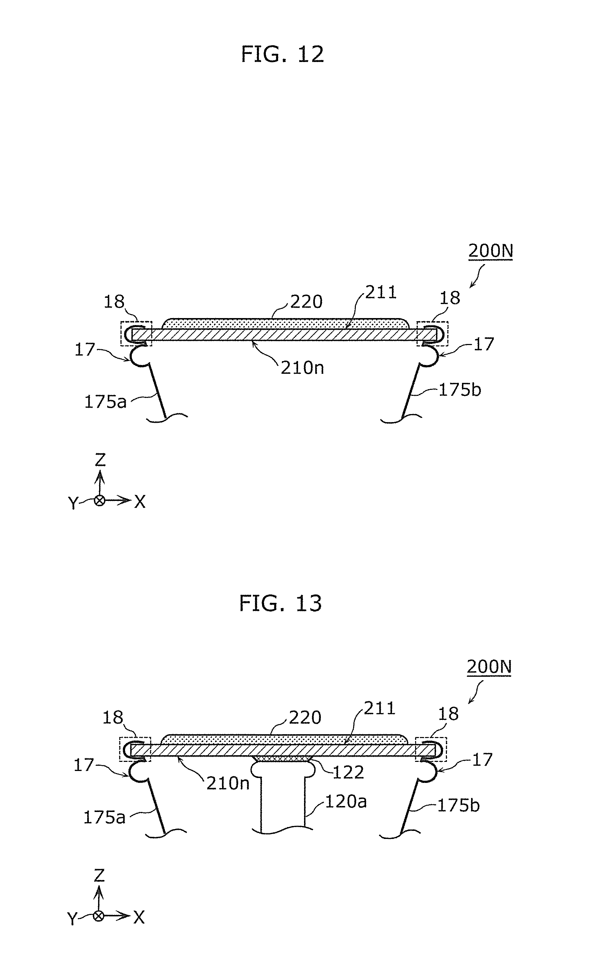

FIG. 12 is a cross-sectional view for describing the fixing structure according to the variation 4 of the embodiment 1. The fixing structure for the LED module 200N shall be described in the variation 4 of the embodiment 1.

In the following description, a light bulb shaped lamp according to the variation 4 of the embodiment 1 may be referred to as a light bulb shaped lamp A14. The light bulb shaped lamp A14 is different from the light bulb shaped lamp 100 in that an LED module 200N is included instead of the LED module 200, and the lead wires 175a and 175b are included instead of the lead wires 170a and 170b. The rest of the structure of the light bulb shaped lamp A14 is identical to the light bulb shaped lamp 100. Accordingly, the description for the structure shall be omitted.

As illustrated in FIG. 12, the LED module 200N is different from the LED module 200 in FIG. 4 and FIG. 8 in that a base mount 210n is included instead of the base mount 210. The rest of the configuration of the LED module 200N is identical to the LED module 200. Accordingly, the detailed description for the structure is not repeated.

The base mount 210n is different from the base mount 210 in that the base mount 210n does not have the holes 250a and 250b. The rest of the configuration of the base mount 210n is identical to the base mount 210, and the detailed description is not repeated. In summary, the group of light-emitting devices 300a is formed on the base mount 210n, and the group of light-emitting devices 300a are sealed by the sealing part 220. Note that, the shape and the structure of the base mount 210n is identical to the shape and the structure of the base mount 210.

The shape of the base mount 210n is quadrangular prism or board.

The LED module 200N (the base mount 210n) is fixed (supported) by the lead wires 175a and 175b. In the following description, each of the lead wires 175a and 175b may be simply referred to as the lead wire 175. The fixing part 120 of the light bulb shaped lamp A14 fixes the lead wire 175 such that a part of the lead wire 175 is exposed, in the same manner as the lead wire 170.

The lead wire 175 is different from the lead wire 170 in FIG. 4 in that a bent part 18 is formed at an end portion of the lead wire 175. Since the rest of the structure and function of the lead wire 175 are identical to those of the lead wire 170, the detailed description shall not be repeated. The lead wires 175a and 175b correspond to the lead wires 170a and 170b, respectively.

More specifically, the end portion of each of the lead wires 175a and 175b has a bent part 18 having a shape which allows the bent part 18 to clip the end portion of the board. The bent part 18 is an end portion of each of the lead wires 175a and 175b formed in U-shape.

Note that, the shape of the bent portion 18 is not limited to U-shape, but may be square U-shape.

As illustrated in FIG. 12, the lead wire 175a is provided such that the bent part 18 in the lead wire 175a clips one of the two end portions of the base mount 210n orthogonal to the X-axis direction. The lead wire 175b is provided such that the bent portion 18 in the lead wire 175b clips the other of the two end portions of the base mount 210n orthogonal to the X-axis direction.

More specifically, at the end portion of each of the lead wires 175, the bent part 18 is formed. Each of the bent parts 18 in the lead wires 175 clips one of the end portions of the base mount 210n. Accordingly, at least two end portions of the base mount 210n clipped by the bent parts 18 are parallel to the same direction (Y-axis direction).

Stated differently, the base mount 210n is fixed by the clipping by the bent parts 18 in the lead wires 175a and 175b.

Stated differently, the elastic part 17 of the lead wire 175 is provided in the vicinity of the base mount 210a.

The lead wires 175a and 175b are electrically connected to the group of light-emitting devices 300a such that the DC power from the lighting circuit 180 can be supplied to the group of light-emitting group 300a.

With the configuration described above, the position of the base mount 210n in the globe 110 is fixed by the lead wires 175a and 175b, and the DC power can be supplied to the group of light-emitting devices 300a using the lead wires 175a and 175b.

Each of the lead wires 175 has the elastic part 17. Accordingly, the same effect achieved by the embodiment 1 is achieved. More specifically, the light bulb shaped lamp A14 according to the embodiment 4 can suppress the possibility of malfunction when the light bulb shaped lamp A14 is shaken.

Note that, the elastic part 17 may be provided in the lead wire 175 at a position away from a predetermined distance from the base mount 210n. The predetermined distance corresponds to the length of the elastic part 17 in the Z-axis direction, for example.

Note that, in the embodiment, each of the left end portion and the right end portion of the base mount 210n is fixed by one lead wire having the bent part 18. However, it is not limited to this example. For example, each of the left end portion and the right end portion of the base mount 210n may be fixed by a plurality of lead wires each having the bent part 18.

### Variation 5 of Embodiment 1

FIG. 13 is a cross-sectional view for describing the fixing structure according to the variation 5 of the embodiment 1. The fixing structure for the LED module 200N shall be described in the variation 5 of the embodiment 1.

The variation 5 of the embodiment 1 is different from the structure illustrated in FIG. 12 (the Embodiment 4) in that the base mount 210n is fixed by a rod part 120a of the fixing part 120 as the stem as well. The structure other than the structure for fixing the base mount 210n is identical to the embodiment 4. Accordingly, the detailed description for the structure shall not be repeated.

As described above, the fixing part 120 as the stem is provided on a side (the second surface) opposite to the main surface 211 of the base mount 210n.

The shape of the fixing part 120 in the variation 5 of the embodiment 1 is described as the rod part 120a of the fixing part 120 extending to the vicinity of the surface opposite to the main surface 211 of the base mount 210n.

The surface (the second surface) opposite to the main surface 211 of the base mount 210n is fixed to the tip of the rod part 120a of the fixing part 120 by adhesive 122. The adhesive 122 is silicone, for example. The surface (the second surface) opposite to the main surface 211 of the base mount 210n is fixed to the tip of the rod part 120a of the fixing part 120.

Note that, the adhesive 122 is not limited to silicone, and may be made of other material.

As described above, the structure according to the variation 1 of the embodiment 4 can fix the base mount 210n (the LED module 200N) even more firmly than the variation 4 of the embodiment 1.

Each of the lead wires 175 has the elastic part 17. Accordingly, the same effect achieved by the embodiment 1 is achieved. More specifically, the light bulb shaped lamp according to the variation 1 of the embodiment 4 can suppress the possibility of malfunction when the light bulb shaped lamp is shaken.

Furthermore, in the variation 5 of the embodiment 1, the left end portion and the right end portion of the base mount 210n may be fixed by more than one lead wires each having a bent part, in the same manner as the variation 4 of the embodiment 1.

In addition, the shape of the fixing part 120 may allow the tip of the rod part 120a of the fixing part 120 to contact the surface opposite to the main surface 211 of the base mount 210n. In this case, the adhesive 122 may not be necessary.

Note that, the base mount (the base mounts 210 and 210a) fixed by the structures illustrated in FIG. 8, FIG. 9, FIG. 10, and FIG. 11 may further be fixed by using the rod part 120a of the fixing part 120, in the same manner as the structure illustrated in FIG. 13. With this structure, the base mounts can be fixed very firmly.

In the following description, a light bulb shaped lamp having the fixing structure according to the variation 5 of the embodiment 1 may be referred to as a light bulb shaped lamp A15.

### Variation 6 of Embodiment 1

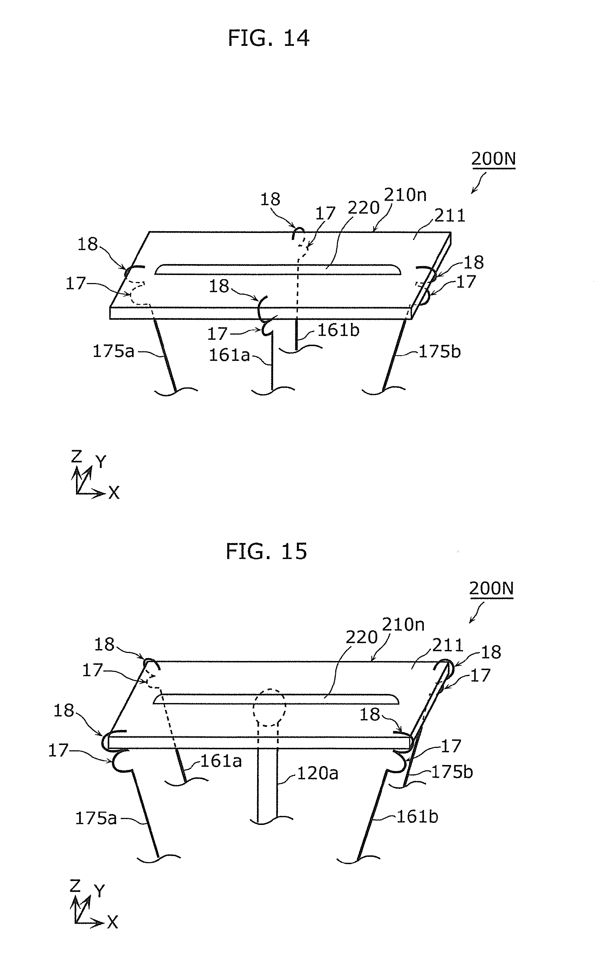

FIG. 14 is a cross-sectional view for describing the fixing structure according to the variation 6 of the embodiment 1. The fixing structure for the LED module 200N shall be described in the variation 6 of the embodiment 1.

In the following description, a light bulb shaped lamp according to the variation 6 of the embodiment 1 may be referred to as a light bulb shaped lamp A16. The light bulb shaped lamp A16 is different from the light bulb shaped lamp A15 according to the variation 5 of the embodiment 1 in that the light bulb shaped lamp A16 further includes fixing wires 161a and 161b. The rest of the structure of the light bulb shaped lamp A16 is identical to the light bulb shaped lamp A15. Accordingly, the description for the structure shall be omitted.

The variation 6 of the embodiment 1 is different from the structure illustrated in FIG. 13 (the variation 5 of the embodiment 1) in that the base mount 210n is further fixed by the fixing wires 161a and 161b. The structure other than the structure for fixing the base mount 210n is identical to the variation 5 of the embodiment 1. Accordingly, the detailed description for the structure shall not be repeated.

Note that, in FIG. 14, the rod part 120a of the fixing part 120 adhered to the back surface of the base mount 210n is not illustrated for simplifying the drawing.

The base mount 210n in the variation 5 of the embodiment 1 is board shaped. Three sealing parts 220 are formed on the board-shaped base mount 210n, as illustrated in (b) in FIG. 5. In FIG. 14, the three sealing parts 220 are illustrated as one sealing part 220 for simplifying the drawing.

Note that, in the same manner, the diagrams to be illustrated later illustrate the three sealing parts 220 formed on the board-shaped base mount as one sealing part 220.

An end portion of each of the fixing wires 161a and 161b is fixed to the fixing part 120, exposing a part of the fixing wire 161a or 161b, in the same manner as the lead wires 170a and 170b in FIG. 1. Note that, the fixing wires 161a and 161b are metal wires not used for supplying power. The metal wires contain copper, for example.

In the following description, each of the fixing wires 161a and 161b may be simply referred to as the fixing wire 161.

The shape of the fixing wire 161 is identical to the shape of the lead wire 175. Stated differently, the bent part 18 is formed at the end portion of each of the fixing wires 161. Furthermore, each of the fixing wires 161 has the elastic part 17. Stated differently, the elastic part 17 of the fixing wire 161 is provided in the vicinity of the base mount 210n.

As illustrated in FIG. 14, the fixing wire 161a includes a bent part 18 of the fixing wire 161a clipping one of the two end portions of the base mount 210n parallel to the X-axis direction. The fixing wire 161b includes the bent part 18 of the fixing wire 161b clipping the other of the two end portions of the base mount 210n parallel to the X-axis direction.

As described above, the lead wire 175a is provided such that the bent part 18 in the lead wire 175a clips one of the two end portions of the base mount 210n orthogonal to the X-axis direction. The lead wire 175b is provided such that the bent portion 18 in the lead wire 175b clips the other of the two end portions of the base mount 210n orthogonal to the X-axis direction.

To put it differently, the base mount 210n is fixed by the bent parts 18 of the lead wires 175a and 175b, and the fixing wires 161a and 161b clipping the four end portions of the base mount 210n. Stated differently, the LED module 200N (the base mount 210n) is fixed (supported) by the lead wires 175a and 175b, and the fixing wires 161a and 161b.

According to the configuration described in the variation 6 of the embodiment 1, the base mount 210n is fixed even more firmly than the fixing structure in the variation 5 of the embodiment 1.

Each of the lead wires 175 and the fixing wires 161 has the elastic part 17. Accordingly, the same effect achieved by the embodiment 1 is achieved. More specifically, the light bulb shaped lamp A16 according to the variation 6 of the embodiment 1 can suppress the possibility of malfunction when the light bulb shaped lamp A16 is shaken.

Note that, the rod part 120a of the fixing part 120 may not be fixed to the back surface (the second surface) of the base mount 210n, and the base mount 210n may be fixed by the lead wires 175a and 175b, and the fixing wires 161a and 161b.

Note that, the fixing wires 161a and 161b may be wires for supplying power to the group of light-emitting devices 300a in the same manner as the lead wires 170a and 170b. In this case, the fixing wires 161a and 161b are electrically connected to the lighting circuit 180 such that the DC power from the lighting circuit 180 can be transmitted therethrough. Furthermore, in this case, the fixing wires 161a and 161b, and the lead wires 170b and 170b are electrically connected to the group of the light-emitting devices 300a such that the power can be supplied to the group of light-emitting devices 300a.

Note that, the elastic part 17 may be provided in the fixing wire 161 at a position away from a predetermined distance from the base mount 210n.

### Variation 7 of Embodiment 1

FIG. 15 is a cross-sectional view for describing the fixing structure according to the variation 7 of the embodiment 1. The fixing structure for the LED module 200N shall be described in the variation 7 of the embodiment 1.

In the following description, a light bulb shaped lamp having the fixing structure according to the variation 7 of the embodiment 1 may be referred to as a light bulb shaped lamp A17.

The variation 7 of the embodiment 1 is different from the structure illustrated in FIG. 14 (the variation 6 of the embodiment 1) in the positions to which the lead wires 175a and 175b and the fixing wires 161a and 161b are fixed. The structure other than the structure for fixing the base mount 210n is identical to the variation 6 of the embodiment 1. Accordingly, the detailed description for the structure shall not be repeated.

The base mount 210n has a shape of quadrilateral board. Accordingly, the base mount 210n has four corners (end portions).

As illustrated in FIG. 15, the lead wire 175a has a bent part 18 of the lead wire 175a clipping one of the four corners of the base mount 210n. The lead wire 175b has a bent part 18 of the lead wire 175b clipping one of the four corners of the base mount 210n.

Stated differently, at least two end portions of the base mount 210n clipped by the bent parts 18 of the lead wires 175 are corners of the base mount 210n.

The fixing wire 161a includes a bent part 18 of the fixing wire 161a clipping one of the four corners of the base mount 210n. The fixing wire 161b includes a bent part 18 of the fixing wire 161b clipping one of the four corners of the base mount 210n.

The lead wires 175a and 175b are provided holding two diagonal corners among the four corners. The fixing wires 161a and 161b are provided holding two diagonal corners among the four corners.

Note that, the positional relationship between the corners clipped by the bent parts 18 of the lead wires 175 and the fixing wires 161 is not limited to the relationship described above. For example, among the four angles, the lead wires 175a and 175b may be provided fixing two corners on the same end portion among the four corners.

As described above, the lead wires 175a and 175b are electrically connected to the group of light-emitting devices 300a such that the power can be supplied to the group of light-emitting devices 300a through the lead wires 175a and 175b.

Accordingly, the same effect achieved by the variation 6 of the embodiment 1 is achieved by the structure according to the variation 7 of the embodiment 1. Accordingly, according to the configuration in the variation 7 of the embodiment 1, the base mount 210n is fixed even more firmly than the fixing structure in the variation 5 of the embodiment 1.

Each of the lead wires 175 and the fixing wires 161 has the elastic part 17. Accordingly, the same effect achieved by the embodiment 1 is achieved. More specifically, the light bulb shaped lamp A17 according to the variation 7 of the embodiment 1 can suppress the possibility of malfunction when the light bulb shaped lamp A17 is shaken.

Note that, the fixing wires 161a and 161b may be wires for supplying power to the group of light-emitting devices 300a in the same manner as the lead wires 170a and 170b, as illustrated in the variation 6 of the embodiment 1.

Note that, the positions for the lead wires 175a and 175b, and the fixing wires 161a and 161b to fix the base mount 210n are not limited to the positions illustrated in FIG. 15, and may be other positions.

Note that, the rod part 120a of the fixing part 120 may not be fixed to the back surface (the second surface) of the base mount 210n, and the base mount 210n may be fixed by the lead wires 175a and 175b, and the fixing wires 161a and 161b.

### Variation 8 of Embodiment 1

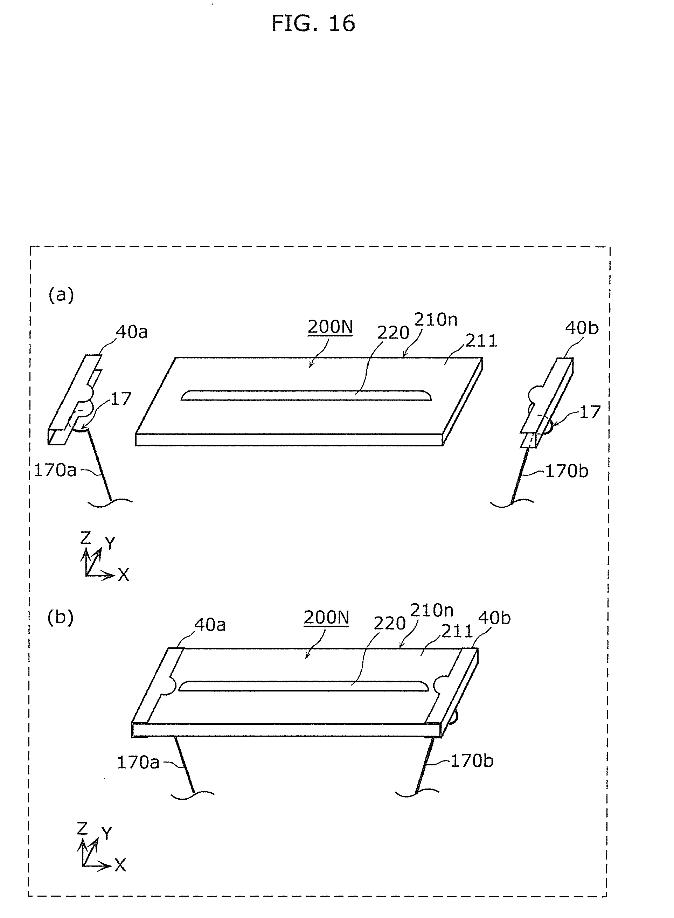

FIG. 16 is a cross-sectional view for describing the fixing structure according to the variation 8 of the embodiment 1. The fixing structure for the LED module 200N shall be described in the variation 8 of the embodiment 1.

In the following description, a light bulb shaped lamp having the fixing structure according to the variation 8 of the embodiment 1 may be referred to as a light bulb shaped lamp A18. The light bulb shaped lamp A18 is different from the light bulb shaped lamp A14 according to the variation 4 of the embodiment 1 in that the lead wires 170a and 170b are included instead of the lead wires 175a and 175b, and the end portion fixing part 40a and 40b are further included. The rest of the structure of the light bulb shaped lamp A18 is identical to the light bulb shaped lamp A14. Accordingly, the description for the structure shall be omitted.

(a) in FIG. 16 illustrates the LED module 200N before being fixed and the end portions fixing parts 40a and 40b used for fixing the LED module 200N. As illustrated in (a) in FIG. 16, the base mount 210n is board-shaped. Note that, the shape of the base mount 210n may be a quadrangular prism.

(b) in FIG. 16 illustrates the LED module 200N fixed.

Each of the end portion fixing parts 40a and 40b may be simply referred to as an end portion fixing part 40 in the following description.

As illustrated in (a) and (b) in FIG. 16, the end portion fixing parts 40a and 40b are square U-shaped and are capable of clipping the end portions of the base mount 210n. The end portion fixing parts 40a and 40b are made of a conductive material. The conductive material is metal, for example. The metal is, for example, stainless, aluminum, or others.

Note that, that the shape of the end portion fixing part 40 is not limited to the square U-shape, and may be in any shape as long as the end portion fixing part 40 can clip the end portion of the base mount having a quadrangular prism shape or board shape.

The bottom part of the end portion fixing part 40a is connected to the tip of the lead wire 170a by welding using laser, for example. More specifically, the end portion fixing part 40a is electrically connected to the lead wire 170a. The bottom part of the end portion fixing part 40b is connected to the tip of the lead wire 170b by welding using laser, for example.

Accordingly, the end portion fixing part 40b is electrically connected to the lead wire 170b. Stated differently, the tip of each of the lead wires 170a and 170b is connected to the end portion fixing part 40. Accordingly, the LED module 200N (the base mount 210n) is fixed (supported) by the lead wires 170a and 170b. Stated differently, the elastic part 17 of the lead wire 170 is provided in the vicinity of the base mount 210n.

As illustrated in (b) in FIG. 16, the end portion fixing part 40a is provided so as to clip one of the two end portions of the base mount 210n parallel to the Y-axis direction. The end portion fixing part 40b is provided so as to fix the other of the two end portions of the base mount 210n parallel to the Y-axis direction.

Stated differently, the end portions fixing parts 40 clipping the end portions of the base mount 210n are provided at the end portions of the base mount 210n.

The lead wires 170a and 170b are electrically connected to the group of light-emitting devices 300a such that the DC power from the lighting circuit 180 can be supplied to the group of light-emitting group 300a through the end portion fixing parts 40a and 40b.

With the configuration described above, the position of the base mount 210n in the globe 110 is fixed by the lead wires 170a and 170b and the end portion fixing parts 40a and 40b, and the DC power can be supplied to the group of light-emitting devices 300a using the lead wires 170a and 170b and the end portion fixing parts 40a and 40b.

Each of the lead wires 170 has the elastic part 17. Accordingly, the same effect achieved by the embodiment 1 is achieved. More specifically, the light bulb shaped lamp A18 according to the variation 8 of the embodiment 1 can suppress the possibility of malfunction when the light bulb shaped lamp A18 is shaken.

Note that, the base mount 110n fixed by the fixing structure according to the variation 8 of the embodiment 1 may be fixed using the rod part 120a of the fixing part 120 as well, in the same manner as the structure illustrated in FIG. 13. With this structure, the base mount 210n can be fixed very firmly.

Note that, the elastic part 17 may be provided in the lead wire 170 at a position away from a predetermined distance from the base mount 210n.

### Variation 9 of Embodiment 1

The fixing structure for two LED modules 200N shall be described in the variation 9 of the embodiment 1. In the variation 9 of the embodiment 1, the two LED modules 200N are also referred to as an LED module 200Na and 200Nb in order to distinguish the two LED modules 200N. In addition, the base mount 210n corresponding to each of the LED module 200Na and 200Nb is also referred to as a base mount 210na or 210nb.

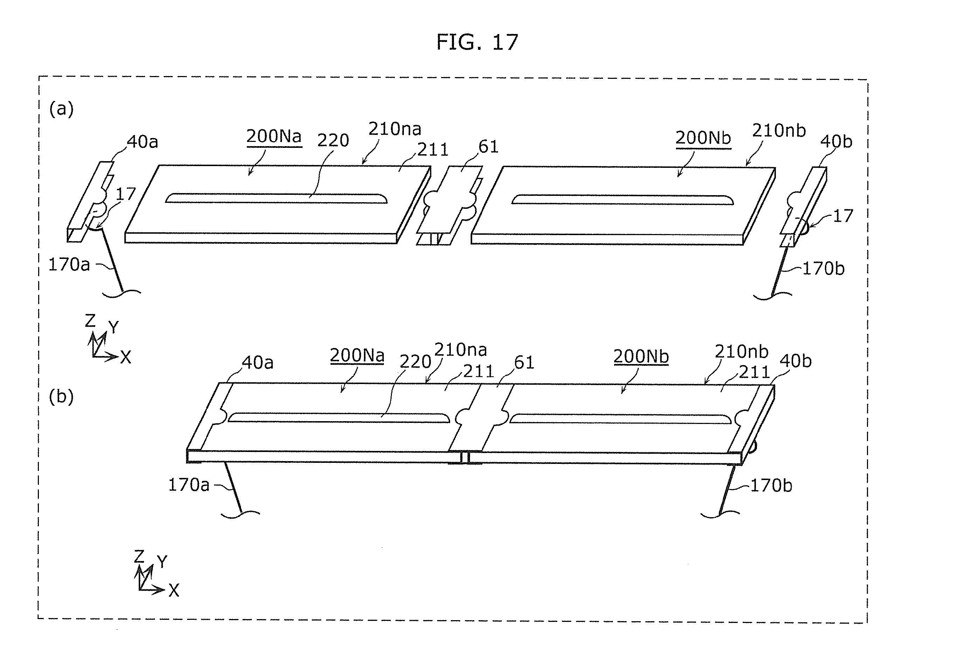

FIG. 17 is a diagram for describing the fixing structure according to the variation 9 of the embodiment 1.

(a) in FIG. 17 illustrates the LED modules 200Na and 200Nb before being fixed.

(b) in FIG. 17 illustrates the LED modules 200Na and 200Nb fixed.

In the following description, a light bulb shaped lamp having the fixing structure according to the variation 9 of the embodiment 1 may be referred to as a light bulb shaped lamp A19. The light bulb shaped lamp A19 is different from the light bulb shaped lamp A18 according to the variation 8 of the embodiment 1 illustrated in FIG. 16 in that the LED modules 200Na and 200Nb integrated by a connecting part 61 are included instead of the LED module 200N. The rest of the structure of the light bulb shaped lamp A19 is identical to the light bulb shaped lamp A18. Accordingly, the description for the structure shall be omitted.

In this case, the light bulb shaped lamp A19 includes the base mount 210na and 210nb integrated by the connecting part 61, as illustrated in (b) in FIG. 17. Stated differently, the light bulb shaped lamp A19 has more than one base mount.

The configuration of the LED modules 200Na and 200Nb are identical to the configuration of the LED module 200N. Stated differently, a plurality of the semiconductor light-emitting devices 300 are mounted on the main surface of each of the base mounts 210na and 210nb corresponding to the LED modules 200Na and 200Nb, respectively. Accordingly, the group of light-emitting devices 300a is formed on the main surface 211 of each of the base mounts 210na and 210nb.

The base mounts 210na and 210nb have a shape of board. Note that, the shape of the base mounts 210na and 210nb is not limited to the board, and may be quadrangular prism.

As illustrated in (a) in FIG. 17, the connecting part 61 has a shape that allows the connecting part 61 to clip an end portion of the base mount 210na and an end portion of the base mount 210nb. Stated differently, the connecting part 61 has a shape for integrating the base mounts.

The connecting part 61 is made of a conductive material. The conductive material is metal, for example. The metal is, for example, stainless, aluminum, or others.

Since the end portion fixing parts 40a and 40b are described above, the detailed description for them is not repeated. The end portion fixing parts 40a and 40b are connected to the lead wires 170a and 170b, respectively. Stated differently, the elastic part 17 of the lead wire 170 is provided in the vicinity of the base mount 210n.

As illustrated in (b) in FIG. 17, the connecting part 61 is provided to clip the right end portion of the base mount 210na and the left end portion of the base mount 210nb. To put it differently, the base mounts (the base mounts 210na and 210nb) are integrated by the connecting part 61. Accordingly, the LED modules 200Na and 200Nb are integrated by the connecting part 61.

The group of light-emitting devices 300a formed on the base mount 210na and the group of light-emitting devices 300a formed on the base mount 210nb are electrically connected in series.

The end portion fixing part 40a is provided so as to clip the left end portion of the base mount 210na. The end portion fixing part 40b is provided so as to clip the right end portion of the base mount 210nb. Stated differently, the lead wires 170a and 170b connected to the end portion fixing parts 40a and 40b are fixed to the end portions of the two base mounts of the multiple base mounts so as to fix the base mounts integrated by the connecting part 61. The multiple integrated base mounts here are the base mounts 210na and 210nb.

Stated differently, the lead wire is fixed to an end portion of the multiple base mounts so as to fix the base mounts integrated by the connecting part.

Accordingly, the end portion fixing part 40 for fixing the end portion is provided at each of at least two end portions of the base mounts integrated. Each of the two lead wires 170 is connected to the two end portion fixing parts 40.

Accordingly, the multiple base mounts integrated are supported by at least two lead wires.

Each of the end portions of at least two of the multiple base mounts integrated is supported by one of the two lead wires. Each of the end portions of at least one of the multiple base mounts integrated is supported by the lead wire.

The lead wires 170a and 170b are electrically connected to the group of light-emitting devices 300a such that the DC power from the lighting circuit 180 can be supplied to the groups of light-emitting devices 300a corresponding to the base mounts 210na and 210nbthrough the end portion fixing parts 40a and 40b.

With the configuration described above, the position of the integrated base mounts 210n are fixed by the lead wires 170a and 170b and the end portion fixing parts 40a and 40b, and the DC power can be supplied to the two groups of light-emitting devices 300a using the lead wires 170a and 170b and the end portion fixing parts 40a and 40b.

Each of the lead wires 170 has the elastic part 17. Accordingly, the same effect achieved by the embodiment 1 is achieved. More specifically, the light bulb shaped lamp A19 according to the variation 9 of the embodiment 6 can suppress the possibility of malfunction when the light bulb shaped lamp A19 is shaken.

Note that, the elastic part 17 may be provided in the lead wire 170 at a position away from a predetermined distance from the base mount 210n.

### Variation 10 of Embodiment 1

The fixing structure for three LED modules 200N shall be described in the variation 10 of the embodiment 1.

In the following description, an end portion of the base mount 210n orthogonal to the longer direction of a sealing part 220 formed on the base mount 210n of the LED module 200N is also referred to as an end portion to be connected. Accordingly, the base mount 210n has two ends to be connected.

In the variation 10 of the embodiment 1, the three LED modules 200N are also referred to as an LED module 200Na, 200Nb, and 200Nc in order to distinguish the three LED modules 200N. The base mounts 210n corresponding to the LED modules 200Na, 200Nb, and 200Nc are also referred to as the base mount 210na, 210nb, and 210nc, respectively.

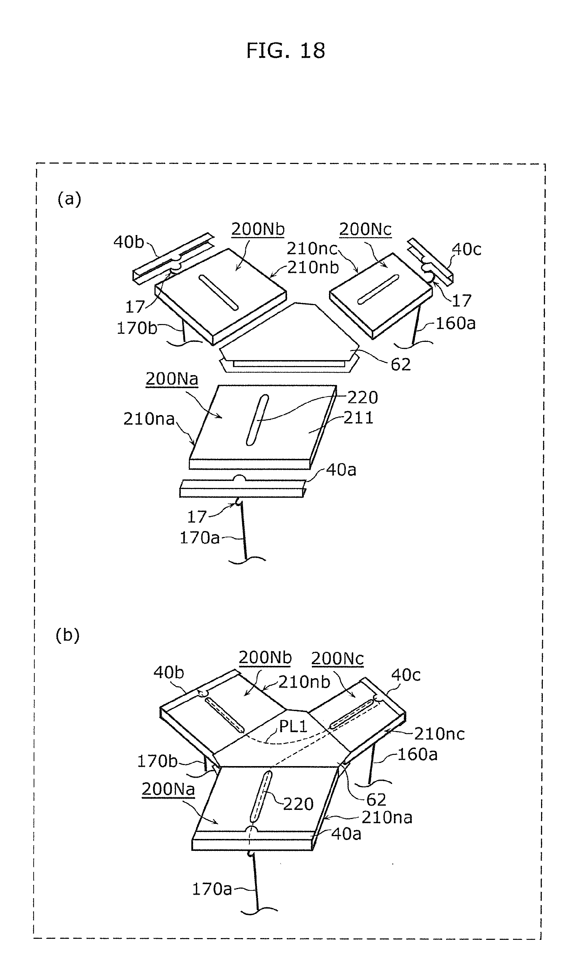

FIG. 18 is a diagram for describing the fixing structure according to the variation 10 of the embodiment 1.

(a) in FIG. 18 illustrates the LED modules 200Na, 200Nb, and 200Nc before being fixed.

(b) in FIG. 18 illustrates the LED modules 200Na, 200Nb, and 200Nc fixed.

In the following description, a light bulb shaped lamp according to the variation 10 of the embodiment 1 may be referred to as a light bulb shaped lamp A110. The light bulb shaped lamp A110 is different from the light bulb shaped lamp A18 according to the variation 8 of the embodiment 1 illustrated in FIG. 16 in that the LED modules 200Na, 200Nb, and 200Nc integrated by a connecting part 62 are included instead of the LED module 200N, and a fixing wire 160a and an end portion fixing part 40c are further included. The rest of the structure of the light bulb shaped lamp A110 is identical to the light bulb shaped lamp A18. Accordingly, the detailed description for the structure shall be omitted.

In this case, the light bulb shaped lamp A110 includes the base mount 210na, 210nb, and 210nc integrated by the connecting part 62, as illustrated in (b) in FIG. 18. Stated differently, the light bulb shaped lamp A110 has more than one base mount.

The configuration of the LED modules 200Na, 200Nb, and 200Nc are identical to the configuration of the LED module 200N. Stated differently, a plurality of the semiconductor light-emitting devices 300 are mounted on the main surface of each of the base mounts 210na, 210nb, and 210nc corresponding to the LED modules 200Na, 200Nb, and 200Nc, respectively. Accordingly, the group of light-emitting devices 300a is formed on the main surface 211 of each of the base mounts 210na, 210nb, and 210nc.

As illustrated in (a) in FIG. 18, the shape of the connecting part 62 allows the connecting part 62 to clip one of two end portions to be connected in each of the base mounts 210na, 210nb, and 210nc. Stated differently, the connecting part 62 has a shape for integrating the base mounts 210na, 210nb, and 210nc. The connecting part 62 is made of the conductive material of which the connecting part 61 is made of.

Since the end portion fixing parts 40a and 40b are described above, the detailed description for them is not repeated.

An end portion of the fixing wire 160a is fixed by the fixing part 120, in the same manner as the lead wires 170a and 170b illustrated in FIG. 1. Note that, the fixing wire 160a is a metal wire not used for supplying power. The material composing the fixing wire 160a is identical to the fixing wire 161 described above. The shape of the fixing wire 160a is identical to the shape of the lead wire 170. Furthermore, the fixing wire 160a has the elastic part 17.

The shape and the structure of the end portion fixing part 40c are identical to those of the end portion fixing part 40a. The bottom part of the end portion fixing part 40c is connected to the tip of the lead wire 160a by welding using laser, for example. More specifically, the end portion fixing part 40c is electrically connected to the fixing wire 160a.

Since the end portion fixing parts 40a and 40b are described above, the detailed description for them is not repeated. The end portion fixing parts 40a and 40b are electrically connected to the lead wires 170a and 170b, respectively. Stated differently, the elastic parts 17 of the lead wire 170 and the fixing wire 160a are provided in the vicinity of the base mount 210n.

As illustrated in (b) in FIG. 18, the connecting part 62 are provided so as to clip one of two end portions to be connected in each of the base mounts 210na, 210nb, and 210nc. To put it differently, the base mounts 210na, 210nb, and 210nc are integrated by the connecting part 62. Accordingly, the LED modules 200Na, 200Nb, and 200Nc are integrated by the connecting part 62.

The group of light-emitting devices 300a formed on the base mount 210na, the group of light-emitting devices 300a formed on the base mount 210nb, and the group of light-emitting devices 300a formed on the base mount 210nc are electrically connected in series.

The end portion fixing part 40a is provided so as to clip the other end portion to be connected in the base mount 210na. The end portion fixing part 40b is provided so as to clip the other end portion to be connected in the base mount 210nb. The end portion fixing part 40c is provided so as to clip the other end portion to be connected in the base mount 210nc.

As described above, the end portion fixing parts 40a, 40b, and 40c are connected to the lead wires 170a, 170b, and the fixing wire 160a, respectively.

The lead wires 170a, 170b, and the fixing wire 160a are fixed to the end portions of the multiple base mounts such that the base mounts 210na, 210nb, and 210nc integrated by the connecting part 62 are fixed, respectively. Stated differently, the lead wires 170a, 170b, and the fixing wire 160a are connected to the end portions of the base mount 210na, 210nb, and 210nc, respectively.

Stated differently, the lead wire is fixed to an end portion of the multiple base mounts so as to fix the base mounts integrated by the connecting part.

Accordingly, the end portion fixing part for fixing the end portion is provided in each of end portions of the three base mounts integrated. At least two lead wires are connected to two of the three end portion fixing parts.

Accordingly, the multiple base mounts integrated are supported by at least two lead wires.

The lead wires 170a and 170b are electrically connected to the group of light-emitting devices 300a such that the DC power from the lighting circuit 180 can be supplied to the groups of light-emitting devices 300a corresponding to the base mount 210na, 210nb, and 210nc through the end portion fixing parts 40a and 40b. With this, the three groups of light-emitting devices 300a emits light by the flow of current through the current path PL1 in (b) in FIG. 18.

With the configuration described above, the positions of the integrated base mounts 210n are fixed by the lead wires 170a and 170b, the fixing wire 160a, and the end portion fixing parts 40a, 40b, and 40c, and the DC power can be supplied to the three groups of light-emitting devices 300a using the lead wires 175a and 175b, the fixing wire 160a, and the end portion fixing parts 40a and 40b.

Each of the lead wires 170 and the fixing wire 160a has the elastic part 17. Accordingly, the same effect achieved by the embodiment 1 is achieved. More specifically, the light bulb shaped lamp A110 according to the variation 10 of the embodiment 1 can suppress the possibility of malfunction when the light bulb shaped lamp A110 is shaken.

Note that, the fixing wire 160a may be a wire for supplying power to the group of light-emitting devices 300a in the same manner as the lead wire 170. In this case, the fixing wire 160a is electrically connected to the lighting circuit 180 such that the DC power from the lighting circuit 180 can be transmitted therethrough. Furthermore, in this case, the fixing wire 160a and the lead wires 170a and 170b are electrically connected to the group of the light-emitting devices 300a such that the power can be supplied to the group of light-emitting devices 300a.

Note that, the elastic parts 17 may be provided in the lead wires 170 and the fixing wire 160a at a position away from a predetermined distance from the base mount 210n.

### Variation 11 of Embodiment 1

The fixing structure for four LED modules 200N shall be described in the variation 11 of the embodiment 1.

In the variation 11 of the embodiment 1, the four LED modules 200N are also referred to as an LED module 200Na, 200Nb, 200Nc, and 200Nd in order to distinguish the four LED modules 200N. The base mounts 210n corresponding to the LED modules 200Na, 200Nb, 200Nc, and 200Nd are also referred to as the base mount 210na, 210nb, 210nc, and 210nd, respectively.

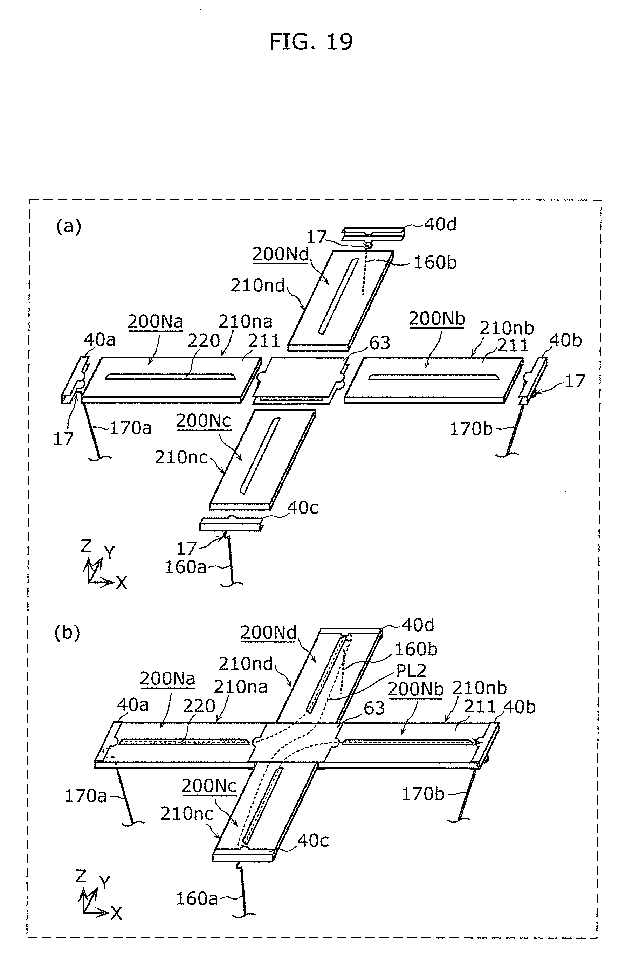

FIG. 19 is a diagram for describing the fixing structure according to the variation 11 of the embodiment 1.

(a) in FIG. 19 illustrates the LED modules 200Na, 200Nb, 200Nc, and 200Nd before being fixed. Note that, in the fixing structure according to the variation 11 of the embodiment 1, the fixing wires 160a and 160b are additionally used.

(b) in FIG. 19 illustrates the LED modules 200Na, 200Nb, 200Nc, and 200Nd fixed.

In the following description, a light bulb shaped lamp according to the variation 11 of the embodiment 1 may be referred to as a light bulb shaped lamp A111. The light bulb shaped lamp A111 is different from the light bulb shaped lamp A18 according to the variation 8 of the embodiment 1 illustrated in FIG. 16 in that the LED modules 200Na, 200Nb, 200Nc, and 200Nd integrated by a connecting part 63 are included instead of the LED module 200N, and fixing wires 160a and 160b and end portion fixing parts 40c and 40d are further included. The rest of the structure of the light bulb shaped lamp A111 is identical to the light bulb shaped lamp A18. Accordingly, the description for the structure shall not be repeated.

In this case, the light bulb shaped lamp A111 includes the base mount 210na, 210nb, 210nc, and 210nd integrated by the connecting part 63, as illustrated in (b) in FIG. 19. Stated differently, the light bulb shaped lamp A111 has more than one base mount.

The configuration of the LED modules 200Na, 200Nb, 200Nc, and 200Nd are identical to the configuration of the LED module 200N. Stated differently, a plurality of the semiconductor light-emitting devices 300 are mounted on the main surface 211 of each of the base mounts 210na, 210nb, 210nc, and 210nd corresponding to the LED modules 200Na, 200Nb, 200Nc, and 200Nd, respectively. Accordingly, the group of light-emitting devices 300a is formed on the main surface 211 of each of the base mounts 210na, 210nb, 210nc, and 210nd.

As illustrated in (a) in FIG. 19, the shape of the connecting part 63 allows the connecting part 63 to clip one of two end portions to be connected in each of the base mounts 210na, 210nb, 210nc, and 210nd. Stated differently, the connecting part 63 has a shape for integrating the base mounts 210na, 210nb, 210nc, and 210nd.

The connecting part 63 is made of the conductive material of which the connecting part 61 is made of.

Since the end portion fixing parts 40a and 40b are described above, the detailed description for them is not repeated.

One end portion of each of the fixing wires 160a and 160b is fixed by the fixing part 120, in the same manner as the lead wires 170a and 170b illustrated in FIG. 1. Note that, the fixing wires 160a and 160b are metal wires not used for supplying power. The metal wires contain copper, for example.

The shape of the fixing wires 160a and 160b is identical to the shape of the lead wire 170. Furthermore, each of the fixing wires 160a and 160b has the elastic part 17.

In the following description, each of the fixing wires 160a and 160b may be simply referred to as the fixing wire 160.

Since the end portion fixing parts 40a and 40b are described above, the detailed description for them is not repeated. The end portion fixing parts 40a and 40b are electrically connected to the lead wires 170a and 170b, respectively.

Since the end portion fixing part 40c is described above, the detailed description is not repeated. More specifically, the end portion fixing part 40c is electrically connected to the fixing wire 160a.

The shape and the structure of the end portion fixing part 40d are identical to those of the end portion fixing part 40a. The bottom part of the end portion fixing part 40d is connected to the tip of the fixing wire 160b by welding using laser, for example. More specifically, the end portion fixing part 40d is electrically connected to the fixing wire 160b. Stated differently, the elastic parts 17 of the lead wire 170 and the fixing wire 160 are provided in the vicinity of the base mount 210n.

As illustrated in (b) in FIG. 19, the connecting part 63 are provided so as to clip one of two end portions to be connected in each of the base mounts 210na, 210nb, 210nc, and 210nd. To put it differently, the base mounts 210na, 210nb, 210nc, and 210nd are integrated by the connecting part 63. Accordingly, the LED modules 200Na, 200Nb, 200Nc, and 200Nd are integrated by the connecting part 63.

The group of light-emitting devices 300a formed on the base mount 210na, the group of light-emitting devices 300a formed on the base mount 210nd, the group of light-emitting devices 300a formed on the base mount 210nc, and the group of light-emitting devices 300a formed on the base mount 210nb are electrically connected in series.

The end portion fixing part 40a is provided clipping the other end portion to be connected in the base mount 210na. The end portion fixing part 40b is provided so as to clip the other end portion to be connected in the base mount 210nb. The end portion fixing part 40c is provided so as to clip the other end portion to be connected in the base mount 210nc. The end portion fixing part 40d is provided clipping the other end portion to be connected in the base mount 210nd.

As described above, the end portion fixing parts 40a, 40b, 40c, and 40d are connected to the lead wires 170a and 170b, and the fixing wires 160a and 160b, respectively.

The lead wires 170a, 170b, and the fixing wires 160a and 160b are fixed to the end portions of the multiple base mounts such that the base mounts 210na, 210nb, 210nc, and 210nd integrated by the connecting part 63 are fixed, respectively. Stated differently, the lead wires 170a and 170b, and the fixing wires 160a and 160b are connected to the end portions of the base mount 210na, 210nb, 201nc, and 210nd, respectively.

Stated differently, the lead wire is fixed to an end portion of the multiple base mounts so as to fix the base mounts integrated by the connecting part.

Accordingly, the end portion fixing part for fixing the end portion is provided in each of end portions of the four base mounts integrated. Each of at least two lead wires is connected to two of the four end portion fixing parts.

Accordingly, the multiple base mounts integrated are supported by at least two lead wires.

The lead wires 170a and 170b are electrically connected to the group of light-emitting devices 300a such that the DC power from the lighting circuit 180 can be supplied to the groups of light-emitting devices 300a corresponding to the base mount 210na, 210nb, 210nc, and 210nd through the end portion fixing parts 40a and 40b. With this, the four groups of light-emitting devices 300a emit light by the flow of current through the current path PL2 in (b) in FIG. 19.

With the configuration described above, the position of the integrated base mounts 210n are fixed by the lead wires 170a and 170b, the fixing wires 160a and 160b, and the end portion fixing parts 40a, 40b, 40c, and 40d, and the DC power can be supplied to the four groups of light-emitting devices 300a using the lead wires 175a and 175b, the fixing wires 160a and 160b, and the end portion fixing parts 40a and 40b.

Each of the lead wires 170 and the fixing wires 160 has the elastic part 17. Accordingly, the same effect achieved by the embodiment 1 is achieved. More specifically, the light bulb shaped lamp A111 according to the variation 11 of the embodiment 1 can suppress the possibility of malfunction when the light bulb shaped lamp A111 is shaken.

Note that, the elastic parts 17 may be provided in the lead wires 170 and the fixing wire 160a at a position away from a predetermined distance from the base mount 210n.

Note that, the structure for fixing the multiple base mounts integrated is not limited to the structures illustrated in the variations 9 to 11 in the embodiment 1. For example, as illustrated in FIG. 14, the multiple base mounts integrated may be fixed by the lead wires or the fixing wires each having the bent part 18. In this structure, the end portion fixing part for fixing the multiple base mounts integrated is not necessary.

Note that, in the fixing structures according to the variations 9 to 11 in the embodiment 1, the connecting parts (the connecting parts 61, 62, and 63) for integrating the multiple base mounts 210n may be fixed by the rod part 120a of the fixing part 120, in the same manner as the structure illustrated in FIG. 13. With this structure, the multiple base mounts 210n integrated can be fixed very firmly.

### Variation 12 of Embodiment 1

In the variation 12 of the embodiment 1, the fixing structure for an LED module 200B having a base mount in a shape different from the embodiments described above shall be described.

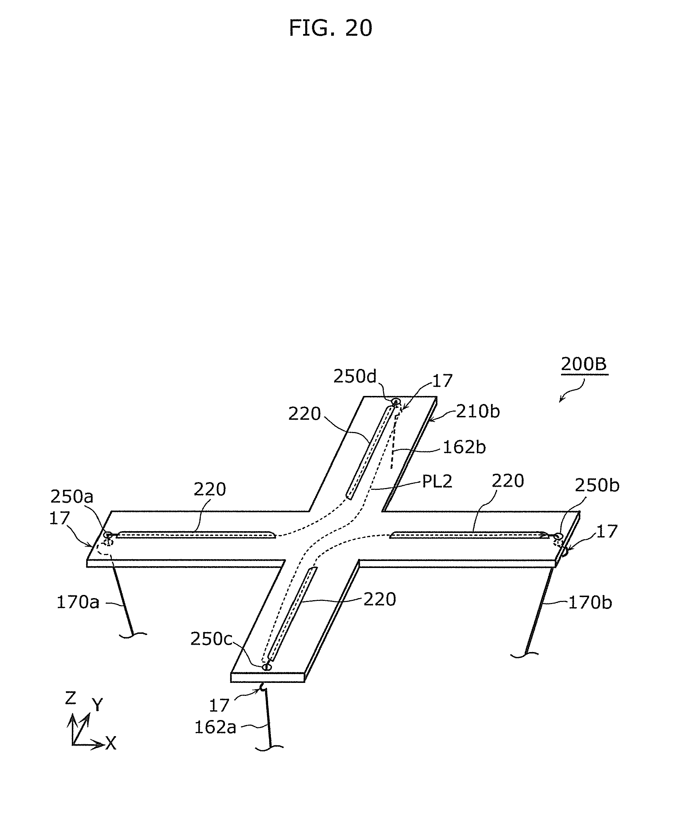

FIG. 20 is a diagram for describing the fixing structure according to the variation 12 of the embodiment 1.

In the following description, a light bulb shaped lamp according to the variation 12 of the embodiment 1 may be referred to as a light bulb shaped lamp A112. The light bulb shaped lamp A112 is different from the light bulb shaped lamp A18 according to the variation 8 of the embodiment 1 illustrated in FIG. 16 in that the LED module 200B is included instead of the LED module 200N, and fixing wires 162a and 162b are further included. The rest of the structure of the light bulb shaped lamp A112 is identical to the light bulb shaped lamp A18. Accordingly, the description for the structure shall be omitted.

As illustrated in FIG. 20, the LED module 200B includes the base mount 210b, four groups of light-emitting devices 300a that are not illustrated, and four sealing parts 220.

The base mount 210b is formed of a plurality of base mounts 210n integrated, as illustrated in FIG. 19. The base mount 210b is board-shaped and cross-shaped. The base mount 210b has holes 250a, 250b, 250c, and 250d.

In the following description, each of the holes 250a, 250b, 250c, and 250d may be simply referred to as the lead wire 250 as well. The hole 250 has a same shape as the hole 250 illustrated in FIG. 4 and others.

The four groups of light-emitting devices 300a that are not illustrated are formed on the base mount 210b. Each of the groups of light-emitting devices 300a includes a plurality of semiconductor light-emitting devices 300 mounted on the main surface 211 of the base mount 210b as illustrated in FIG. 4. The four groups of light-emitting devices 300a are sealed by the four sealing parts 220, respectively.

Note that, the four groups of light-emitting devices 300a formed on the base 210b are electrically connected in series such that the current flows through the current path PL2, for example.

The LED module 200B is fixed by the lead wires 170a and 170b, and the fixing wires 162a and 162b.

Since the structure and function of the lead wires 170a and 170b are described referring to FIG. 8, the detailed description is not repeated. As illustrated in FIG. 8, the lead wires 170a and 170b are fixed, passing though the holes 250a and 250b, respectively.

Each of the fixing wires 162a and 162b has the elastic part 17, in the same manner as the fixing wires 160a and 160b. Accordingly, the shape of the fixing wires 162a and 162b are identical to the lead wire 170 in FIG. 8. Since the rest of the structure and function of the fixing wires 162a and 162b are identical to those of the fixing wires 160a and 160b, the detailed description shall not be repeated.

In the same manner as the lead wires 170, the fixing wires 162a and 162b are fixed, passing though the holes 250c and 250d, respectively. Each of the fixing wires 162a and 162b may be simply referred to as the fixing wire 162 in the following description.

Stated differently, the elastic parts 17 of the lead wire 170 and the fixing wire 162 are provided in the vicinity of the base mount 210b.

In the same manner as FIG. 8, the elastic part 17 in each of the lead wires 170 and the elastic part 17 in each of the fixing wires 162 are capable of positioning the base mount 210 in the globe 110 in the process for fixing the lead wires 170 and the fixing wires 162 to the base mount 210b.

Accordingly, the same effect achieved by the embodiment 1 is achieved in this embodiment. More specifically, the light bulb shaped lamp A112 according to the embodiment 7 can suppress the possibility of malfunction when the light bulb shaped lamp A112 is shaken.

Note that, in the fixing structure for the LED module 200B in the embodiment, the structure described in the variations 1 and 2 of the embodiment 1 and others using the hole 251 may be applied.

Note that, the LED module 200B may be fixed by the rod part 120a of the fixing part 120 at the center part on the back surface of the base mount 210b, as illustrated in the fixing structure according to the variation 5 of the embodiment 1 (FIG. 13).

Note that, the elastic parts 17 may be provided in the lead wires 170 and the fixing wires 162 at a position away from a predetermined distance from the base mount 210b.

### Variation 13 of Embodiment 1

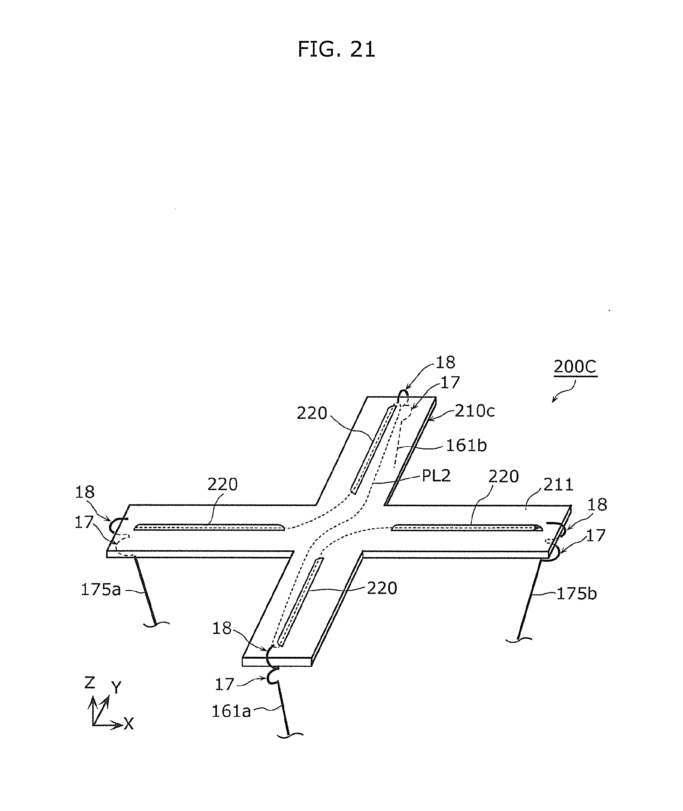

FIG. 21 is a diagram for describing the fixing structure according to the variation 13 of the embodiment 1. The fixing structure for the LED module 200C shall be described in the variation 13 of the embodiment 1.

In the following description, a light bulb shaped lamp according to the variation 13 of the embodiment 1 may be referred to as a light bulb shaped lamp A113. The light bulb shaped lamp A113 is different from the light bulb shaped lamp A16 according to the variation 6 of the embodiment 1 illustrated in FIG. 14 in that the LED module 200C is included instead of the LED module 200N. The rest of the structure of the light bulb shaped lamp A113 is identical to the light bulb shaped lamp A16. Accordingly, the description for the structure shall be omitted.

As illustrated in FIG. 21, the LED module 200C is different from the LED module 200B in FIG. 20 in that a base mount 210c is included instead of the base mount 210b. The rest of the configuration of the LED module 200C is identical to the LED module 200B. Accordingly, the detailed description for the structure is not repeated.

The base mount 210c is different from the base mount 210b in that the holes 250a, 250b, 250c, and 250d are not provided. The rest of the structure and the shape of the base mount 210c are identical to the base mount 210b. Accordingly, the detailed description shall not be repeated.

The base mount 210c is board-shaped and cross-shaped. The four groups of light-emitting devices 300a that are not illustrated are formed on the base mount 210c. The four groups of light-emitting devices 300a are sealed by the four sealing parts 220, respectively.

Note that, the four groups of light-emitting devices 300a formed on the base mount 210c are electrically connected in series such that the current flows through the current path PL2, for example.

In the same manner as the fixing structure according to the variation 6 of the embodiment 1, the LED module 200C is fixed by the lead wires 175a and 175b and the fixing wires 161a and 161b. Stated differently, each of the end portions of the base mount 210c in the LED module 200C are fixed by one of the lead wires 175 or the fixing wires 161 clipping the end portion. Stated differently, the elastic parts 17 of the lead wires 175 and the fixing wires 161 are provided in the vicinity of the base mount 210c.

Since the structure and function of the fixing wires 175a and 175b and the fixing wires 161a and 161b are described above, the detailed description is not repeated.

With this configuration, even if the base mount is cross-shaped, the LED module 200C (the base mount 210c) firmly, according to the configuration of the variation 13 of the embodiment 1.

Each of the lead wires 175 and the fixing wires 161 has the elastic part 17. Accordingly, the same effect achieved by the embodiment 1 is achieved. More specifically, the light bulb shaped lamp A113 according to the variation 13 of the embodiment 1 can suppress the possibility of malfunction when the light bulb shaped lamp A113 is shaken.

Note that, the LED module 200C may be fixed by the rod part 120a of the fixing part 120 at the center part on the back surface of the base mount 210c, as illustrated in the fixing structure according to the variation 5 of the embodiment 1 (FIG. 13).

Note that, the elastic parts 17 may be provided in the lead wire 175 and the fixing wire 161 at a position away from a predetermined distance from the base mount 210c.

### Variation 14 of Embodiment 1

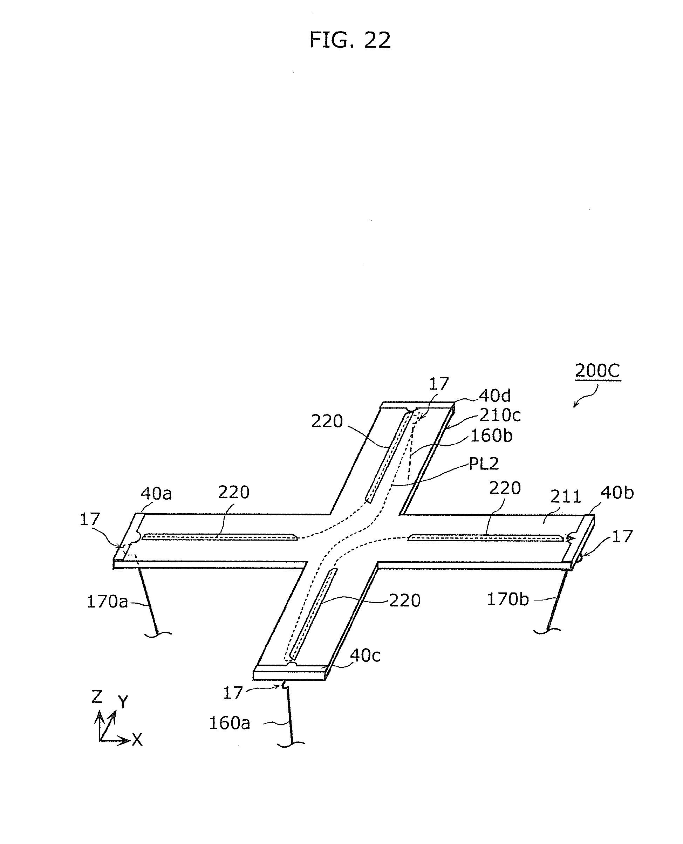

FIG. 22 is a diagram for describing the fixing structure according to the variation 14 of the embodiment 1. The fixing structure for the LED module 200C shall be described in the variation 14 of the embodiment 1.

In the following description, a light bulb shaped lamp according to the variation 14 of the embodiment 1 may be referred to as a light bulb shaped lamp A114. The light bulb shaped lamp A114 is different from the light bulb shaped lamp A111 according to the variation 11 of the embodiment 1 illustrated in FIG. 19 in that the LED module 200C is included instead of the four LED modules 200N integrated. The rest of the structure of the light bulb shaped lamp A114 is identical to the light bulb shaped lamp A111. Accordingly, the description for the structure shall be omitted.

As shown in FIG. 22, the LED module 200C is fixed by the fixing structure as illustrated in FIG. 19 described in the variation 11 of the embodiment 1. Stated differently, the LED module 200C is fixed by the end portion fixing parts 40a, 40b, 40c, and 40d, the lead wires 170a and 170b, and the fixing wires 160a and 160b, in the same manner as the integrated base mount in FIG. 19. Stated differently, the elastic parts 17 of the lead wires 170 and the fixing wires 160 are provided in the vicinity of the base mount 210c.

Note that, the four groups of light-emitting devices 300a formed on the base mount 210c are electrically connected in series such that the current flows through the current path PL2, for example.

With this configuration, even if the base mount is cross-shaped, the LED module 200C (the base mount 210c) is fixed firmly, according to the configuration of the variation 14 of the embodiment 1.

Each of the lead wires 170 and the fixing wires 160 has the elastic part 17. Accordingly, the same effect achieved by the embodiment 1 is achieved. More specifically, the light bulb shaped lamp A114 according to the variation 14 of the embodiment 1 can suppress the possibility of malfunction when the light bulb shaped lamp A114 is shaken.

Note that, the LED module 200C may be fixed by the rod part 120a of the fixing part 120 at the center part on the back surface of the base mount 210c, as illustrated in the fixing structure according to the variation 5 of the embodiment 1 (FIG. 13).

Note that, the elastic parts 17 may be provided in the lead wires 170 and the fixing wires 160 at a position away from a predetermined distance from the base mount 210c.

### Embodiment 2

### (Overall structure of light bulb shaped lamp)

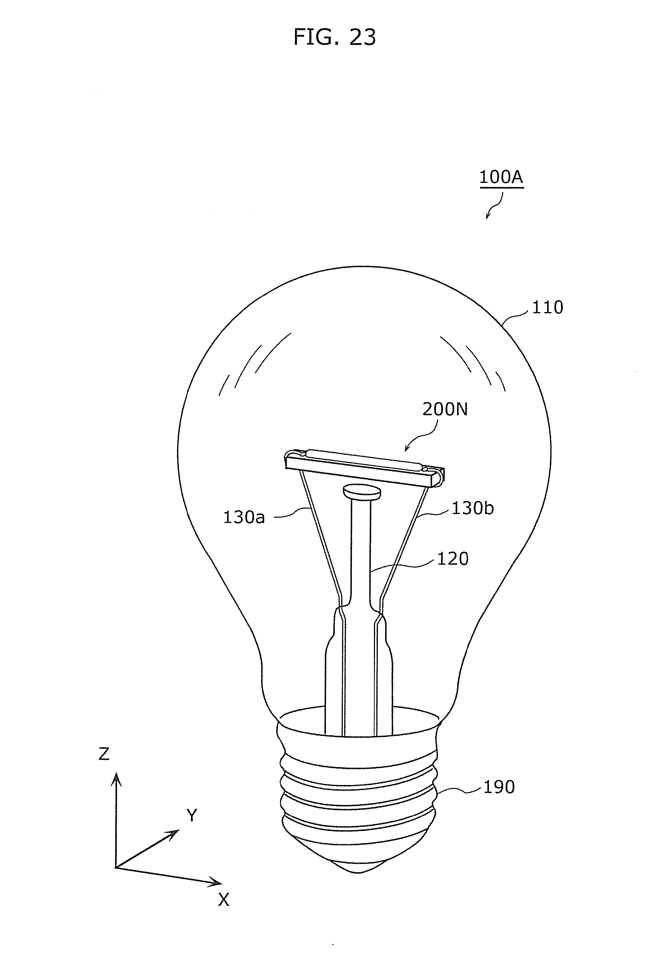

The overall structure of the light bulb shaped lamp 100A according to the embodiment 2 shall be described with reference to FIG. 23 to FIG. 25.

FIG. 23 is a perspective view of the light bulb shaped lamp according to the embodiment 2.

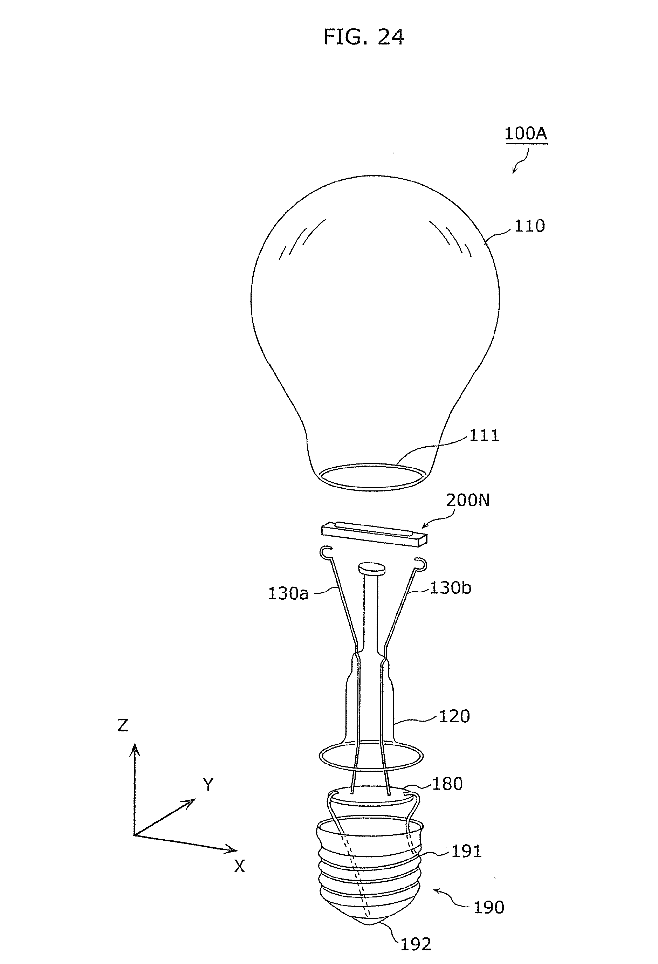

FIG. 24 is an exploded perspective view of the light bulb shaped lamp according to the embodiment 2.

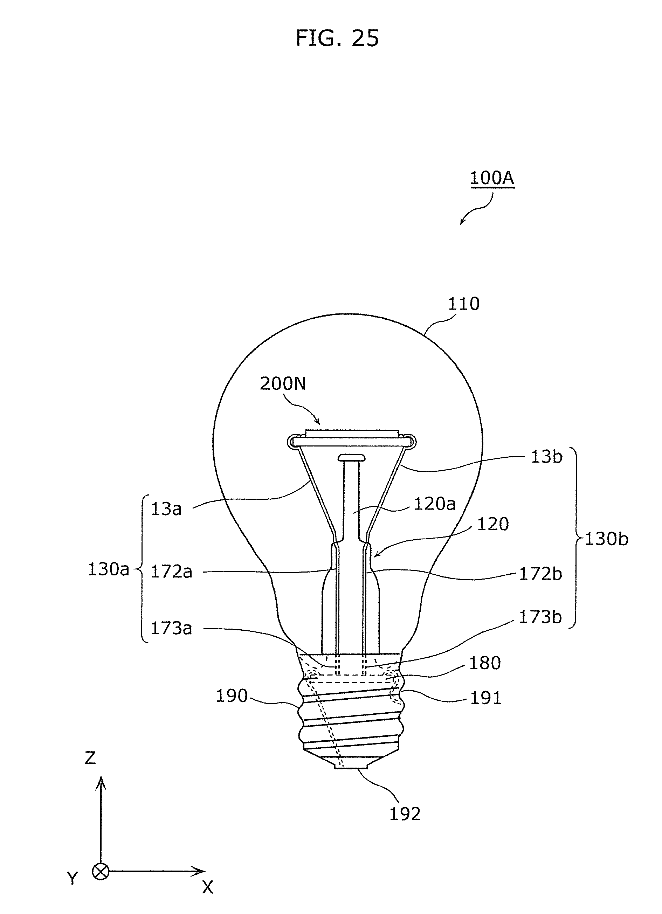

FIG. 25 is a front view of the light bulb shaped lamp according to the embodiment 2.

The light bulb shaped lamp 100A is different from the light bulb shaped lamp 100 in FIG. 1 in that lead wires 130a and 130b are provided instead of the lead wires 170a and 170b, and an LED module 200N is provided instead of the LED module 200. The rest of the structure of the light bulb shaped lamp 100A is identical to the light bulb shaped lamp 100. Accordingly, the detailed description is not repeated.

The lead wires 130a and 130b have the same structure and function as the lead wires 170a and 170b. Accordingly, the detailed description for the lead wires 130a and 130b is omitted.

Note that, in FIG. 25, the lighting circuit 180 and part of lead wires 130a and 130b for power supply and for support which are positioned inside the base 190 are illustrated in dotted lines.

The LED module 200N is electrically connected to the lead wires 130a and 130b.

The lead wire 130a is a composite wire including an internal lead wire 13a, the Dumet wire 172a, and the external lead wire 173a joined in order. The lead wire 130b is a composite wire including an internal lead wire 13b, the Dumet wire 172b, and the external lead wire 173b joined in order.

In the following description, each of the lead wire 130a and 130b may be simply referred to as the lead wire 130. Furthermore, in the following description, each of the internal lead wires 13a and 13b may be simply referred to as the internal lead wire 13.

The internal lead wire 13 is an electric wire extending from the fixing part 120 to be described later to the LED module 200N. The internal lead wire 13 is joined with the base mount 210n to be described later, and supports the LED module 200N (the base mount 210n). Stated differently, the base mount 210n to be described later is supported by the lead wires 130a and 130b.

In addition, two lead wires 130 do not have to be provided. For example, when the light bulb shaped lamp 100A includes a plurality of the LED modules 200N in the globe 110, two lead wires 130 may be provided for each of the LED modules 200N. Accordingly, the light bulb shaped lamp 100A may include the lead wires 130 twice in number as the number of the LED modules 200N.

Among the internal lead wire 13, the Dumet wire 172, and the external lead wire 173 composing the lead wire 130, the fixing part 120 seals the Dumet wire 172. To put it differently, the fixing part 120 fixes the lead wire 130 exposing a part of the lead wire 130 (the internal lead wire 13).

The globe 110 covers the LED module 200N, part of the lead wires 130a and 130b, a part of the fixing part 120, and others. The LED module 200N is positioned at a part around the center of the globe 110. The globe 110 is made of a translucent material, as described above.

With this, the light bulb shaped lamp 100A can reduce the loss of light emitted by the semiconductor light-emitting device 300 caused by the globe 110.

The light from the LED module 200N passes through the globe 110, and is emitted to outside.

Since the LED module 200N is positioned around the center of the globe 110, omnidirectional light distribution property is achieved when the LED module 200N emits light.

The lighting circuit 180 is electrically connected to the lead wires 130a and 130b.

### (The configuration of LED module)

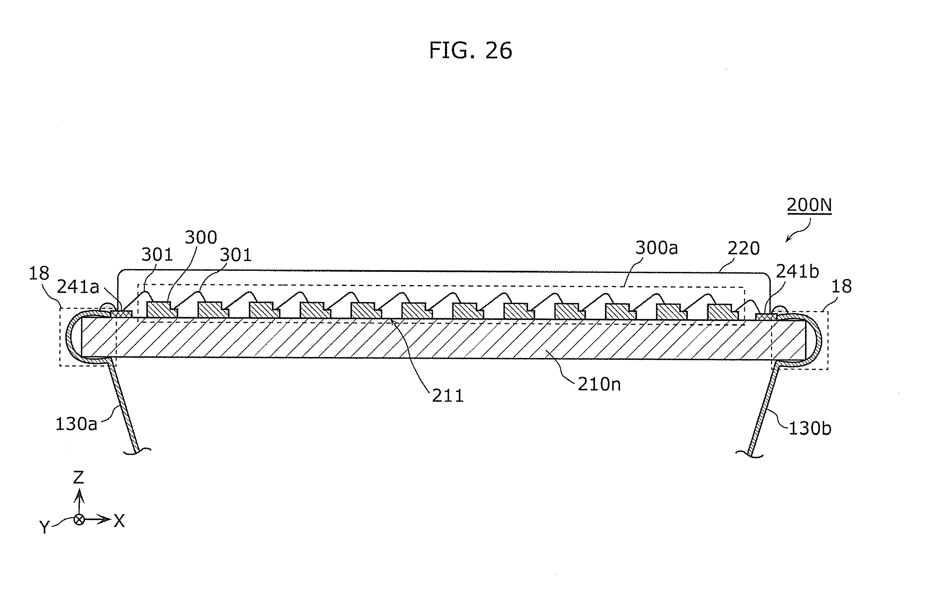

FIG. 26 is a cross-sectional view illustrating the configuration of the LED module 200N. Note that, the lead wires 130a and 130b not included in the LED module 200N are also illustrated in FIG. 26.

Note that, the details on the shape of the lead wires 130a and 130b shall be described later.

The LED module 200N is housed in the globe 110, and is preferably positioned at the center of the sphere defined by the globe 110. With this structure, the light bulb shaped lamp 100A can achieve omnidirectional light distribution property when the light bulb shaped lamp 100 is switched on. The omnidirectional light distribution property is approximated to a common incandescent light bulb using conventional filament coil.

As shown in FIG. 26, the LED module 200N includes the base mount 210n described above, a plurality of semiconductor light-emitting devices 300, and a sealing part 220.

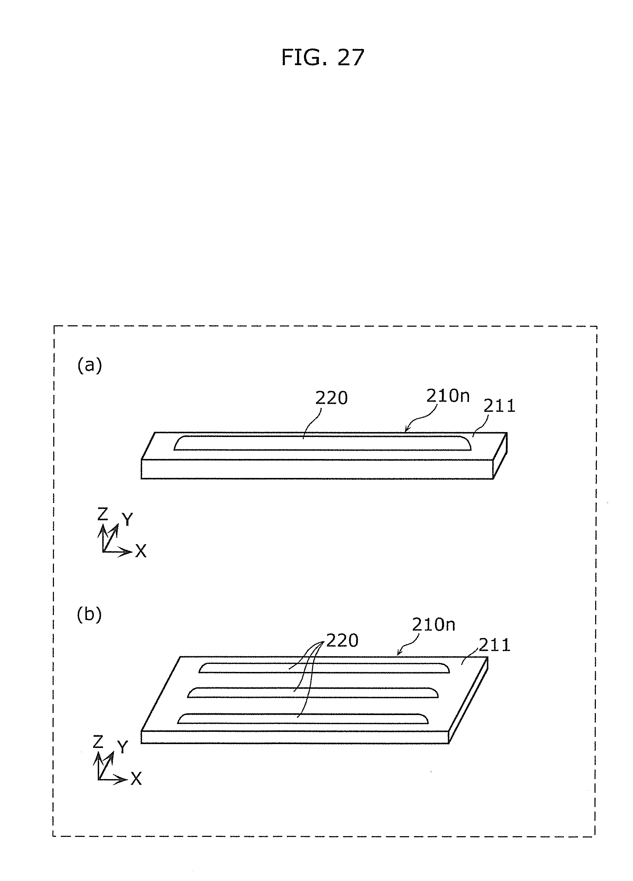

The shape of the base mount 210n is a quadrangular prism, as illustrated in (a) in FIG. 27.

Note that, the shape of the base mount 210n is not limited to the quadrangular prism, and may be other shape. The shape of the base mount 210n may be like a board, as illustrated in FIG. 27 (b).

If the shape of the base mount 210n is a quadrangular prism, the LED module 200N in the light bulb shaped lamp 100A can imitate the filament of an incandescent light bulb.

End portions of the lead wires 130a and 130b are fixed to the power supply terminals 241a and 241 by solder, respectively. Accordingly, the lead wires 130a and 130b are electrically connected to the power supply terminals 241a and 241, respectively. To put it differently, the lead wires 130a and 130b are fixed to the base mount 210n (the LED module 200N) by solder.

The base mount 210n has a main surface 211. The semiconductor light-emitting devices 300 are mounted in a straight line on the main surface 211. Stated differently, the semiconductor light-emitting devices 300 are mounted on the main surface 211 of the base mount 210n such that the semiconductor light-emitting devices 300 are arranged in a straight line between the power supply terminal 241a and the power supply terminal 241b.

The group of light-emitting devices 300a is formed of the semiconductor light-emitting devices 300 mounted on the main surface 211 on the base mount 210n in a straight line. The power is supplied to the semiconductor light-emitting devices 300 composing the group of light-emitting devices 300a from the lead wires 130a and 130b.

To put it differently, the lead wires 130a and 130b are electric wires for supplying power to the semiconductor light-emitting devices 300. More specifically, the lead wires 130a and 130b are electric wires for supplying power to the LED module 200N as the light-emitting module.

Note that, if the shape of the base mount 210n is a quadrangular prism, the semiconductor light-emitting devices 300 composing the group of light-emitting devices 300a may be formed on a side surface of the base mount 210n different from the main surface 211.

Note that, as illustrated in FIG. 27 (b), if the base mount 210n is board-shaped, three sealing parts 220 for sealing the group of light-emitting devices 300a are formed on the main surface 211. Accordingly, three groups of light-emitting devices 300a are formed on the main surface 211 of the base mount 210n. In this case, the three groups of the light-emitting devices 300a are electrically connected in series.

The LED module 200N is fixed by the lead wires 130a and 130b such that the main surface 211 of the base mount 210n faces toward the top of the globe 110.

Since the base mount 210n is translucent, the white light emitted from the linear sealing part 220 is transmitted through the inside of the base mount 210n and is emitted from the back surface and the side surfaces of the base mount 210n.

Note that, the sealing part 220 containing the wavelength conversion material may be provided on the back surface of the base mount 210n on which the semiconductor light-emitting devices 300 are not mounted.

The following shall describe the structure for fixing the LED module included in the light bulb shaped lamp in detail.

The fixing structure according to the embodiment 2 shall be described with reference to FIG. 26. The fixing structure for the LED module 200N shall be described in the embodiment 2.

More specifically, the end portion of each of the lead wires 130a and 130b has a bent part 18 having a shape which allows the bent part 18 to clip the end portion of the base mount. The bent part 18 is an end portion clipping part clipping the end portion of the base mount. The bent part 18 is an end portion of each of the lead wires 130a and 130b formed in U-shape.

Stated differently, each of the end portion clipping parts (bend parts 18) is a bent part formed by bending the end portion of the lead wire corresponding to the end portion clipping part. To put it differently, the bent part 18 as the end portion clipping part is a bent part of the end portion of the lead wire. The bent portion 18 is U-shaped.

Note that, the shape of the bent portion 18 is not limited to U-shape, but may be square U-shape.

As illustrated in FIG. 26, the lead wire 130a is provided such that the bent part 18 in the lead wire 130a clips one of the two end portions of the base mount 210n orthogonal to the X-axis direction. The lead wire 130b is provided such that the bent portion 18 in the lead wire 130b clips the other of the two end portions of the base mount 210n orthogonal to the X-axis direction.

More specifically, at the end portion of each of the lead wires 130, the bent part 18 as the end portion clipping part is formed. Each of the bent parts 18 in the lead wires 130 clips one of the end portions of the base mount 210n. More specifically, the end portion clipping parts (the bent parts 18) formed in the lead wires 130 clips the end portions of the base mount 210n. Accordingly, at least two end portions of the base mount 210n clipped by the bent parts 18 are parallel to the same direction (Y-axis direction).

Stated differently, the base mount 210n is fixed by the clipping by the bent parts 18 in the lead wires 130a and 130b. Stated differently, the base mount 210n to be described later is supported by the lead wires 130a and 130b. Accordingly, the base mount 210n is clipped and supported by the bent parts 18 (end portion clipping parts) in the lead wires 130a and 130b.

The lead wires 130a and 130b are electrically connected to the group of light-emitting devices 300a such that the DC power from the lighting circuit 180 can be supplied to the group of light-emitting devices 300a.

With the structure described above, the base mount 210n on which the semiconductor light-emitting device is mounted is supported by the lead wire having the end portion clipping part (the bent part 18) clipping the end portions of the base mount 210n at the end portion. Stated differently, the base mount 210n is fixed by the clipping by the bent parts 18 in the lead wires 130a and 130b.

Accordingly, the base mount 210n is fixed firmly by the lead wires 130a and 130b clipping the end portions of the base mount 210n. Accordingly, the base mount on which the semiconductor light-emitting device is mounted is fixed firmly.

Note that, in the embodiment, each of the left end portion and the right end portion of the base mount 210n is fixed by one lead wire having the bent part 18. However, it is not limited to this example. For example, each of the left end portion and the right end portion of the base mount 210n may be fixed by a plurality of lead wires each having the bent part.

The base mount 210n on which the semiconductor light-emitting device 300 is mounted is supported by the lead wires 130. With this, it is possible to suppress the large part of the light emitted by the semiconductor light-emitting device 300 mounted on the base mount 210n.

Furthermore, the base mount 210n is translucent. With this, it is possible to prevent the large part of the light emitted by the semiconductor light-emitting device 300 from being blocked. Accordingly, a sufficient light distribution angle can be achieved.

### Variation 1 of Embodiment 2

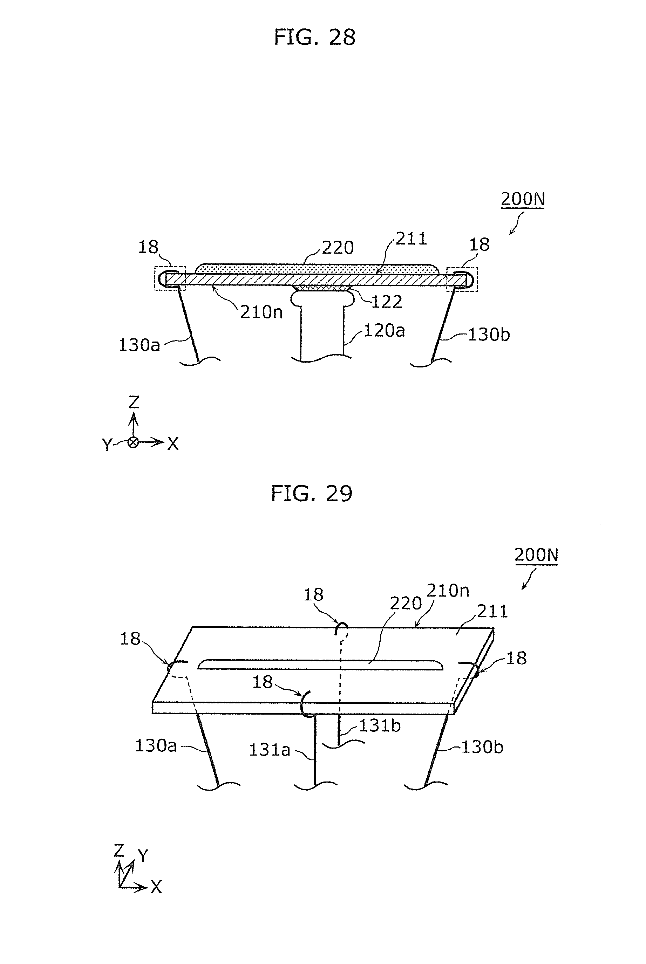

FIG. 28 is a cross-sectional view for describing the fixing structure according to the variation 1 of the embodiment 2. The fixing structure for the LED module 200N shall be described in the variation 1 of the embodiment 2.

The variation 1 of the embodiment 2 is different from the structure illustrated in FIG. 26 (the Embodiment 2) in that the base mount 210n is fixed by a rod part 120a of the fixing part 120 as the stem as well. The structure other than the structure for fixing the base mount 210n is identical to the embodiment 2. Accordingly, the detailed description for the structure shall not be repeated.

As described above, the fixing part 120 as the stem is provided on a side (the second surface) opposite to the main surface 211 of the base mount 210n.

The shape of the fixing part 120 in the variation 1 of the embodiment 2 is described as the rod part 120a of the fixing part 120 extending to the vicinity of the surface opposite to the main surface 211 of the base mount 210n.

The surface (the second surface) opposite to the main surface 211 of the base mount 210n is fixed to the tip of the rod part 120a of the fixing part 120 by adhesive 122. The surface (the second surface) opposite to the main surface 211 of the base mount 210n is fixed to the tip of the rod part 120a of the fixing part 120. Stated differently, the base mount 210n is also supported by the rod part 120a.

With the structure described above, according to the structure in the variation 1 of the embodiment 2, the base mount 210n is supported by the rod part 120a more firmly than the fixing structure according to the embodiment 2. Accordingly, the base mount 210n (the LED module 200N) is fixed even more firmly than the fixing structure in the embodiment 2.

Furthermore, in the variation 1 of the embodiment 2, each of the left end portion and the right end portion of the base mount 210n may be fixed by more than one lead wires each having a bent part, in the same manner as the embodiment 2.

In addition, the shape of the fixing part 120 may allow the tip of the rod part 120a of the fixing part 120 to contact the surface opposite to the main surface 211 of the base mount 210. In this case, the adhesive 122 may not be necessary.

In the following description, a light bulb shaped lamp having the fixing structure according to the variation 1 of the embodiment 2 may be referred to as a light bulb shaped lamp A21.

### Variation 2 of Embodiment 2

FIG. 29 is a cross-sectional view for describing the fixing structure according to the variation 2 of the embodiment 2. The fixing structure for the LED module 200N shall be described in the variation 2 of the embodiment 2.

In the following description, a light bulb shaped lamp having the fixing structure according to the variation 2 of the embodiment 2 may be referred to as a light bulb shaped lamp A22. The light bulb shaped lamp A22 is different from the light bulb shaped lamp A21 according to the variation 1 of the embodiment 2 described in FIG. 28 in that the light bulb shaped lamp A22 further includes fixing wires 131a and 131b. The rest of the structure of the light bulb shaped lamp A22 is identical to the light bulb shaped lamp A21. Accordingly, the detailed description for the structure shall be omitted.

The variation 2 of the embodiment 2 is different from the structure illustrated in FIG. 28 (the variation 1 of the embodiment 2) in that the base mount 210n is fixed by the fixing wires 131a and 131b. The structure other than the structure for fixing the base mount 210n is identical to the variation 1 of the embodiment 2. Accordingly, the detailed description for the structure shall not be repeated.

Note that, in FIG. 29, the rod part 120a of the fixing part 120 adhered to the back surface of the base mount 210n is not illustrated for simplifying the drawing.

The base mount 210n in the variation 2 of the embodiment 2 is board shaped. Three sealing parts 220 are formed on the board-shaped base mount 210, as illustrated in (b) in FIG. 27. In FIG. 29, the three sealing parts 220 are illustrated as one sealing part 220 for simplifying the drawing.

Note that, in the same manner, the diagrams to be illustrated later illustrate the three sealing parts 220 formed on the board-shaped base mount as one sealing part 220.

The base mount 210n in the variation 2 of the embodiment 2 is not limited to the board-shape, but may have the shape of quadrangular prism.

An end portion of each of the fixing wires 131a and 131b is fixed to the fixing part 120, exposing a part of the fixing wire 131a or 131b, in the same manner as the lead wires 130a and 130b in FIG. 23. Note that, the fixing wires 131a and 131b are metal wires not used for supplying power. The metal wires contain copper, for example.

In the following description, each of the fixing wires 131a and 131b may be simply referred to as the fixing wire 131.

The shape of the fixing wire 131 is identical to the shape of the lead wire 130. Stated differently, the bent part 18 is formed at the end portion of each of the fixing wires 131.

As illustrated in FIG. 29, the fixing wire 131a includes a bent part 18 of the fixing wire 131a clipping one of the two end portions of the base 210n parallel to the X-axis direction. The fixing wire 131b includes a bent part 18 of the fixing wire 131b clipping the other of the two end portions of the base mount 210n parallel to the X-axis direction.

As described above, the lead wire 130a is provided such that the bent part 18 in the lead wire 130a clips one of the two end portions of the base mount 210n orthogonal to the X-axis direction. The lead wire 130b is provided such that the bent portion 18 in the lead wire 130b clips the other of the two end portions of the base mount 210n orthogonal to the X-axis direction.

To put it differently, the base mount 210n is fixed by the bent parts 18 of the lead wires 130a and 130b, and the fixing wires 131a and 131b clipping the four end portions of the base mount 210n. Stated differently, the LED module 200N (the base mount 210n) is fixed (supported) by the lead wires 130a and 130b and the fixing wires 131a and 131b.

With the structure described above, in the configuration according to the variation 2 of the embodiment 2, four parts of the base mount 210n is supported by the lead wires 130a and 130b and the fixing wires 131a and 131b each having the bent part 18 at the end portion. Stated differently, the base mount 210n is also supported by the rod part 120a of the fixing part 120. Accordingly, the base mount 210n is fixed even more firmly than the fixing structure in the variation 1 of the embodiment 2.

Note that, the rod part 120a of the fixing part 120 may not be fixed to the back surface (the second surface) of the base mount 210n, and the base mount 210n may be fixed by the lead wires 130a and 130b and the fixing wires 131a and 131b.

Note that, the fixing wires 131a and 131b may be wires for supplying power to the group of light-emitting devices 300a in the same manner as the lead wires 130a and 130b. In this case, the fixing wires 131a and 131b are electrically connected to the lighting circuit 180 such that the DC power from the lighting circuit 180 can be transmitted therethrough. Furthermore, in this case, the fixing wires 131a and 131b and the lead wires 130b and 130b are electrically connected to the group of the light-emitting devices 300a such that the power can be supplied to the group of light-emitting devices 300a.

### Variation 3 of Embodiment 2

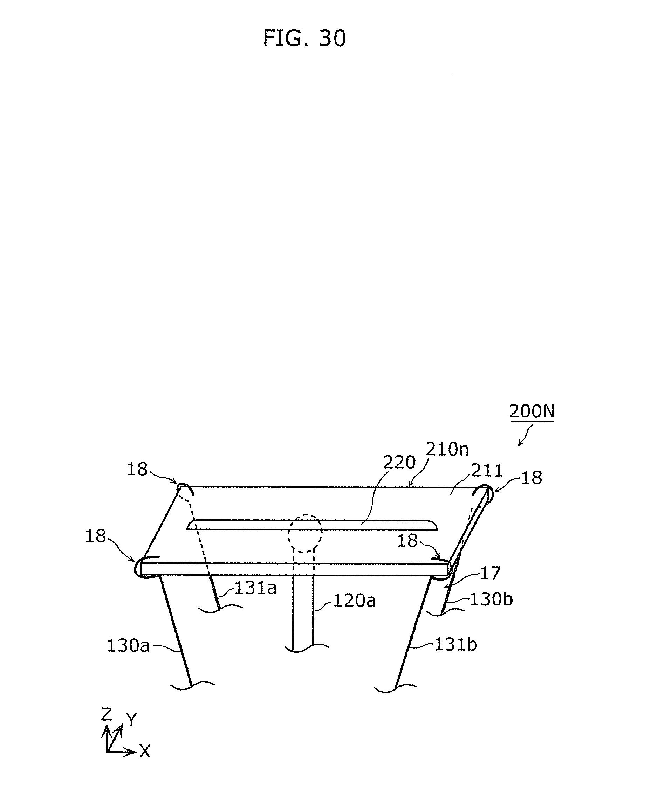

FIG. 30 is a cross-sectional view for describing the fixing structure according to the variation 3 of the embodiment 2. The fixing structure for the LED module 200N shall be described in the variation 3 of the embodiment 2.

In the following description, a light bulb shaped lamp having the fixing structure according to the variation 3 of the embodiment 2 may be referred to as a light bulb shaped lamp A23.

The variation 3 of the embodiment 2 is different from the structure illustrated in FIG. 29 (the variation 2 of the embodiment 2) in the positions to which the lead wires 130a and 130b and the fixing wires 131a and 131b are fixed. The structure other than the structure for fixing the base mount 210n is identical to the variation 2 of the embodiment 2. Accordingly, the detailed description for the structure shall not be repeated.

The base mount 210n has a shape of quadrangular prism. Accordingly, the base mount 210n has four corners (end portions).

As illustrated in FIG. 30, the lead wire 130a has a bent part 18 of the lead wire 130a clipping one of the four corners of the base mount 210n. The lead wire 130b has a bent part 18 of the lead wire 130b clipping one of the four corners of the base mount 210n.

Stated differently, at least two end portions of the base mount 210 clipped by the bent parts 18 of the lead wires 130 are corners of the base mount 210n.

The fixing wire 131a includes a bent part 18 of the fixing wire 131a clipping one of the four corners of the base mount 210n. The fixing wire 131b includes a bent part 18 of the fixing wire 131b clipping one of the four corners of the base mount 210b.

The lead wires 130a and 130b are provided holding two diagonal corners among the four corners. The fixing wires 131a and 131b are provided holding two diagonal corners among the four corners.

Note that, the positional relationship between the corners clipped by the bent parts 18 of the lead wires 130 and the fixing wires 131 is not limited to the relationship described above. For example, among the four corners, the lead wires 130a and 130b may be provided fixing two corners on the same end portion among the four corners.

As described above, the lead wires 130a and 130b are electrically connected to the group of light-emitting devices 300a such that the power can be supplied to the group of light-emitting devices 300a through the lead wires 130a and 130b.

With the structure described above, in the configuration according to the variation 3 of the embodiment 2, four parts of the base mount 210n are supported by the lead wires 130a and 130b, and the fixing wires 131a and 131b each having the bent part 18 at the end portion. Stated differently, the base mount 210n is also supported by the rod part 120a of the fixing part 120. Accordingly, the same effect achieved by the variation 2 of the embodiment 2 is achieved. According to the configuration described in the variation 3 of the embodiment 2, the base mount 210n is fixed even more firmly than the fixing structure in the variation 1 of the embodiment 2.

Note that, the fixing wires 131a and 131b may be wires for supplying power to the group of light-emitting devices 300a in the same manner as the lead wires 130a and 130b, as illustrated in the variation 2 of the embodiment 2.

Note that, the positions for the lead wires 130a and 130b and the fixing wires 131a and 131b to fix the base mount 210n are not limited to the positions illustrated in FIG. 30, and may be other positions.

Note that, the rod part 120a of the fixing part 120 may not be fixed to the back surface (the second surface) of the base mount 210n, and the base mount 210n may be fixed by the lead wires 130a and 130b and the fixing wires 131a and 131b.

### Variation 4 of Embodiment 2

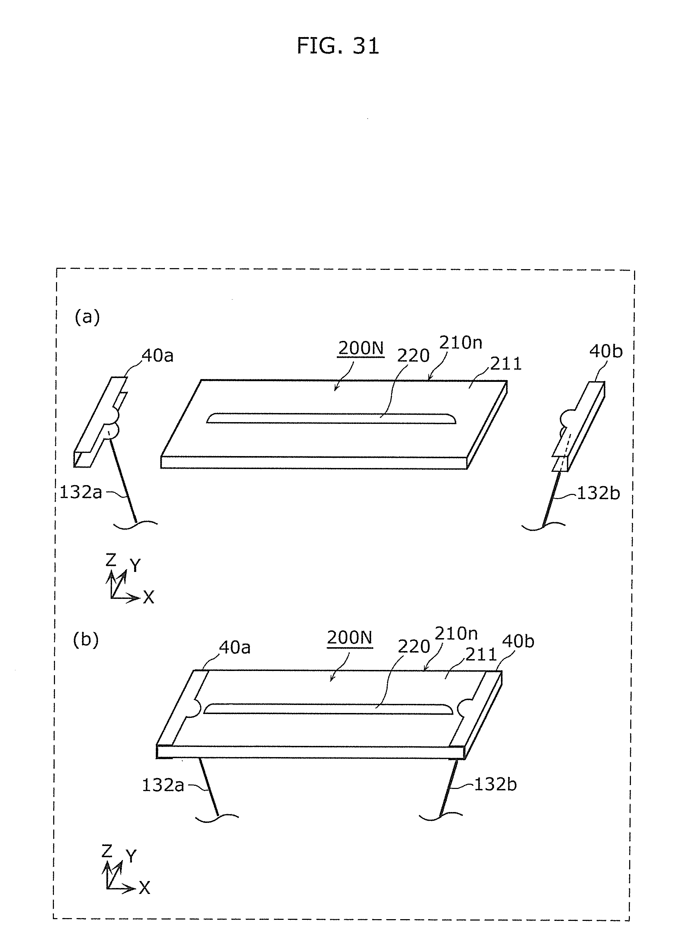

FIG. 31 is a cross-sectional view for describing the fixing structure according to the variation 4 of the embodiment 2. The fixing structure for the LED module 200N shall be described in the variation 4 of the embodiment 2.

In the following description, a light bulb shaped lamp having the fixing structure according to the variation 4 of the embodiment 2 may be referred to as a light bulb shaped lamp A24. The light bulb shaped lamp A24 is different from the light bulb shaped lamp 100A according to the embodiment 2 in that lead wires 132a and 132b are included instead of the lead wires 130a and 130b, and the end portion fixing parts 40a and 40b described above are included. The rest of the structure of the light bulb shaped lamp A24 is identical to the light bulb shaped lamp 100A. Accordingly, the detailed description for the structure shall be omitted.

(a) in FIG. 31 illustrates the LED module 200N before being fixed and the end portions fixing parts 40a and 40b used for fixing the LED module 200N. As illustrated in (a) in FIG. 31, the base mount 210n is board-shaped. Accordingly, the shape of the main surface 211 of the base mount 210n is quadrilateral. Note that, the shape of the base mount 210n is not limited to the board, and may be quadrangular prism.

(b) in FIG. 31 illustrates the LED module 200N fixed.

In the following description, each of the lead wires 132a and 132b may be simply referred to as the lead wire 132. Additionally, each of the end portion fixing parts 40a and 40b may be simply referred to as an end portion fixing part 40 in the following description.

As shown in (a) and (b) in FIG. 31, each of the end portion fixing parts 40a and 40b as the end portion clipping part clips a part corresponding to a side of the quadrilateral in the shape of the main surface 211 of the base mount 210n.

The bottom part of the end portion fixing part 40a is connected to the tip of the lead wire 132a by welding using laser, for example. More specifically, the end portion fixing part 40a is electrically connected to the lead wire 132a. The bottom part of the end portion fixing part 40b is connected to the tip of the lead wire 132b by welding using laser, for example.

Accordingly, the end portion fixing part 40b is electrically connected to the lead wire 132b. Stated differently, the tip of each of the lead wires 132a and 132b is connected to the end portion fixing part 40. Stated differently, the end portion fixing part 40 as the end portion clipping part clipping the end portion of the base mount 210n is provided at the tip of the lead wire 132.

Accordingly, the LED module 200N (the base mount 210n) is fixed (supported) by the lead wires 132a and 132b. Accordingly, the base mount 210n is clipped and supported by the bent parts 40 (end portion clipping parts) in the lead wires 132a and 132b.

As illustrated in (b) in FIG. 31, the end portion fixing part 40a is provided so as to clip one of the two end portions of the base mount 210n parallel to the Y-axis direction. The end portion fixing part 40b is provided so as to fix the other of the two end portions of the base mount 210n parallel to the Y-axis direction.

Stated differently, the end portions fixing parts 40 clipping the end portions of the base mount 210n are provided at the end portions of the base mount 210n.

The lead wires 132a and 132b are electrically connected to the group of light-emitting devices 300a such that the DC power from the lighting circuit 180 can be supplied to the group of light-emitting devices 300a through the end portion fixing parts 40a and 40b.

With the structure described above, the base mount 210n is supported by the lead wire 132 having the end portion fixing part 40 at the end for clipping the end portion of the base mount 210b. Accordingly, the base mount 210n is clipped and supported by the end portion fixing parts 40 (end portion clipping parts) in the lead wires 132a and 132b. With this structure, the base mount 210n can be fixed firmly.

Note that, the base mount 210n fixed by the fixing structure according to the variation 4 of the embodiment 2 may be fixed using the rod part 120a of the fixing part 120 as well, in the same manner as the structure illustrated in FIG. 28. With this structure, the base mount 210n can be fixed very firmly.

### Variation 5 of Embodiment 2

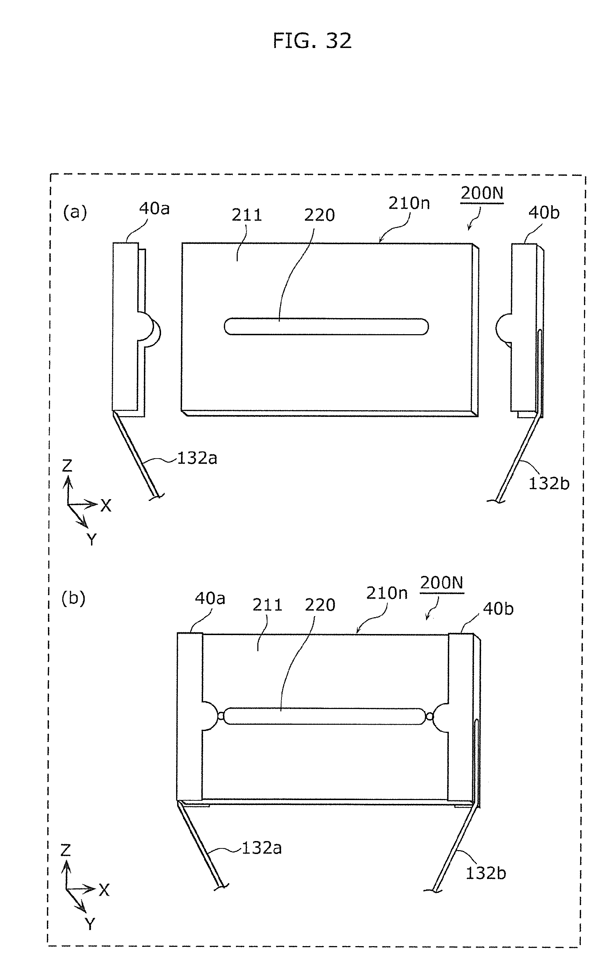

FIG. 32 is a diagram for describing the fixing structure according to the variation 5 of the embodiment 2. The fixing structure for the LED module 200N shall be described in the variation 5 of the embodiment 2.

In the following description, a light bulb shaped lamp according to the variation 2 of the embodiment 5 may be referred to as a light bulb shaped lamp A25. The light bulb shaped lamp A25 is different from the light bulb shaped lamp A24 according to the variation 4 of the embodiment 2 in the direction of fixing the LED module 200N. The rest of the structure of the light bulb shaped lamp A25 is identical to the light bulb shaped lamp A24. Accordingly, the detailed description for the structure shall be omitted.

(a) in FIG. 32 illustrates the LED module 200N before being fixed.

(b) in FIG. 32 illustrates the LED module 200N fixed.

As illustrated in (a) and (b) in FIG. 32, the base mount 210n (the LED module 200N) is arranged such that the main surface 211 of the base mount 210n is parallel to the Z-X plane. Note that, the Z-X plane here is a plane including the Z-axis direction and the X-axis direction.

The end portion fixing parts 40a and 40b are also arranged such that the longer direction of the end portion fixing parts 40a and 40b is parallel to the Z-axis direction.

The end portion fixing part 40a is connected to the end portion of the lead wire 132a by welding using laser, for example. The end portion fixing part 40b is connected to the end portion of the lead wire 132b by welding using laser, for example.

As illustrated in (b) in FIG. 32, the end portion fixing part 40a is provided so as to clip one of the two end portions of the base mount 210n parallel to the Z-axis direction. The end portion fixing part 40b is provided so as to fix the other of the two end portions of the base mount 210n parallel to the Z-axis direction.

With the structure described above, even if the base mount 210n (the LED module 200N) is provided such that the main surface 211 of the base mount 210n is parallel to the Z-X plane, the base mount 210n can be fixed firmly by the lead wire 132 having, at the end portion, the end portion fixing part 40 for clipping the end portion of the base mount 210n.

### Variation 6 of Embodiment 2

The fixing structure for two LED modules 200N shall be described in the variation 6 of the embodiment 2. In the variation 6 of the embodiment 2, each of the two LED modules 200N are also referred to as an LED module 200Na and 200Nb in order to distinguish the two LED modules 200N. In addition, the base mount 210n corresponding to each of the LED module 200Na and 200Nb is also referred to as a base mount 210na or 210nb.

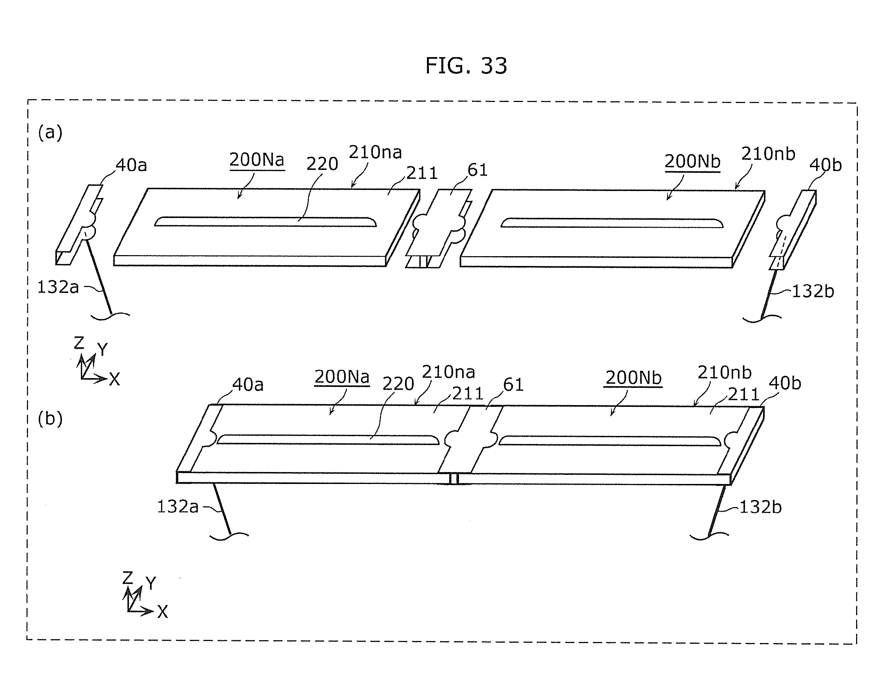

FIG. 33 is a diagram for describing the fixing structure according to the variation 6 of the embodiment 2.

(a) in FIG. 33 illustrates the LED modules 200Na and 200Nb before being fixed.

(b) in FIG. 33 illustrates the LED modules 200Na and 200Nb fixed.

In the following description, a light bulb shaped lamp having the fixing structure according to the variation 6 of the embodiment 2 may be referred to as a light bulb shaped lamp A26. The light bulb shaped lamp A26 is different from the light bulb shaped lamp A24 according to the variation 4 of the embodiment 2 illustrated in FIG. 31 in that the LED modules 200Na and 200Nb integrated by a connecting part 61 are included instead of the LED module 200N. The rest of the structure of the light bulb shaped lamp A26 is identical to the light bulb shaped lamp A24. Accordingly, the detailed description for the structure shall be omitted.

In this case, the light bulb shaped lamp A26 includes the base mounts 210na and 210nb integrated by the connecting part 61, as illustrated in (b) in FIG. 33. Stated differently, the light bulb shaped lamp A26 has more than one base mount.

The configuration of the LED modules 200Na and 200Nb are identical to the configuration of the LED module 200N.

Since the shape of the connecting part 61 has been described above, the description is omitted here.

The end portion fixing parts 40a and 40b are electrically connected to the lead wires 132a and 132b, respectively.

The structure using the connecting part 61 has been illustrated in the description for (b) in FIG. 17.

The group of light-emitting devices 300a formed on the base mount 210na and the group of light-emitting devices 300a formed on the base mount 210nb are electrically connected in series.

The end portion fixing part 40a is provided so as to clip the left end portion of the base mount 210na. The end portion fixing part 40b is provided so as to clip the right end portion of the base mount 210nb. Stated differently, the lead wires 132a and 132b connected to the end portion fixing parts 40a and 40b are fixed to the end portions of the two bases among the multiple bases so as to fix the multiple base mounts integrated by the connecting part 61. The multiple integrated base mounts here are the base mounts 210na and 210nb.

Stated differently, the lead wire is fixed to an end portion of the multiple base mounts so as to fix the base mounts integrated by the connecting part.

Accordingly, the end portion fixing part 40 for fixing the end portion is provided in each of at least two end portions of the base mounts integrated. Each of the two lead wires 132 is connected to one of the two end portion fixing parts 40.

Accordingly, the shape of the main surface 211 of the base mount 210n is quadrilateral. Furthermore, each of the end portion fixing parts 40 as the end portion clipping part clips a part corresponding to a side of a quadrilateral in a different base mount.

More specifically, the end portion fixing part 40 as the end portion clipping part clipping a different end portion of the multiple base mounts integrated are formed at the end portion of the lead wire 132a or 132b. The end portion fixing part 40 as the end portion clipping part clipping the end portion of at least one of the multiple base mounts integrated is formed at the end of the lead wire 132.

Accordingly, the multiple base mounts integrated are supported by at least two lead wires.

Each of the end portions of at least two of the multiple base mounts integrated is supported by one of the two lead wires. Each of the end portions of at least one of the multiple base mounts integrated is supported by one of the two lead wires. Accordingly, at least one of the multiple base mounts integrated is supported by the end portion fixing part 40 in the lead wire clipping the base mount.

The lead wires 132a and 132b are electrically connected to the group of light-emitting devices 300a such that the DC power from the lighting circuit 180 can be supplied to the groups of light-emitting devices 300a corresponding to the base mounts 210na and 210nb through the end portion fixing parts 40a and 40b.

With the configuration described above, the multiple base mounts 210n integrated are supported by the lead wires 132 each having the end portion fixing part 40 clipping the end portion of the multiple base mounts 210n integrated. Accordingly, the multiple base mounts 210n integrated are supported by the end portion fixing part 40 in the lead wire clipping the base mount. With this structure, the base mount 210n can be fixed firmly.

### Variation 7 of Embodiment 2

The fixing structure for three LED modules 200N shall be described in the variation 7 of the embodiment 2.

In the following description, an end portion of the base mount 210n orthogonal to the longer direction of a sealing part 220 formed on the base mount 210 of the LED module 200N is also referred to as an end portion to be connected. Accordingly, the base mount 210n has two ends to be connected.

In the variation 7 of the embodiment 2, each of the three LED modules 200N are also referred to as an LED module 200Na, 200Nb, and 200Nc in order to distinguish the three LED modules 200N. Each of the base mounts corresponding to the LED modules 200Na, 200Nb, and 200Nc are also referred to as the base mount 210na, 210nb, and 210nc, respectively.

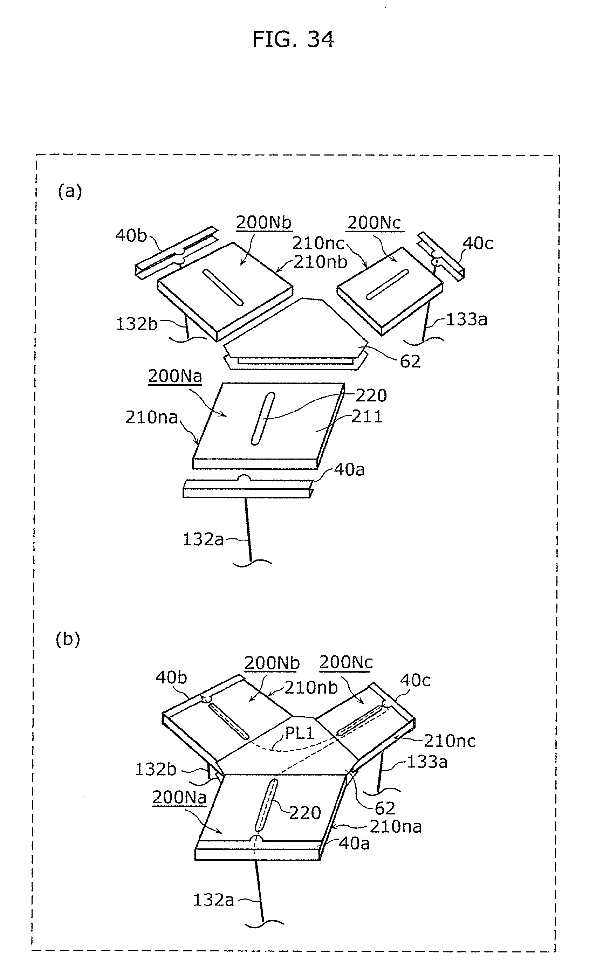

FIG. 34 is a diagram for describing the fixing structure according to the variation 7 of the embodiment 2.

(a) in FIG. 34 illustrates the LED modules 200Na, 200Nb, and 200Nc before being fixed.

(b) in FIG. 34 illustrates the LED modules 200Na, 200Nb, and 200Nc fixed.

In the following description, a light bulb shaped lamp according to the variation 7 of the embodiment 2 may be referred to as a light bulb shaped lamp A27. The light bulb shaped lamp A27 is different from the light bulb shaped lamp A24 according to the variation 4 of the embodiment 2 illustrated in FIG. 31 in that the LED modules 200Na, 200Nb, and 200Nc integrated by a connecting part 62 are included instead of the LED module 200N, and a fixing wire 133a and an end portion fixing part 40c are further included. The rest of the structure of the light bulb shaped lamp A27 is identical to the light bulb shaped lamp A24. Accordingly, the detailed description for the structure shall be omitted.

In this case, the light bulb shaped lamp A27 includes the base mount 210na, 210nb, and 210nc integrated by the connecting part 62, as illustrated in (b) in FIG. 34. Stated differently, the light bulb shaped lamp A27 has more than one base mount.

Since the LED modules 200Na, 200Nb, and 200Nc have been described above, the detailed description of these elements are not repeated.

The structure of the connecting part 62 and the structure using the connecting part 62 have been illustrated in the description for FIG. 18.

An end portion of the fixing wire 133a is fixed by the fixing part 120, in the same manner as the lead wires 130a and 130b illustrated in FIG. 23. Note that, the fixing wire 133a is metal wires not used for supplying power. The material composing the fixing wire 133a is identical to the fixing wire 131 described above. The shape of the fixing wire 133a is identical to the shape of the lead wire 132.

The bottom part of the end portion fixing part 40c is connected to the tip of the lead wire 133a by welding using laser, for example. More specifically, the end portion fixing part 40c is electrically connected to the fixing wire 133a.

The end portion fixing parts 40a and 40b are electrically connected to the lead wires 132a and 132b, respectively.

Since the structure of the end portion fixing parts 40a, 40b, and 40c are described using FIG. 18, the detailed description of these elements are not repeated.

As described above, the end portion fixing parts 40a, 40b, and 40c are connected to the lead wires 132a, 132b, and 132c, respectively.

The lead wires 132a, 132b, and the fixing wire 133a are fixed to the end portions of the multiple base mounts such that the base mounts 210na, 210nb, and 210nc integrated by the connecting part 62 are fixed. Stated differently, the lead wires 132a, 132b, and the fixing wire 133a are connected to the end portions of the base mount 210na, 210nb, and 210nc, respectively.

Stated differently, the lead wire is fixed to an end portion of the multiple base mounts so as to fix the base mounts integrated by the connecting part.

Accordingly, the end portion fixing part for fixing the end portion is provided in each of end portions of the three base mounts integrated. At least two lead wires are connected to two of the three end portion fixing parts.

Here, the shape of each of the main surfaces 211 of the multiple base mounts 210n is quadrilateral. Furthermore, each of the end portion fixing parts 40 as the end portion clipping part clips a part corresponding to a side of a quadrilateral in a different base mount.

More specifically, the end portion fixing part 40 as the end portion clipping part clipping a different end portion of the multiple base mount integrated is formed at the end portion of the lead wire 132a or 132b. The end portion fixing part 40 as the end portion clipping part clipping the end portion of at least one of the multiple base mounts integrated is formed at the end of the lead wire 132.

Accordingly, the multiple base mounts integrated are supported by at least two lead wires.

The lead wires 132a and 132b are electrically connected to the group of light-emitting devices 300a such that the DC power from the lighting circuit 180 can be supplied to the groups of light-emitting devices 300a corresponding to the base mount 210na, 210nb, and 210nc through the end portion fixing parts 40a and 40b. With this, the three groups of light-emitting devices 300a emit light by the flow of current through the current path PL1 in (b) in FIG. 34.

With the configuration described above, the multiple base mounts 210n integrated is supported by the lead wires 132 and the fixing wire 133a each having the end portion fixing part 40 clipping the end portion of the multiple base mounts 210n integrated. With this structure, the base mount 210n can be fixed firmly.

Note that, the fixing wire 133a may be a wire for supplying power to the group of light-emitting devices 300a in the same manner as the lead wire 132.

### Variation 8 of Embodiment 2

The fixing structure for four LED modules 200N shall be described in the variation 8 of the embodiment 2.

In the variation 8 of the embodiment 2, each of the four LED modules 200N are also referred to as an LED module 200Na, 200Nb, 200Nc, and 200Nd in order to distinguish the four LED modules 200N. The base mounts corresponding to the LED modules 200Na, 200Nb, 200Nc, and 200Nd are also referred to as the base mount 210na, 210nb, 210nc, and 210nd, respectively.

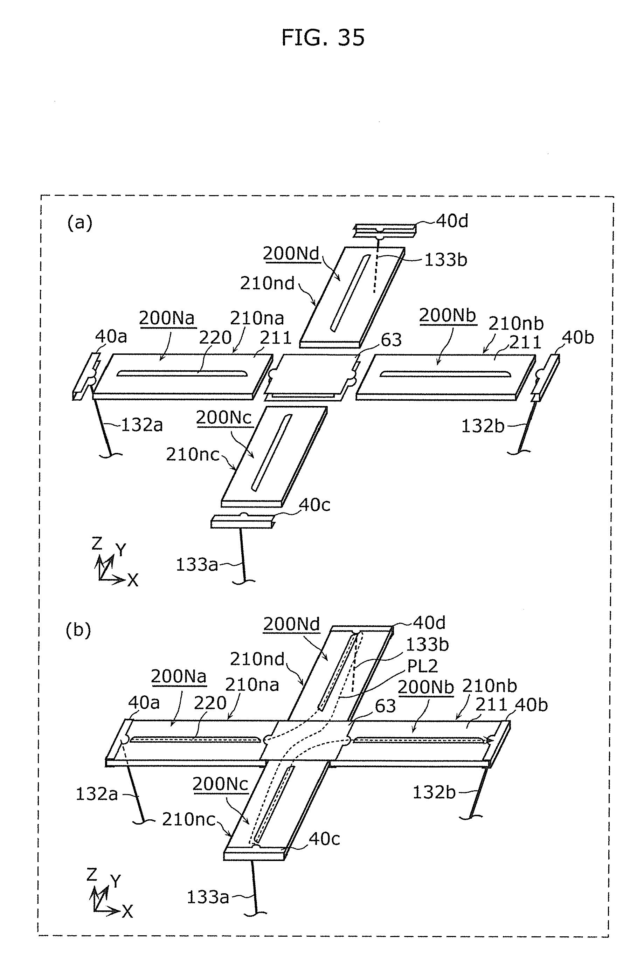

FIG. 35 is a diagram for describing the fixing structure according to the variation 8 of the embodiment 2.

(a) in FIG. 35 illustrates the LED modules 200Na, 200Nb, 200Nc, and 200Nd before being fixed. Note that, in the fixing structure according to the variation 8 of the embodiment 2, the fixing wires 133a and 133b are additionally used.

(b) in FIG. 35 illustrates the LED modules 200Na, 200Nb, 200Nc, and 200Nd fixed.

In the following description, a light bulb shaped lamp according to the variation 8 of the embodiment 2 may be referred to as a light bulb shaped lamp A28. The light bulb shaped lamp A28 is different from the light bulb shaped lamp A24 according to the variation 4 of the embodiment 2 illustrated in FIG. 31 in that the LED modules 200Na, 200Nb, 200Nc, and 200Nd integrated by a connecting part 63 are included instead of the LED module 200N, and fixing wires 133a and 133b and end portion fixing parts 40c and 40d are further included. The rest of the structure of the light bulb shaped lamp A28 is identical to the light bulb shaped lamp A24. Accordingly, the detailed description for the structure shall not be repeated.

In this case, the light bulb shaped lamp A28 includes the base mount 210na, 210nb, 210nc, and 210nd integrated by the connecting part 63, as illustrated in (b) in FIG. 35. Stated differently, the light bulb shaped lamp A28 has more than one base mount.

Since the LED modules 200Na, 200Nb, 200Nc, and 200Nd have been described above, the detailed description for these elements are not repeated.

The structure of the connecting part 63 and the structure using the connecting part 63 have been illustrated in the description for FIG. 19.

An end portion of one of the fixing wires 133a and 133b is fixed by the fixing part 120, in the same manner as the lead wires 130a and 130b illustrated in FIG. 23. Note that, the fixing wires 133a and 133b are metal wires not used for supplying power. The metal wires contain copper, for example.

The shape of the fixing wires 133a and 133b is identical to the shape of the lead wire 132.

In the following description, each of the fixing wires 133a and 133b may be simply referred to as the fixing wire 133.

More specifically, the end portion fixing part 40c is electrically connected to the fixing wire 133a.

The shape and the structure of the end portion fixing part 40d are identical to that of the end portion fixing part 40a. The bottom part of the end portion fixing part 40d is connected to the tip of the lead wire 133b by welding using laser, for example. More specifically, the end portion fixing part 40d is electrically connected to the fixing wire 133b.

The integrated structure using the connecting part 63 has been illustrated using FIG. 19. Accordingly, the detailed description for the integrated structure is not repeated.

As described above, the end portion fixing parts 40a, 40b, 40c, and 40d are connected to the lead wires 132a and 132b, and the fixing wires 133a and 133b, respectively.

The lead wires 132a, 132b, and the fixing wires 133a and 133b are fixed to the end portions of the multiple base mounts such that the base mounts 210na, 210nb, 210nc, and 210nd integrated by the connecting part 63 are fixed, respectively. Stated differently, the lead wires 132a and 132b, and the fixing wires 133a and 133b are connected to the end portions of the base mount 210na, 210nb, 210nc, and 210nd, respectively.

Stated differently, the lead wire is fixed to an end portion of the multiple base mounts so as to fix the base mounts integrated by the connecting part.

Accordingly, the end portion fixing part for fixing the end portion is provided in each of end portions of the four base mounts integrated. Each of at least two lead wires is connected to two of the four end portion fixing parts.

Here, the shape of each of the main surfaces 211 of the multiple base mounts 210n is quadrilateral. Furthermore, each of the end portion fixing parts 40 as the end portion clipping part clips a part corresponding to a side of a quadrilateral in a different base mount.

More specifically, the end portion fixing part 40 as the end portion clipping part clipping a different end portion of the multiple base mount integrated is formed at the end portion of the lead wire 132a or 132b. The end portion fixing part 40 as the end portion clipping part clipping the end portion of at least one of the multiple base mounts integrated is formed at the end of the lead wire 132.

Accordingly, the multiple base mounts integrated are supported by at least two lead wires. Accordingly, at least one of the multiple bases integrated is supported by the end portion fixing parts 40 in one of the at least two lead wires clipping the base.

The lead wires 132a and 132b are electrically connected to the group of light-emitting devices 300a such that the DC power from the lighting circuit 180 can be supplied to the groups of light-emitting devices 300a corresponding to the base mount 210na, 210nb, 210nc, and 210nd through the end portion fixing parts 40a and 40b. With this, the four groups of light-emitting devices 300a emits light by the flow of current through the current path PL2 in (b) in FIG. 35.

With the configuration described above, the multiple base mounts 210n integrated is supported by the lead wires 132 and the fixing wires 133 each having the end portion fixing part 40 at the end clipping the end portion of the multiple base mounts 210n integrated. With this structure, the base mount 210n can be fixed firmly.

Note that, the structure for fixing the multiple base mounts integrated is not limited to the structures illustrated in the variations 6 to 8 in the embodiment 2. For example, as illustrated in FIG. 29, the multiple base mounts integrated may be fixed by the lead wires or the fixing wires each having the bent part 18. In this structure, the end portion fixing part for fixing the multiple base mounts integrated is not necessary.

Note that, in the fixing structures according to the variations 6 to 8 in the embodiment 2, the connecting parts (the connecting parts 61, 62, and 63) for integrating the multiple base mounts 210 may be fixed by the rod part 120a of the fixing part 120, in the same manner as the structure illustrated in FIG. 28. With this structure, the multiple base mounts 210n integrated can be fixed very firmly.

### Variation 9 of Embodiment 2

In the variation 9 of the embodiment 2, the fixing structure for an LED module 200C having a base mount in a shape different from the embodiments described above shall be described.

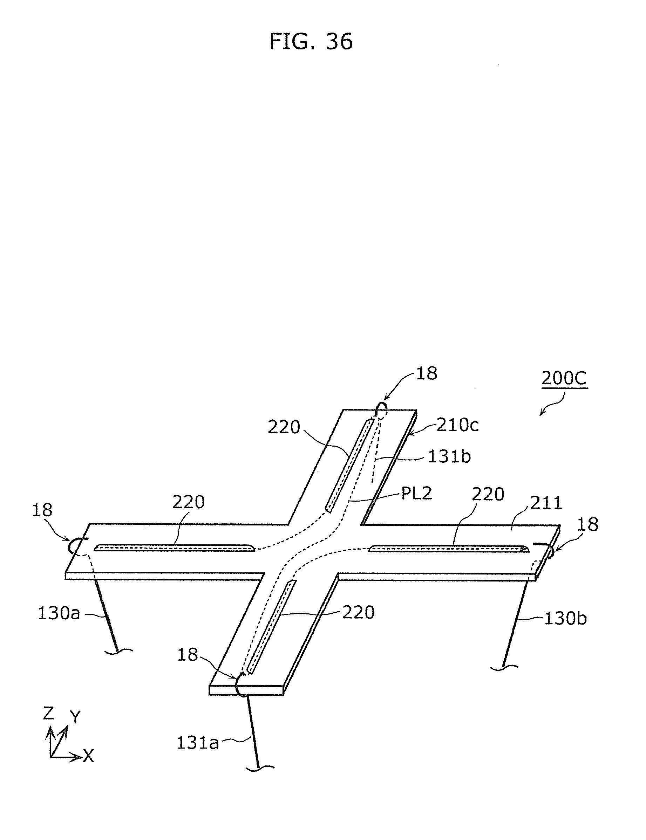

FIG. 36 is a diagram for describing the fixing structure according to the variation 9 of the embodiment 2.

In the following description, a light bulb shaped lamp having the fixing structure according to the variation 2 of the embodiment 9 may be referred to as a light bulb shaped lamp A29. The light bulb shaped lamp A29 is different from the light bulb shaped lamp A22 according to the variation 2 of the embodiment 2 illustrated in FIG. 29 in that the LED module 200C is included instead of the LED module 200N. The rest of the structure of the light bulb shaped lamp A29 is identical to the light bulb shaped lamp A22. Accordingly, the detailed description for the structure shall be omitted.

The configuration of the LED module 200C illustrated in FIG. 36 is as described in the description for FIG. 21.

The LED module 200C is fixed by the lead wires 130a and 130b, and the fixing wires 131a and 131b.

In the same manner as the fixing structure according to the variation 2 of the embodiment 2 described in the description for FIG. 29, the LED module 200C is fixed by the lead wires 130a and 130b and the fixing wires 131a and 131b. Stated differently, each of the end portions of the base mount 210c in the LED module 200C are fixed by the lead wires 130 or the fixing wires 131 clipping the end portion.

Since the structure and function of the lead wires 130a and 130b and the fixing wires 131a and 131b are described referring to FIG. 29, the detailed description is not repeated.

With the structure described above, in the configuration according to the variation 9 of the embodiment 2, the base mount 210c having a cross-shape is supported by the lead wires 130a and 130b, and the fixing wires 131a and 131b each having the bent part 18 at the end portion at four parts of the base mount 210c. With this configuration, even if the base mount is cross-shaped, the LED module 200C (the base mount 210c) can be fixed firmly.

Note that, the LED module 200C may be fixed by the rod part 120a of the fixing part 120 at the center part on the back surface of the base mount 210c, as illustrated in the fixing structure according to the variation 1 of the embodiment 2 (FIG. 28).

### Variation 10 of Embodiment 2

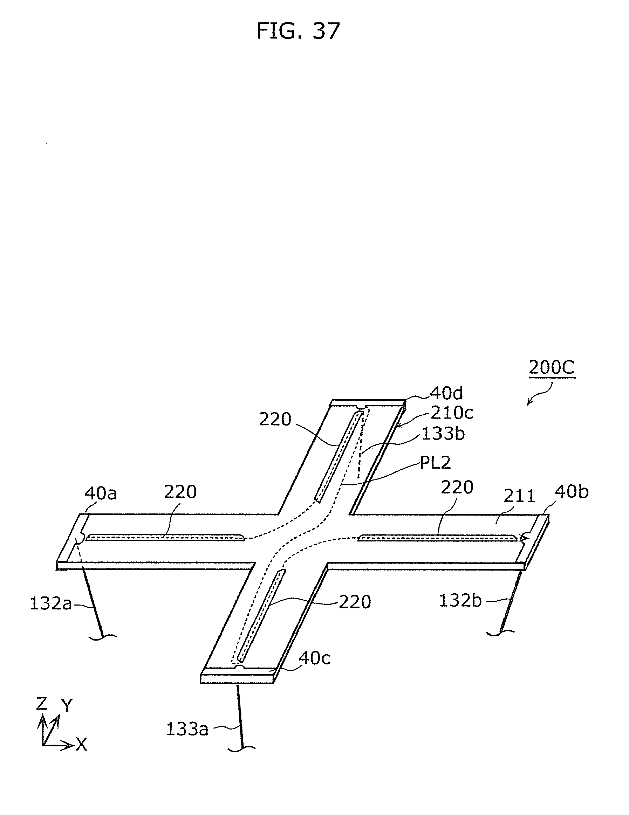

FIG. 37 is a diagram for describing the fixing structure according to the variation 10 of the embodiment 2. The fixing structure for the LED module 200C shall be described in the variation 10 of the embodiment 2.

In the following description, a light bulb shaped lamp according to the variation 10 of the embodiment 2 may be referred to as a light bulb shaped lamp A210. The light bulb shaped lamp A210 is different from the light bulb shaped lamp A28 according to the variation 8 of the embodiment 2 illustrated in FIG. 35 in that the LED module 200C is included instead of the four LED modules 200N. The rest of the structure of the light bulb shaped lamp A210 is identical to the light bulb shaped lamp A28. Accordingly, the detailed description for the structure shall be omitted.

As shown in FIG. 37, the LED module 200C is fixed by the fixing structure as illustrated in FIG. 35 described in the variation 8 of the embodiment 2. Stated differently, the LED module 200C is fixed by the end portion fixing parts 40a, 40b, 40c, and 40d, the lead wires 132a and 132b and the fixing wires 133a and 133b, in the same manner as the integrated base mount in FIG. 35.

With the structure described above, in the structure according to the variation 10 of the embodiment 2, the cross-shaped base mount 210c is supported at the four parts by the lead wires 132a and 132b and the fixing wires 133a and 133b each having the end portion at which the end portion fixing part 40is formed. With this configuration, even if the base mount is cross-shaped, the LED module 200C (the base mount 210c) is fixed firmly.

Note that, the LED module 200C may be fixed by the rod part 120a of the fixing part 120 at the center part on the back surface of the base mount 210c, as illustrated in the fixing structure according to the variation 1 of the embodiment 2 (FIG. 28).

### Embodiment 3

### (Overall structure of light bulb shaped lamp)

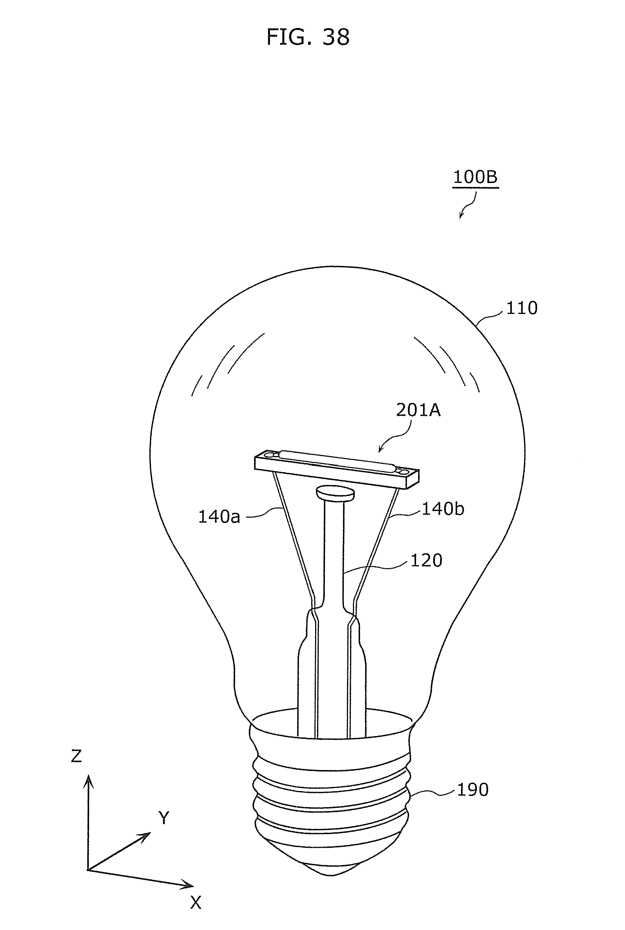

The overall structure of the lightbulb-shaped lamp 100B according to the embodiment 3 shall be described with reference to FIG. 38 to FIG. 40.

FIG. 38 is a front view of the lightbulb-shaped lamp according to the embodiment 3.

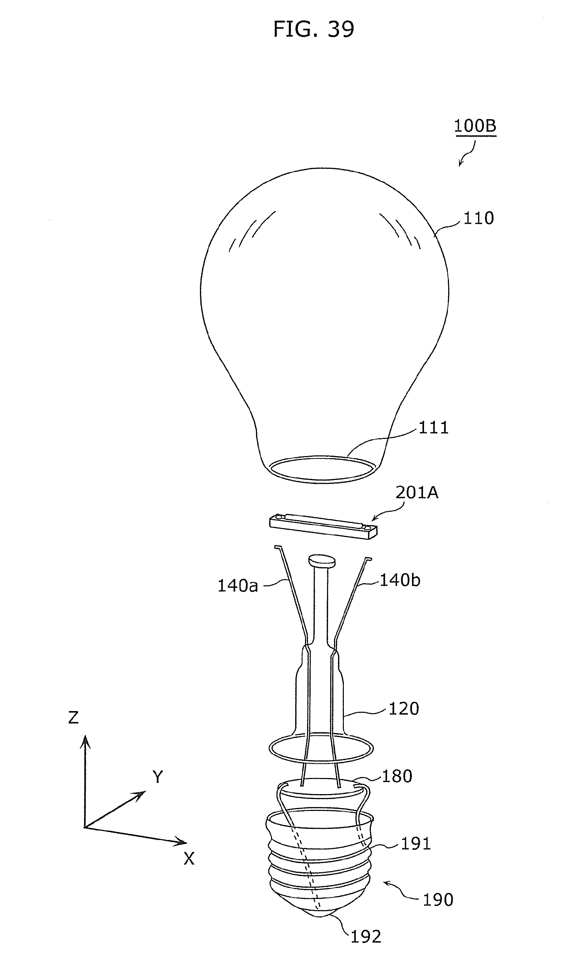

FIG. 39 is an exploded perspective view of the lightbulb-shaped lamp according to the embodiment 3.

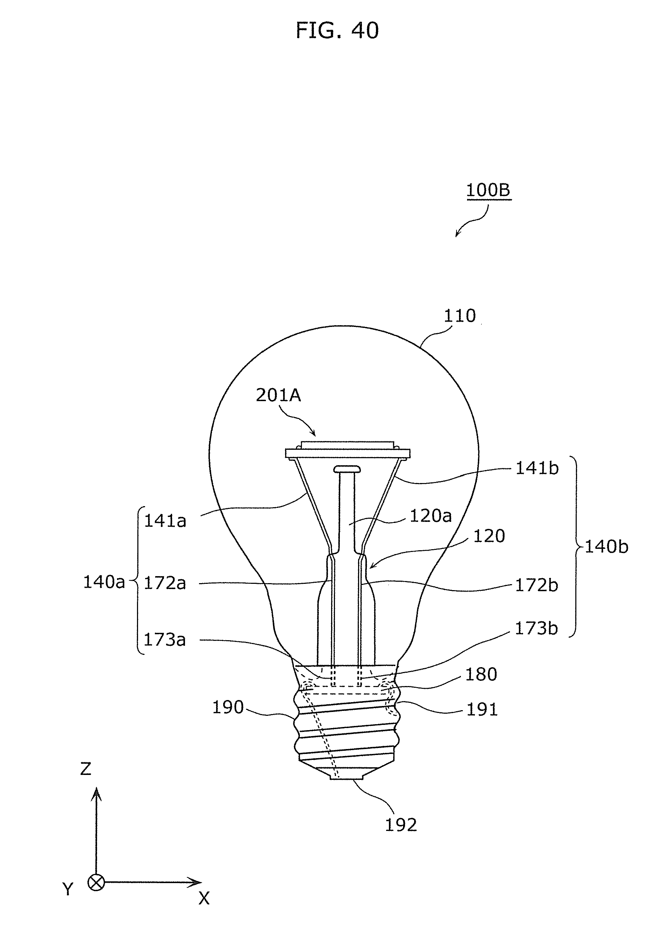

FIG. 40 is a perspective view of the lightbulb-shaped lamp according to the embodiment 3.

The lightbulb-shaped lamp 100B is different from the lightbulb-shaped lamp 100 in FIG. 1 in that lead wires 140a and 140b are provided instead of the lead wires 170a and 170b, and an LED module 201A instead of the LED module 200. The rest of the structure of the lightbulb-shaped lamp 100B is identical to the lightbulb-shaped lamp 100. Accordingly, the detailed description is not repeated.

The lead wires 140a and 140b have the same structure and function as the lead wires 170a and 170b. Accordingly, the detailed description for the lead wires 140a and 140b is omitted.

Note that, in FIG. 40, the lighting circuit 180 and part of lead wires 140a and 140b for power supply and for support which are positioned inside a base 190 are illustrated in dotted lines.

The LED module 201A is electrically connected to the lead wires 140a and 140b.

The lead wire 140a is a composite wire including an internal lead wire 141a, a Dumet wire 172a, and an external lead wire 173a joined in order. The lead wire 140b is a composite wire including an internal lead wire 141b, a Dumet wire 172b, and an external lead wire 173b joined in order.

In the following description, the lead wire 140a and 140b are simply referred to as the lead wire 140. Furthermore, in the following description, each of the internal lead wires 141a and 141b may be simply referred to as the internal lead wire 141.

The internal lead wire 141 is an electric wire extending from the fixing part 120 to the LED module 201A. The internal lead wire 141 is joined with the base mount 210a, and supports the LED module 201A (the base mount 210a). Stated differently, the base mount 210a to be described later is supported by the lead wires 140a and 140b.

In addition, two lead wires 140 do not have to be provided. For example, when the lightbulb-shaped lamp 100B includes a plurality of the LED modules 201A in the globe 110, two lead wires 140 may be provided for each of the LED modules 201A. Accordingly, the lightbulb-shaped lamp 100B may include the lead wires 140 twice in number as the number of the LED modules 201A.

Among the internal lead wire 141, the Dumet wire 172, and the external lead wire 173 composing the lead wire 140, the fixing part 120 seals the Dumet wire 172. To put it differently, the fixing part 120 fixes the lead wire 140 exposing a part of the lead wire 140 (the internal lead wire 141).

The globe 110 covers the LED module 201A, part of the lead wires 140a and 140b, a part of the fixing part 120, and others. The LED module 201A is positioned at a part around the center of the globe 110. The globe 110 is made of a translucent material, as described above.

With this, the lightbulb-shaped lamp 100B can reduce the loss of light emitted by the semiconductor light-emitting device 300 caused by the globe 110.

The light from the LED module 201A passes through the globe 110, and is emitted to outside.

Since the LED module 201A is positioned around the center of the globe 110, omnidirectional light distribution property is achieved when the LED module 201A emits light.

The lighting circuit 180 is electrically connected to the lead wires 140a and 140b.

### (The configuration of LED module)

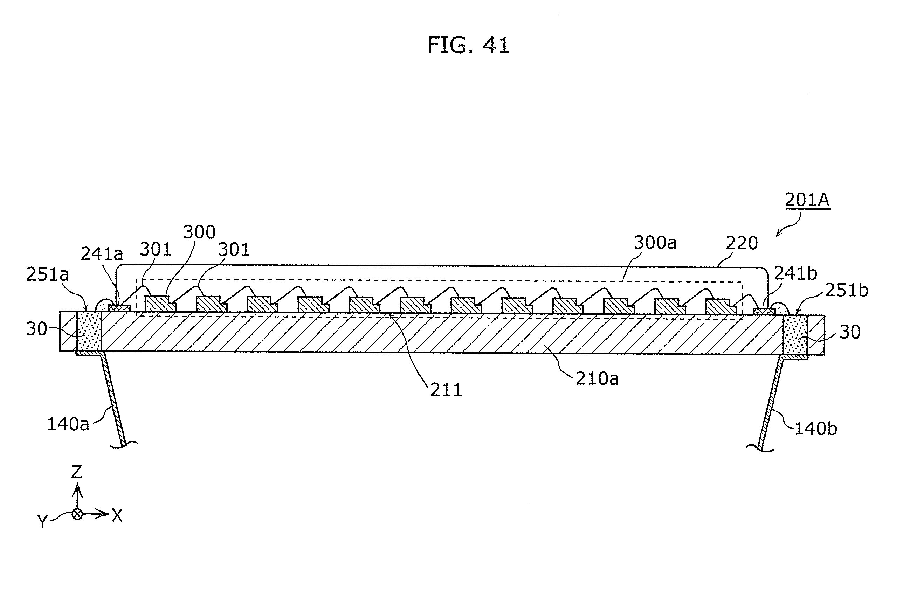

FIG. 41 is a cross-sectional view illustrating the configuration of the LED module 201A. Note that, the lead wires 140a and 140b not included in the LED module 201A are also illustrated in FIG. 41.

Note that, the details on the shape of the lead wires 140a and 140b shall be described later.

The LED module 201A is different from the LED module 200 illustrated in FIG. 4 in that a base mount 210a is included instead of the base mount 210. The rest of the configuration of the LED module 200A is identical to the LED module 200. Accordingly, the detailed description is not repeated.

The LED module 201A is housed in the globe 110, and is preferably positioned at the center of the sphere defined by the globe 110. With this structure, the light bulb shaped lamp 100B can achieve omnidirectional light distribution property when the light bulb shaped lamp 100 is switched on. The omnidirectional light distribution property is approximated to a common incandescent light bulb using conventional filament coil.

As shown in FIG. 41, the LED module 201A includes the base mount 210a, a plurality of semiconductor light-emitting devices 300, and a sealing part 220.

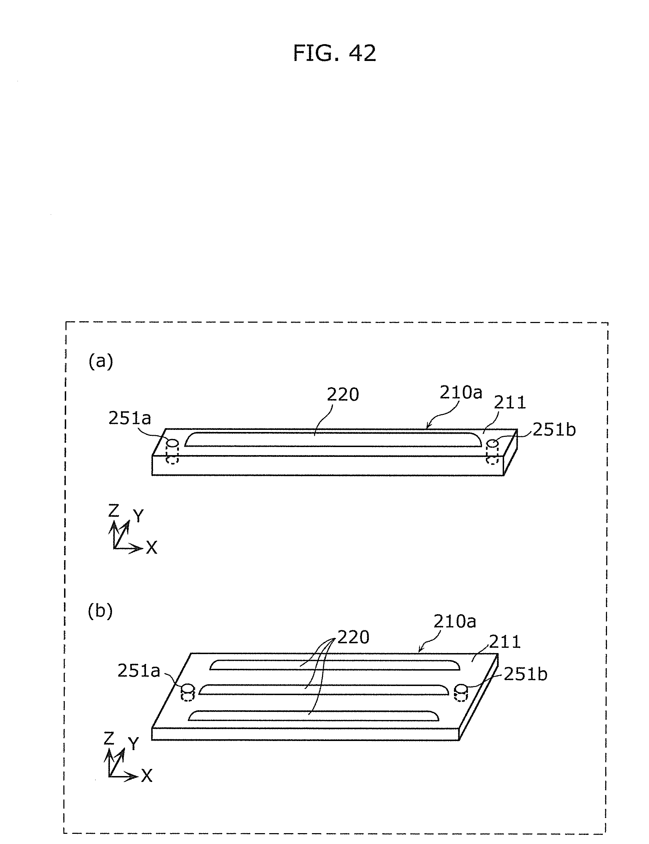

The shape of the base mount 210a is a quadrangular prism, as illustrated in (a) in FIG. 42.

Note that, the shape of the base mount 210a is not limited to the quadrangular prism, and may be other shape. The shape of the base mount 210a may be board-shaped, as illustrated in (b) in FIG. 42.

If the shape of the base mount 210a is a quadrangular prism, the LED module 201A in the lightbulb-shaped lamp 100B can imitate the filament of an incandescent lightbulb.

Each of the lead wires 140a and 140b is connected to the conductive component 30. Each of the conductive components 30 is connected to the power supply terminal 241a or the power supply terminal 241b by solder. Accordingly, the lead wires 140a and 140b are electrically connected to the power supply terminals 241a and 241, respectively. To put it differently, the lead wires 140a and 140b are fixed to the base mount 210a (the LED module 201A) by solder.

The base mount 210 has a main surface 211. The semiconductor light-emitting devices 300 are mounted in a straight line on the main surface 211. Stated differently, the semiconductor light-emitting devices 300 are mounted on the main surface 211 of the base mount 210a such that the semiconductor light-emitting devices 300 are arranged in a straight line between the power supply terminal 241a and the power supply terminal 241b.

The group of light-emitting devices 300a is formed of the semiconductor light-emitting devices 300 mounted on the main surface 211 on the base mount 210a in a straight line. The power is supplied to the semiconductor light-emitting devices 300 composing the group of light-emitting devices 300a from the lead wires 140a and 140b.

To put it differently, the lead wires 140a and 140b are electric wires for supplying power to the semiconductor light-emitting devices 300. More specifically, the lead wires 140a and 140b are electric wires for supplying power to the LED module 201A as the light-emitting module.

Note that, if the shape of the base mount 210a is a quadrangular prism, the semiconductor light-emitting devices 300 composing the group of light-emitting devices 300a may be formed on a side surface of the base mount 210a different from the main surface 211.

As illustrated in FIG. 41 and FIG. 42, holes 251a and 251b are provided on the ends of the base mount 210a in the longer direction (X-axis direction). Each of the holes 251a and 251b is a through hole passing through the base mount 210a. Stated differently, the base mount 210a has the holes 251a and 251b passing through the base mount 210a. Each of the holes 251a and 251b extends along the Z-axis direction.

In the following description, each of the holes 251a and 251b may be simply referred to as the hole 251 as well.

Note that, as illustrated in (b) in FIG. 42, if the base mount 210a is board-shaped, three sealing parts 220 for sealing the groups of light-emitting devices 300a are formed on the main surface 211, for example. Accordingly, three groups of light-emitting devices 300a are formed on the main surface 211 of the base mount 210a. In this case, the three groups of the light-emitting devices 300a are electrically connected in series.

The LED module 201A is fixed by the lead wires 140a and 140b such that the main surface 211 of the base mount 210a faces toward the top of the globe 110.

Since the base mount 210a is translucent, the white light emitted from the linear sealing part 220 transmits the inside of the base mount 210a and is emitted from the back surface and the side surfaces of the base mount 210a.

Note that, the sealing part 220 containing the wavelength conversion material may be provided on the back surface on which the semiconductor light-emitting devices 300 are not mounted in the base mount 210a.

The following shall describe the structure for fixing the LED module included in the light bulb shaped lamp in detail.

The fixing structure according to the embodiment 3 shall be described with reference to FIG. 41. The fixing structure for the LED module 201A shall be described in the embodiment 3.

As illustrated in FIG. 41, the conductive component 30 is filled in the holes 251a and 251b in the base mount 210a.

The conductive component 30 is, for example, metal such as stainless, cermet, or others. When the conductive component 30 is metal, each of the holes 251a and 251b is filled (press-fit) with the conductive component 30.

When the conductive component 30 is composed of cermet, each of the holes 251a and 251b is filled with the conductive component 30 by the thermal shrink-fit. Stated differently, the conductive component 30 in this case is made of cermet.

The conductive component 30 filled in the hole 251a is electrically connected to the wire bonding part 331 of the left-end semiconductor light-emitting device in the group of light-emitting devices 300a by a wire 301 which is not illustrated. The conductive component 30 filled in the hole 251b is electrically connected to the wire bonding part 332 of the right-end semiconductor light-emitting device in the group of light-emitting devices 300a by the wire 301.

As illustrated in FIG. 41, the end portions of the lead wires 140a and 140b are bent so as to form parts parallel to the second surface of the base mount 210a, and the parts of the end portions parallel to the second surface are welded to the conductive components 30 by laser, for example. Stated differently, the end portion of each of the lead wires 140 is angled so as to form a part parallel to the second surface of the base mount 210a, and a part of the end portion of each of the lead wires 140 is connected to the conductive component 30. The lead wire 140 is connected to the conductive component 30.

Stated differently, the lead wire 140 is electrically connected to the conductive component 30 from the side of the second surface opposite to the main surface 211 (the first surface) of the base mount 210a. Accordingly, the LED module 201A (the base mount 210a) is held (supported) by the lead wires 140a and 140b connected to the conductive component 30.

With this, the lead wire 140a is electrically connected to the left-end semiconductor light-emitting device in the group of light-emitting devices 300a through the conductive component 30. Furthermore, the lead wire 140b is electrically connected to the right-end semiconductor light-emitting device in the group of light-emitting devices 300a through the conductive component 30.

The lead wires 140a and 140b are electrically connected to the group of light-emitting devices 300a such that the DC power from the lighting circuit 180 can be supplied to the group of light-emitting group 300a.

With the configuration described above, the conductive component 30 filled in the hole 251 in the base mount 210a is firmly fixed to the base mount 210a. The base mount 210a on which the semiconductor light-emitting devices 300 are mounted is supported by the lead wire 140 connected to the conductive component 30 filled in the hole 251 in the base mount 210a. Accordingly, the base mount 210a is fixed firmly by the lead wires 140a and 140b. Accordingly, the base mount on which the semiconductor light-emitting device is mounted is fixed firmly.

The base mount 210a on which the semiconductor light-emitting device 300 is mounted is supported by the lead wires 140. With this, it is possible to suppress the large part of the light emitted by the semiconductor light-emitting device 300 mounted on the base mount 210a.

Furthermore, the base mount 210a is translucent. With this, it is possible to prevent the large part of the light emitted by the semiconductor light-emitting device 300 from being blocked. Accordingly, a sufficient light distribution angle can be achieved.

### Variation 1 of Embodiment 3

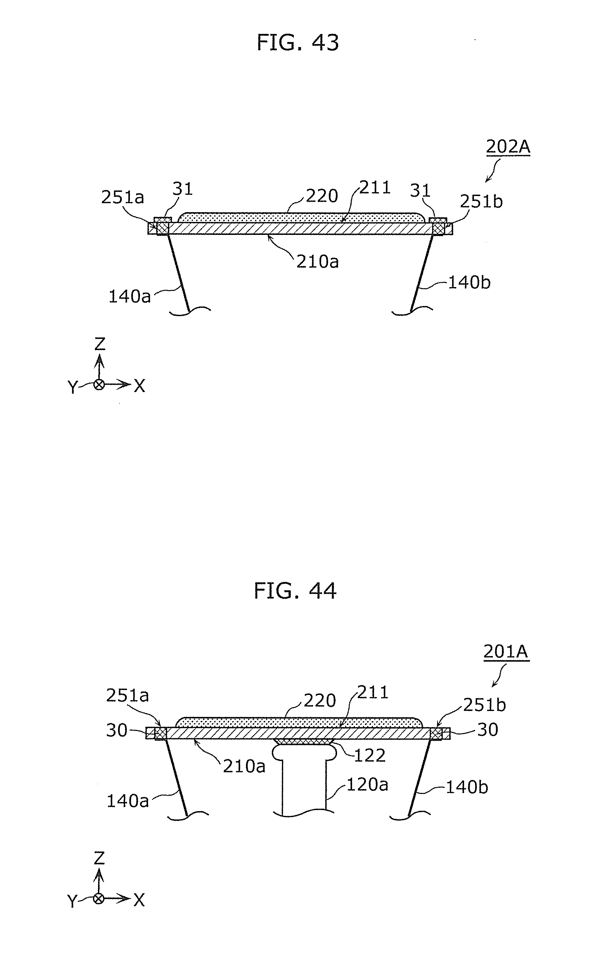

FIG. 43 is a cross-sectional view for describing the fixing structure according to the variation 1 of the embodiment 3. The fixing structure for the LED module 202A shall be described in the variation 1 of the embodiment 3.

In the following description, a lightbulb-shaped lamp having the fixing structure according to the variation 1 of the embodiment 3 may be referred to as a lightbulb-shaped lamp A31. The lightbulb-shaped lamp A31 is different from the lightbulb-shaped lamp 100B in that an LED module 202A is included instead of the LED module 201A. The rest of the structure of the lightbulb-shaped lamp A31 is identical to the lightbulb-shaped lamp 100B. Accordingly, the description for the structure shall be omitted.

As illustrated in FIG. 43, the LED module 202A is different from the LED module 200 in FIG. 41 in that a conductive component 31 is embedded instead of the conductive component 30 in the holes 251a and 251b in the base mount 210. Stated differently, the holes 251a and 251b are filled with the conductive components 31.

The rest of the configuration of the LED module 202A is identical to the LED module 201A. Accordingly, the detailed description is not repeated.

The conductive component 31 is a rivet. Note that, the conductive component 31 is not limited to a rivet, and may be any conductive component that can be embedded in the hole. The conductive component 31 may be a screw, for example.

The conductive component 31 filled in the hole 251a is electrically connected to the wire bonding part 331 of the left-end semiconductor light-emitting device in the group of light-emitting devices 300a by a wire 301 and others which are not illustrated. The conductive component 31 filled in the hole 251b is electrically connected to the wire bonding part 332 of the right-end semiconductor light-emitting device in the group of light-emitting devices 300a by the wire 301 and others which are not illustrated.

As illustrated in FIG. 43, the end portions of the lead wires 140a and 140b are bent so as to form the parts parallel to the second surface of the base mount 210a, and the parts of the end portions parallel to the second surface are welded to the conductive components 31 by laser, for example. Stated differently, the end portion of each of the lead wires 140 is angled so as to form a part parallel to the second surface of the base mount 210a, and the part of the end portion of each of the lead wires 140 parallel to the second surface is connected to the conductive component 31. The lead wire 140 is connected to the conductive component 31.

Stated differently, the lead wire 140 is electrically connected to the conductive component 31 from the side of the second surface opposite to the main surface 211 (the first surface) of the base mount 210a. Accordingly, the LED module 202A (the base mount 210a) is held (supported) by the lead wires 140a and 140b connected to the conductive component 31.

With this, the lead wire 140a is electrically connected to the left-end semiconductor light-emitting device in the group of light-emitting devices 300a through the conductive component 31. Furthermore, the lead wire 140b is electrically connected to the right-end semiconductor light-emitting device in the group of light-emitting devices 300a through the conductive component 31.

The lead wires 140a and 140b are electrically connected to the group of light-emitting devices 300a such that the DC power from the lighting circuit 180 can be supplied to the group of light-emitting group 300a.

With the configuration described above, the conductive component 31 filled in the hole 251 in the base mount 210a is firmly fixed to the base mount 210a. The base mount 210a on which the semiconductor light-emitting devices 300 are mounted is supported by the lead wire 140 connected to the conductive component 31 filled in the hole 251 in the base mount 210a. Accordingly, the base mount 210a is fixed firmly by the lead wires 140a and 140b. Accordingly, the base mount on which the semiconductor light-emitting device is mounted is fixed firmly.

### Variation 2 of Embodiment 3

FIG. 44 is a cross-sectional view for describing the fixing structure according to the variation 2 of the embodiment 3. The fixing structure for the LED module 201A shall be described in the variation 2 of the embodiment 3.

The variation 2 of the embodiment 3 is different from the structure in the Embodiment 3 illustrated in FIG. 41 in that the base mount 210a is fixed by a rod part 120a of the fixing part 120 as the stem as well. The structure other than the structure for fixing the base mount 210a is identical to the embodiment 3. Accordingly, the detailed description for the structure shall not be repeated.

As described above, the fixing part 120 as the stem is provided on a side (the second surface) opposite to the main surface 211 of the base mount 210a.

The shape of the fixing part 120 in the variation 2 of the embodiment 3 is described as the rod part 120a of the fixing part 120 extending to the vicinity of the surface opposite to the main surface 211 of the base mount 210a.

The surface (the second surface) opposite to the main surface 211 of the base mount 210a is fixed to the tip of the rod part 120a of the fixing part 120 by adhesive 122. The surface (the second surface) opposite to the main surface 211 of the base mount 210a is fixed to the tip of the rod part 120a of the fixing part 120. Stated differently, the base mount 210a is also supported by the rod part 120a.

With the structure described above, according to the structure in the variation 2 of the embodiment 3, the base mount 210a is supported by the rod part 120a more firmly than the fixing structure according to the embodiment 3. Accordingly, the base mount 210a (the LED module 201A) is fixed even more firmly than the fixing structure in the embodiment 3.

Note that, the fixing structure according to the variation 2 of the embodiment 3 may be applied to the fixing structure according to the variation 1 of the embodiment 3 illustrated in FIG. 43. More specifically, the base mount 210a in the LED module 202A may be fixed by the rod part 120a of the fixing part 120.

In addition, the shape of the fixing part 120 may allow the tip of the rod part 120a of the fixing part 120 to contact the surface opposite to the main surface 211 of the base mount 210a. In this case, the adhesive 122 may not be necessary.

In the following description, a lightbulb-shaped lamp having the fixing structure according to the variation 2 of the embodiment 3 may be referred to as a lightbulb-shaped lamp A32.

### Variation 3 of Embodiment 3

In the variation 3 of the embodiment 3, the fixing structure for an LED module 200D having a base mount in a shape different from the embodiments described above shall be described.

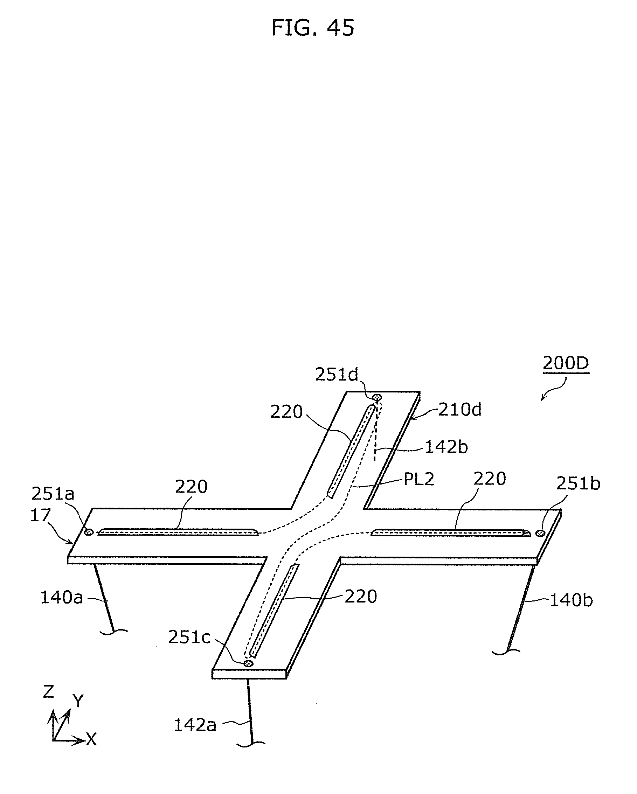

FIG. 45 is a diagram for describing the fixing structure according to the variation 3 of the embodiment 3.

In the following description, a lightbulb-shaped lamp having the fixing structure according to the variation 3 of the embodiment 3 may be referred to as a lightbulb-shaped lamp A33. The lightbulb-shaped lamp A33 is different from the lightbulb-shaped lamp 100B according to the embodiment 3 illustrated in FIG. 41 in that the LED module 200D is included instead of the LED module 201A, and fixing wires 142a and 142b are further included. The rest of the structure of the lightbulb-shaped lamp A33 is identical to the lightbulb-shaped lamp 100B. Accordingly, the description for the structure shall be omitted.

As illustrated in FIG. 45, the LED module 200D includes the base mount 210d, four groups of light-emitting devices 300a that are not illustrated, and four sealing parts 220.

The base mount 210d is different from the base mount 210b in FIG. 20 in that holes 251a, 251b, 251c, and 251d are provided instead of the holes 250a, 250b, 250c, and 250d. The rest of the configuration of the base mount 210d is identical to the base mount 210b, and the detailed description is not repeated. The holes 251a, 251b, 251c, and 251d are filled with the conductive component 30, as illustrated in FIG. 41.

In the following description, each of the holes 251a, 251b, 251c, and 251d may be simply referred to as the hole 251 as well. Each of the holes 251 in FIG. 45 has the same shape as the holes 251 illustrated in FIG. 41 and others.

The four groups of light-emitting devices 300a that are not illustrated are formed on the base mount 210d. Each of the groups of light-emitting devices 300a includes a plurality of semiconductor light-emitting devices 300 mounted on the main surface 211 of the base mount 210d, as illustrated in FIG. 41. The four groups of light-emitting devices 300a are sealed by the four sealing parts 220, respectively.

Note that, the four groups of light-emitting devices 300a formed on the base mount 210d are electrically connected in series such that the current flows through the current path PL2, for example.

The LED module 200D is fixed by the lead wires 140a and 140b, and the fixing wires 142a and 142b.

Since the configuration and function of the lead wires 140a and 140b are described referring to FIG. 41, the detailed description is not repeated. In the same manner as FIG. 41, the lead wire 140a is connected to the conductive component 30 filled in the hole 251a.

In the same manner as FIG. 41, the lead wire 140b is connected to the conductive component 30 filled in the hole 251b. Stated differently, the part of the end portion of each of the lead wires 140 parallel to the second surface is connected to the conductive component 30.

One end portion of each of the fixing wires 142a and 142b is fixed by the fixing part 120, in the same manner as the lead wires 140a and 140b illustrated in FIG. 38. Note that, the fixing wires 142a and 142b are metal wires not used for supplying power. The metal wires contain copper, for example. Accordingly, the shape of the fixing wires 142a and 142b are identical to the lead wire 140 in FIG. 41.

Each of the fixing wires 142a and 142b may be simply referred to as the fixing wire 142 in the following description.

The fixing wire 142a is connected to the conductive component 30 filled in the hole 251c, in the same manner as the lead wire 140 illustrated in FIG. 41. The fixing wire 142b is connected to the conductive component 30 filled in the hole 251d, in the same manner as the lead wire 140 illustrated in FIG. 41. Stated differently, the part of the end portion of each of the fixing wires 142 parallel to the second surface of the base 210d is connected to the conductive component 30.

With the structure described above, in the structure according to the variation 3 of the embodiment 3, the cross-shaped base mount 210d is supported at the four parts by the lead wires 140a and 140b and the fixing wires 142a and 142b each having the end portion connected to the conductive component 30. With this configuration, even if the base mount is cross-shaped, the LED module 200D (the base mount 210d) can be fixed firmly.

Note that, the LED module 200D may be fixed by the rod part 120a of the fixing part 120 at the center part on the back surface of the base mount 210d, as illustrated in the fixing structure according to the variation 2 of the embodiment 3 (FIG. 44).

Note that, the fixing wires 142a and 142b may be wires for supplying power to the group of light-emitting devices 300a in the same manner as the lead wires 140a and 140b. In this case, the fixing wires 142a and 142b are electrically connected to the lighting circuit 180 such that the DC power from the lighting circuit 180 can be transmitted therethrough. Furthermore, in this case, the fixing wires 142a and 142b and the lead wires 140b and 140b are electrically connected to the group of the light-emitting devices 300a such that the power can be supplied to the group of light-emitting devices 300a.

Note that, although the holes 251 are filled with the conductive component 30, it is not limited to this example, and the holes 251 may be filled with the conductive component 31, in the same manner as the structure illustrated in FIG. 43.

### Embodiment 4

### (Overall structure of light bulb shaped lamp)

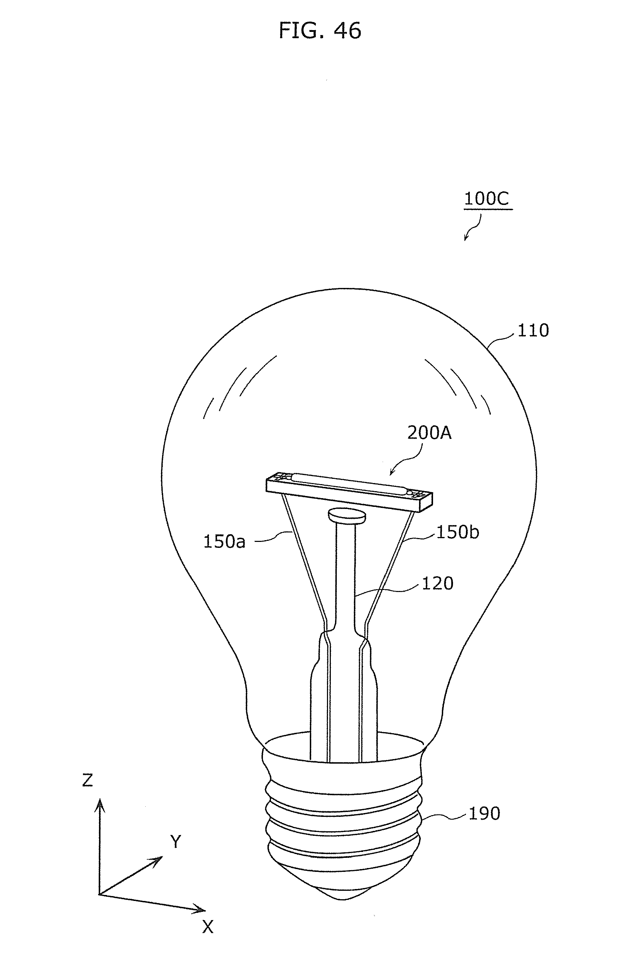

The overall structure of the lightbulb-shaped lamp 100C according to the embodiment 4 shall be described with reference to FIG. 46 to FIG. 48.

FIG. 46 is a perspective view of the lightbulb-shaped lamp according to the embodiment 4.

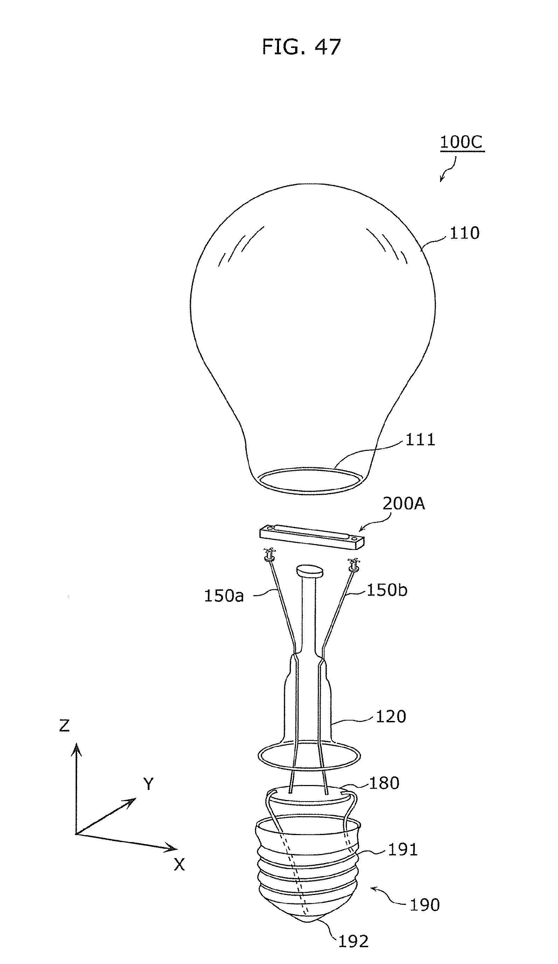

FIG. 47 is an exploded perspective view of the lightbulb-shaped lamp according to the embodiment 4.

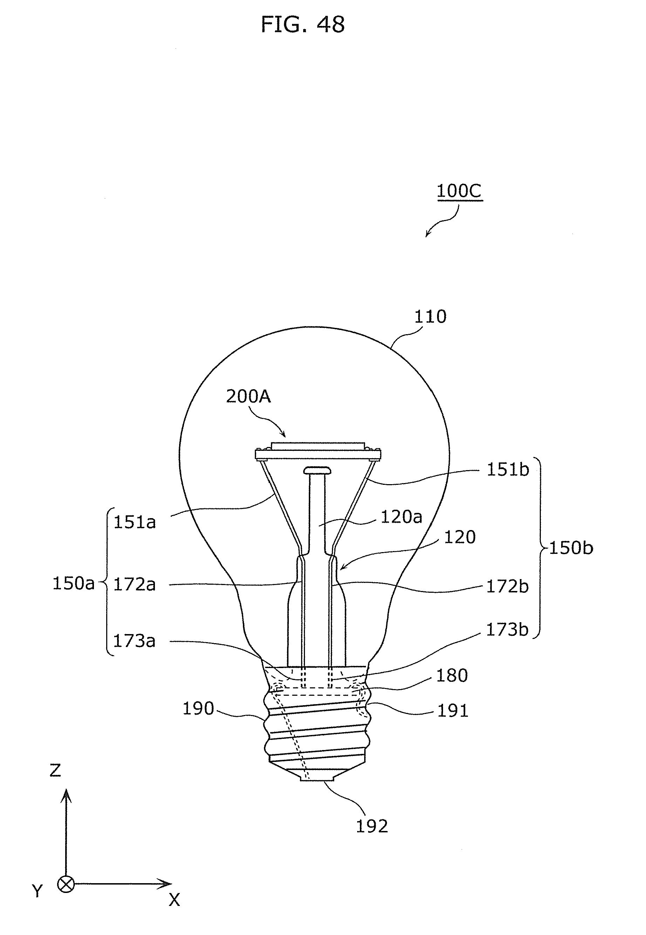

FIG. 48 is a front view of the lightbulb-shaped lamp according to the embodiment 4.

The lightbulb-shaped lamp 100C is different from the lightbulb-shaped lamp 100 in FIG. 1 in that lead wires 150a and 150b are provided instead of the lead wires 170a and 170b, and an LED module 200A is provided instead of the LED module 200. The rest of the structure of the lightbulb-shaped lamp 100C is identical to the lightbulb-shaped lamp 100. Accordingly, the detailed description is not repeated.

The lead wires 150a and 150b have the same structure and function as the lead wires 170a and 170b. Accordingly, the detailed description for the lead wires 150a and 150b is omitted.

Note that, in FIG. 48, the lighting circuit 180 and part of lead wires 150a and 150b for power supply and for support which are positioned inside a base 190 are illustrated in dotted lines.

The LED module 200A is electrically connected to the lead wires 150a and 150b.

The lead wire 150a is a composite wire including an internal lead wire 151a, a Dumet wire 172a, and an external lead wire 173a joined in order. The lead wire 150b is a composite wire including an internal lead wire 151b, a Dumet wire 172b, and an external lead wire 173b joined in order.

In the following description, each of the lead wire 150a and 150b are simply referred to as the lead wire 150. Furthermore, in the following description, each of the internal lead wires 151a and 151b may be simply referred to as the internal lead wire 151.

The internal lead wire 151 is an electric wire extending from the fixing part 120 to the LED module 200A. The internal lead wire 151 is joined with the base mount 210a, and supports the LED module 200A (the base mount 210a). Stated differently, the base mount 210a to be described later is supported by the lead wires 150a and 150b.

In addition, two lead wires 150 do not have to be provided. For example, when the lightbulb-shaped lamp 100C includes a plurality of the LED modules 200A in the globe 110, two lead wires 150 may be provided for each of the LED modules 200A. Accordingly, the lightbulb-shaped lamp 100C may include the lead wires 150 twice in number as the number of the LED modules 200A.

Among the internal lead wire 151, the Dumet wire 172, and the external lead wire 173 composing the lead wire 150, the fixing part 120 seals the Dumet wire 172. To put it differently, the fixing part 120 fixes the lead wire 150 exposing a part of the lead wire 150 (the internal lead wire 151).

The globe 110 covers the LED module 200A, part of the lead wires 150a and 150b, a part of the fixing part 120, and others. The LED module 200A is positioned at a part around the center of the globe 110. The globe 110 is made of a translucent material, as described above.

With this, the lightbulb-shaped lamp 100C can reduce the loss of light emitted by the semiconductor light-emitting device 300 caused by the globe 110.

The light from the LED module 200A passes through the globe 110, and is emitted to outside.

Since the LED module 200A is positioned around the center of the globe 110, omnidirectional light distribution property is achieved when the LED module 200A emits light.

The lighting circuit 180 is electrically connected to the lead wires 150a and 150b.

### (The configuration of LED module)

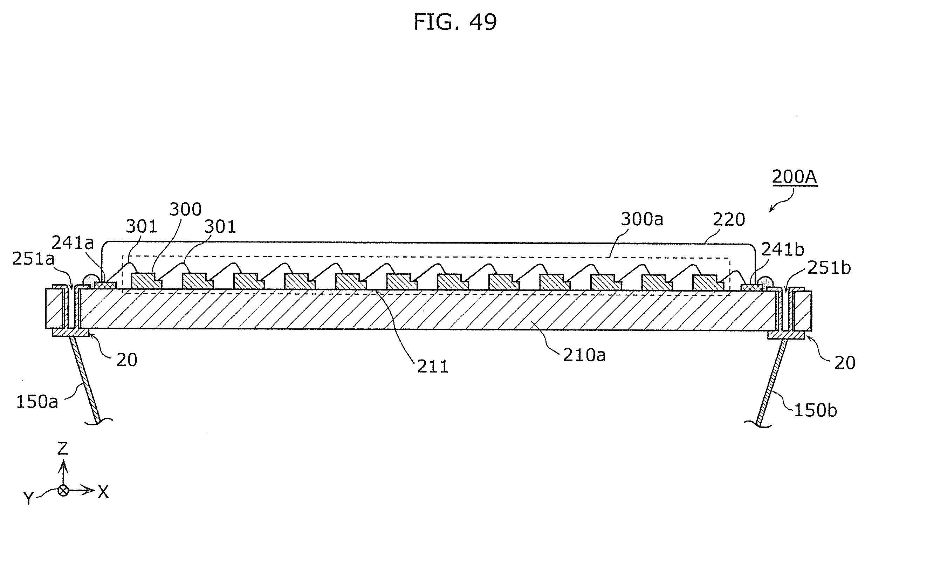

FIG. 49 is a cross-sectional view illustrating the configuration of the LED module 200A. Note that, the lead wires 150a and 150b not included in the LED module 200A are also illustrated in FIG. 49.

Note that, the details on the shape of the lead wires 150a and 150b shall be described later.

The LED module 200A is different from the LED module 200 illustrated in FIG. 4 in that a base mount 210a is included instead of the base mount 210. The rest of the configuration of the LED module 200A is identical to the LED module 200. Accordingly, the detailed description is not repeated.

The LED module 200A is housed in the globe 110, and is preferably positioned at the center of the sphere defined by the globe 110. With this structure, the light bulb shaped lamp 100A can achieve omnidirectional light distribution property when the light bulb shaped lamp 100 is switched on. The omnidirectional light distribution property is approximated to a common incandescent light bulb using conventional filament coil.

As shown in FIG. 49, the LED module 200A includes the base mount 210a described above, a plurality of semiconductor light-emitting devices 300, and a sealing part 220.

The structure of the base mount 210a has been illustrated using FIG. 42. Accordingly, the detailed description for the integrated structure is not repeated.

The hole fixed part 20 to be described later is formed at the end portion of each of the lead wires 150a and 150b. Each of the conductive components 20 is connected to the power supply terminal 241a or the power supply terminal 241b by solder. Accordingly, the lead wires 150a and 150b are electrically connected to the power supply terminals 241a and 241, respectively. To put it differently, the lead wires 150a and 150b are fixed to the base mount 210a (the LED module 200A) by solder.

The power is supplied to the semiconductor light-emitting devices 300 composing the group of light-emitting devices 300a from the lead wires 150a and 150b.

To put it differently, the lead wires 150a and 150b are electric wires for supplying power to the semiconductor light-emitting devices 300. More specifically, the lead wires 150a and 150b are electric wires for supplying power to the LED module 200A as the light-emitting module.

Note that, if the shape of the base mount 210a is a quadrangular prism, the semiconductor light-emitting devices 300 composing the group of light-emitting devices 300a may be formed on a side surface of the base mount 210a different from the main surface 211.

The LED module 200A is fixed by the lead wires 150a and 150b such that the main surface 211 of the base mount 210a faces toward the top of the globe 110.

Since the base mount 210a is translucent, the white light emitted from the linear sealing part 220 transmits the inside of the base mount 210a and is emitted from the back surface and the side surfaces of the base mount 210a.

The following shall describe the structure for fixing the LED module included in the light bulb shaped lamp in detail.

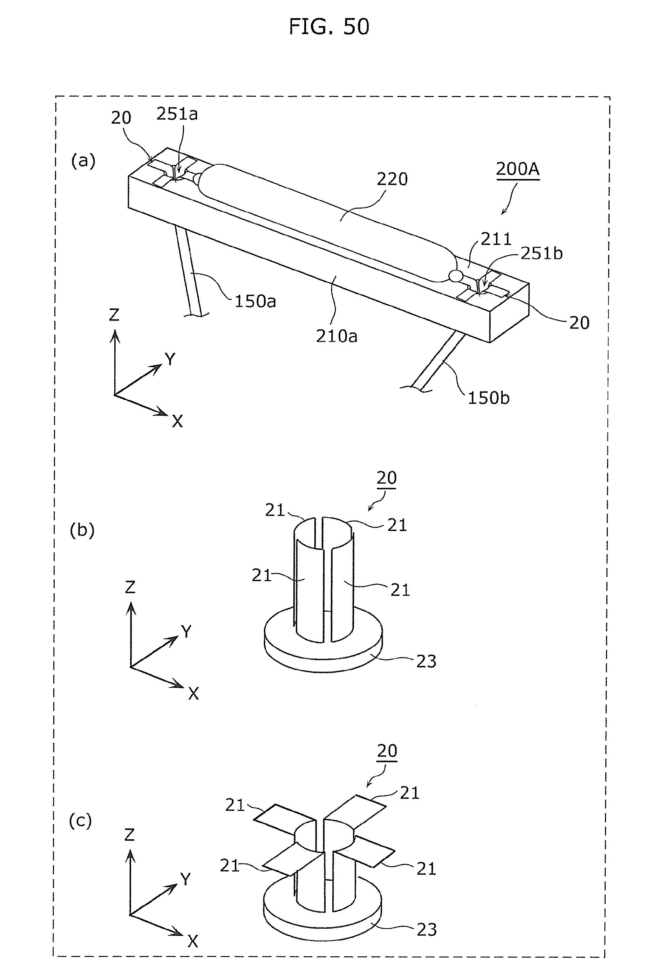

FIG. 50 is a diagram for describing the fixing structure according to the embodiment 4. The fixing structure for the LED module 200A shall be described in the embodiment 4.

The fixing structure according to the embodiment 4 shall be described with reference to FIG. 49 and FIG. 50.

(a) in FIG. 50 is an enlarged view of the LED module 200A fixed by the lead wires 150a and 150b.

(b) in FIG. 50 is a diagram illustrating the shape of the hole fixed part 20 before fixed to the LED module 200A.

(c) in FIG. 50 is a diagram illustrating the shape of the hole fixed part 20 before fixed to the LED module 200A.

As illustrated in FIG. 49 and FIG. 50, the hole fixed parts 20 are formed at the end of the lead wires 150a and 150b. The hole fixed part 20 is a part inserted into the hole 251 and fixed to the hole 251. Stated differently, the hole fixed part 20 is a part for fixing the lead wire 150 with the base mount 210a, using the hole 251.

The hole fixed parts 20 are end portions of the lead wires 150a and 150b formed into shapes of the hole fixed part 20 illustrated in FIG. 49, (a) in FIG. 50 and (c) in FIG. 50. Stated differently, the hole fixed part 20 and the lead wire 150 are integrally formed.

Note that, the hole fixed part 20 and the lead wire 150 are not limited to the integrally formed structure. For example, the hole fixed part 20 may be weld to the end of the lead wire 150.

As illustrated in (b) in FIG. 50, the hole fixed part 20 includes four leads 21 and a supporting part 23.

Each of the leads 21 and the supporting part 23 are composed of the same material (metal) as the material composing the lead wire 170. The lead 21 is a bendable conductive metal.

The supporting part 23 is board-shaped. The size of the supporting part 23 in the X-axis direction is larger than the diameter of the holes 251a and 251b. Each lead 21 is formed on the main surface of the supporting part 23.

Accordingly, when fixing each lead 150 with the base mount 210a, the lead 21 in each lead wire 150 passes through the hole 251 in the base mount 210a, the position of the base mount 210a in the globe 110 is fixed by the upper surface (main surface) of the supporting part 23 contacting the base mount 210a. Stated differently, the supporting part holds the part in the periphery of the hole 251 in the second surface opposite to the main surface 211 (the first surface) of the base mount 210a.

Stated differently, the hole fixed part 20 (supporting part 23) of the lead wire 150 is capable of positioning the base mount 210a in the globe 110 when fixing the lead wire 150 to the base mount 210a.

Note that, the number of the leads 21 included in the hole fixed part 20 is not limited to four, but may be three or larger than or equal to 5.

As illustrated in (a) in FIG. 50 and (c) in FIG. 50, the part of the leads 21 of the hole fixed part 20, projecting from the holes 251 are crimped (bent) such that the projecting part contact the main surface 211 of the base mount 210a.

Stated differently, part of each of the four leads 21 is crimped from the second surface toward the main surface (the first surface) of the base mount 210a through the hole 251 and contacting the main surface 211 (the first surface) of the base mount 210a. The hole fixed part 20 is fixed to the hole 251 by clipping the periphery of the hole 251 in the main surface 211 (the first surface) of the base mount 210a and the periphery of the hole 251 in the second surface of the base mount 210a. Accordingly, the hole fixed part 20 is firmly fixed to the hole 251.

Accordingly, the hole fixed part to be inserted into the hole 251 and fixed to the hole 251 is formed at the end of each of the lead wires 150.

One lead 21 in the hole fixed part 20 fixed to the hole 251a is electrically connected to the wire bonding part 331 of the left-end semiconductor light-emitting device included in the group of light-emitting devices 300a. One of the leads 21 in the hole fixed part 20 fixed to the hole 251b is electrically connected to the wire bonding part 332 of the right-end semiconductor light-emitting device in the group of light-emitting devices 300a.

To put it differently, the lead wires 150a and 150b are electrically connected to the group of light-emitting devices 300a such that DC power from the lighting circuit 180 can be supplied to the group of light-emitting devices 300a.

With the structure described above, the base mount 210a on which the semiconductor light-emitting devices 300 are mounted is supported by the lead wires 150a and 150b each having the hole fixed part 20 firmly fixed to the hole 251. Accordingly, the base mount 210a can be firmly fixed by the lead wires 150a and 150b. Accordingly, the base mount on which the semiconductor light-emitting device is mounted is fixed firmly.

In addition, the DC power can be supplied to the group of light-emitting devices 300a by using the lead wires 150a and 150b.

Furthermore, the lead wire 150 supports the base mount 210a on which semiconductor light-emitting devices 300 are mounted. With this, it is possible to suppress a large part of the light emitted by the semiconductor light-emitting device 300 mounted on the base mount 210a being blocked.

Furthermore, the base mount 210a is translucent. With this, it is possible to prevent the large part of the light emitted by the semiconductor light-emitting device 300 from being blocked. Accordingly, a sufficient light distribution angle can be achieved.

### Variation 1 of Embodiment 4

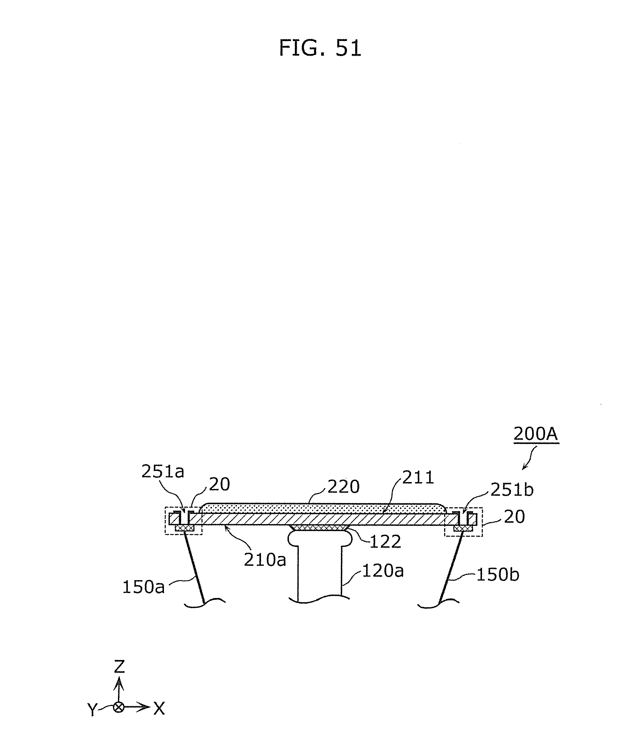

FIG. 51 is a cross-sectional view for describing the fixing structure according to the variation 1 of the embodiment 4. The fixing structure for the LED module 200A shall be described in the variation 1 of the embodiment 4.

The variation 1 of the embodiment 4 is different from the structure in the Embodiment 4 illustrated in FIG. 49 and FIG. 50 in that the base mount 210a is fixed by a rod part 120a of the fixing part 120 as the stem as well. The rest of the structure for fixing the base mount 210a is identical to the embodiment 4. Accordingly, the detailed description is not repeated.

As described above, the fixing part 120 as the stem is provided on a side (the second surface) opposite to the main surface 211 of the base mount 210a.

The shape of the fixing part 120 in the variation 1 of the embodiment 4 is described as the rod part 120a of the fixing part 120 extending to the vicinity of the surface opposite to the main surface 211 of the base mount 210a.

The surface (the second surface) opposite to the main surface 211 of the base mount 210a is fixed to the tip of the rod part 120a of the fixing part 120 by adhesive 122. The surface (the second surface) opposite to the main surface 211 of the base mount 210a is fixed to the tip of the rod part 120a of the fixing part 120. Stated differently, the base mount 210a is also supported by the rod part 120a.

According to the structure in the variation 1 of the embodiment 4, the base mount 210a is supported by the rod part 120a more firmly than the fixing structure according to the embodiment 4. Accordingly, the base mount 210a (the LED module 200A) is fixed even more firmly than the fixing structure in the embodiment 4.

In addition, the shape of the fixing part 120 may allow the tip of the rod part 120a of the fixing part 120 contacts the surface opposite to the main surface 211 of the base mount 210a. In this case, the adhesive 122 may not be necessary.

In the following description, a lightbulb-shaped lamp according to the variation 1 of the embodiment 4 may be referred to as a lightbulb-shaped lamp A41.

### Variation 2 of Embodiment 4

The fixing structure for the LED module 200A shall be described in the variation 2 of the embodiment 4.

In the variation 2 of the embodiment 4, the four LED modules 200A are also referred to as an LED module 200Aa, 200Ab, 200Ac, and 200Ad in order to distinguish the four LED modules 200A. The base mounts corresponding to the LED modules 200Aa, 200Ab, 200Ac, and 200Ad are also referred to as the base mount 210aa, 210ab, 210ac, and 210ad, respectively.

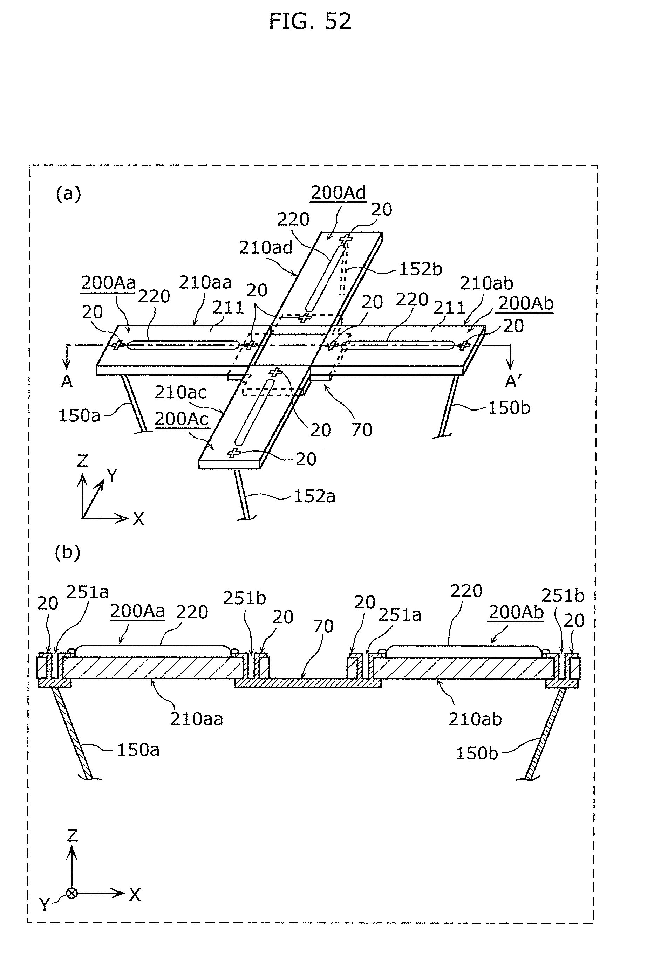

FIG. 52 is a cross-sectional view for describing the fixing structure according to the variation 2 of the embodiment 4.

(a) in FIG. 52 illustrates the LED modules 200Aa, 200Ab, 200Ac, and 200Ad fixed.

(b) in FIG. 52 is a cross-sectional view illustrating the LED modules 200Aa, 200Ab, 200Ac, and 200Ad fixed. More specifically, (b) in FIG. 52 is a cross-sectional view of LED modules along the line A-A' in (a) in FIG. 52.

In the following description, a lightbulb-shaped lamp according to the variation 2 of the embodiment 4 may be referred to as a lightbulb-shaped lamp A42. The lightbulb-shaped lamp A42 is different from the lightbulb-shaped lamp 100C according to the embodiment 4 illustrated in FIG. 46 to FIG. 49 and others in that the LED modules 200Aa, 200Ab, 200Ac, and 200Ad integrated by a connecting part 70 are included instead of the LED module 200A, and fixing wires 152a and 152b are further included. The rest of the structure of the lightbulb-shaped lamp A42 is identical to the lightbulb-shaped lamp 100C. Accordingly, the detailed description is not repeated.

In this case, the lightbulb-shaped lamp A42 includes the base mount 210aa, 210ab, 210ac, and 210ad integrated by the connecting part 70, as illustrated in (a) in FIG. 52. Stated differently, the lightbulb-shaped lamp A42 has more than one base mount. Each of the base mount 210aa, 210ab, 210ac, and 210ad is board-shaped. Each of the base mount 210aa, 210ab, 210ac, and 210ad is not only board-shaped, but may be in a shape of quadrilateral prism.

The configurations of the LED modules 200Aa, 200Ab, 200Ac, and 200Ad are identical to the configuration of the LED module 200A. Stated differently, a plurality of the semiconductor light-emitting devices 300 are mounted on the main surface 211 of each of the base mounts 210aa, 210ab, 210ac, and 210ad corresponding to the LED modules 200Aa, 200Ab, 200Ac, and 200Ad, respectively. Accordingly, the group of light-emitting devices 300a is formed on the main surface 211 of each of the base mounts 210aa, 210ab, 210ac, and 210ad.

Furthermore, in the same manner as the base mount 210a in FIG. 49, the holes 251a and 251b are provided on ends of the base mount 210a in the longer direction of the base mounts 210aa, 210ab, 210ac, and 210ad. As described above, each of the holes 251a and 251b is a through hole passing through the base mount 210a.

In the following description, each of the holes 251a and 251b is referred to as a first hole or a second hole, depending on the position of the hole in the corresponding base mount 210. Stated differently, each of the base mounts has the first hole and the second hole passing through the base mount.

The hole fixed part 20 is firmly fixed to each of the holes 251a and 251b in the base mount 210a by using the fixing structure illustrated in FIG. 50. More specifically, the hole fixed part 20 is firmly fixed to each of the first hole and the second hole in the base mount 210.

As illustrated in (a) in FIG. 52, the four bases 210a are arranged such that one end of each of the bases 210a is close to one ends of the other bases 210a. Accordingly, the bases are arranged such that the one ends of the bases are close to one another.

In the following description, the hole 251 provided in one end of the base mount may be referred to as the second hole.

For example, in (b) in FIG. 52, the right end part of the base mount 210aa and the left end part of the base mount 210ab are close to each other. Stated differently, one ends of the base mounts close to one another include the right end part of the base mount 210aa and the left end part of the base mount 210ab in (b) in FIG. 52, for example. Accordingly, the hole 251b provided at the right end part of the base mount 210aa and the hole 251a provided at the left end part of the base mount 210ab are the second holes. Therefore, the second hole is provided at one ends of the base mounts close to one another.

Furthermore, in the following description, the hole 251 other than the second hole among the two holes 251 provided in the base mount is referred to as the first hole. For example, in (b) in FIG. 52, the hole 251a provided on the left end of the base mount 210aa and the hole 251b provided on the right end of the base mount 210ab are the first holes.

As illustrated in (a) in FIG. 52 and (b) in FIG. 52, the connecting part 70 integrates the hole fixed part 20 fixed to the second holes in the bases 210aa, 210ab, 210ac, 210ad. To put it differently, the four base mounts 210a are integrated by the connecting part 70 integrating the hole fixed parts 20 fixed to the second holes in the four base mounts 210a.

The base mounts are integrated by the connecting part integrating the hole fixed parts fixed to the second holes in the base mounts. Accordingly, the LED modules 200Aa, 200Ab, 200Ac, and 200Ad are integrated by the connecting part 70. The integrated LED modules 200Aa, 200Ab, 200Ac, and 200Ad are light-emitting modules.

As illustrated in (a) in FIG. 52, the connecting part 70 is cross-shaped when viewed from the Z-axis direction. The connecting part 70 is composed of a conductive material. The conductive material is metal, for example. The metal is, for example, stainless, aluminum, or others.

As described above, the hole fixed part 20 is formed at the end of each of the lead wires 150a and 150b. Stated differently, the hole fixed part 20 and the lead wire 150 are integrally formed.

Accordingly, the hole fixed part 20 to be fixed to the hole 251a provided at the left end part of the base mount 210aa is formed at the end of the lead wire 150a. The hole fixed part 20 to be fixed to the hole 251b provided at the right end part of the base mount 210ab is formed at the end of the lead wire 150b.

Stated differently, the hole fixed part 20 for a different hole provided on the base mounts integrated is formed at the end of each of the lead wires 150a and 150b. Accordingly, the hole fixed part 20 to be fixed to the first hole provided in at least one base of the bases integrated is provided at the end of the lead wire 150.

An end portion of the each of the fixing wires 152a and 152b is fixed by the fixing part 120, in the same manner as the lead wires 150a and 150b in FIG. 46. Note that, the fixing wires 152a and 152b are metal wires not used for supplying power.

The shape of the fixing wires 152a and 152b is identical to the shape of the lead wire 150. In the following description, each of the fixing wires 152a and 152b may be simply referred to as the fixing wire 152. Stated differently, the hole fixed part 20 is formed at the end portion of each of the lead wire 152. Stated differently, the hole fixed part 20 and the fixing wire 152 are integrally formed.

Accordingly, as illustrated in (a) in FIG. 52, the four base mounts integrated are supported by the lead wires 150a and 150b and the fixing wires 152a and 152b each having the hole fixed part 20. Stated differently, the base mounts integrated are supported by at least two of the lead wires 150. Stated differently, at least one of the base mounts integrated are supported by the lead wire 150.

The group of light-emitting devices 300a formed on the base mount 210aa, the group of light-emitting devices 300a formed on the base mount 210ad, the group of light-emitting devices 300a formed on the base mount 210ac, and the group of light-emitting device 300a formed on the base mount 210ab are electrically connected in series.

The lead wires 150a and 150b are electrically connected to the group of light-emitting devices 300a such that the DC power from the lighting circuit 180 can be supplied to the groups of light-emitting devices 300a corresponding to the base mount 210aa, 210ab, 210ac, and 210ad through the hole fixed parts 20.

With the structure described above, the base mounts 210a integrated are supported by the lead wire 150 and the fixing wire 152 each having the hole fixed part 20 at the end. The hole fixed part 20 is firmly fixed to the base mount. With this structure, it is possible to fix the base mounts 210a integrated may be fixed firmly. Accordingly, the base mounts integrated on which the semiconductor light-emitting device is mounted are fixed firmly.

In addition, the DC power can be supplied to the four groups of light-emitting devices 300a by using the lead wires 150a and 150b and the fixing wires 152a and 152b.

Note that, in the embodiment 4, the number of the base mounts 210a integrated is described as four. However, it is not limited to this example. The number of the base mounts 210a to be integrated may be 2, 3, or more than or equal to 5, for example. If the number of the base mounts 210a to be integrated is three, the connecting part 70 is T-shaped, for example.

Note that, the fixing wires 152a and 152b may be wires for supplying power to the group of light-emitting devices 300a in the same manner as the lead wires 150a and 150b. In this case, the fixing wires 152a and 152b are electrically connected to the lighting circuit 180 such that the DC power from the lighting circuit 180 can be transmitted therethrough. In this case, the fixing wires 152a and 152b and the lead wires 150a and 150b are electrically connected to group of light-emitting devices 300a such that the power can be supplied to the group of light-emitting devices 300a.

The connecting part 70 integrating the base mounts 210a may be fixed by using the rod part 120a of the fixing part 120, in the same manner as the configuration in FIG. 51. With this structure, it is possible to fix the base mounts 210a integrated very firmly.

### Variation 3 of Embodiment 4

The fixing structure for the LED module 200E having a base mount with a shape different from the embodiments described above shall be described in the variation 3 of the embodiment 4.

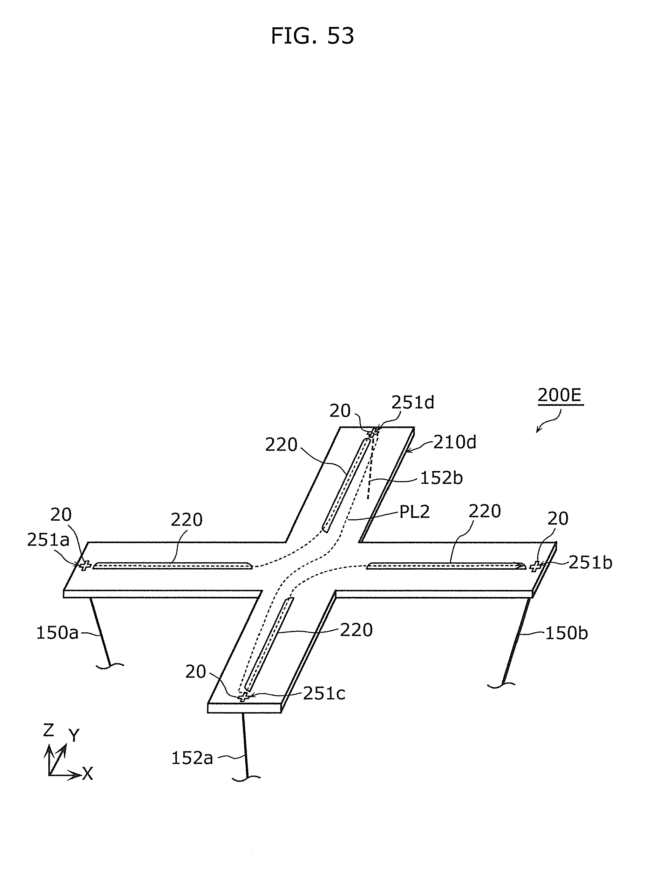

FIG. 53 is a cross-sectional view for describing the fixing structure according to the variation 3 of the embodiment 4.

In the following description, a lightbulb-shaped lamp according to the variation 3 of the embodiment 4 may be referred to as a lightbulb-shaped lamp A43. The lightbulb-shaped lamp A43 is different from the lightbulb-shaped lamp 100C according to the embodiment 4 illustrated in FIG. 46 and FIG. 49 in that the LED module 200E is included instead of the LED module 200A, and fixing wires 152a and 152b are further included. The structure of the lightbulb-shaped lamp A43 is identical to the lightbulb-shaped lamp 100C. Accordingly, the detailed description is not repeated.

As illustrated in FIG. 53, the LED module 200E includes the base mount 210d, four groups of light-emitting devices 300a that are not illustrated, and four sealing parts 220.

Since the base mount 210d is described with reference to FIG. 45, the detailed description is not repeated. The following is a simplified description.

As illustrated in FIG. 53, the holes 251a, 251b, 251c, and 251d are provided at the four ends of the base mount 210d.

In the following description, each of the holes 251a, 251b, 251c, and 251d may be simply referred to as the hole 251.

The holes 251 in FIG. 53 have the same shape as the hole 251 illustrated in FIG. 41 and others. The hole fixed part 20 is firmly fixed to each of the holes 251 in FIG. 53, as described with reference to FIG. 50.

The four groups of light-emitting devices 300a that are not illustrated are formed on the base mount 210d. The four groups of light-emitting devices 300a are sealed by the four sealing parts 220, respectively.

Note that, the four groups of light-emitting devices 300a formed on the base mount 210d are electrically connected in series such that the current flows through the current path PL2, for example.

The LED module 200E is fixed by the lead wires 150a and 150b, and the fixing wires 152a and 152b.

Since the shape, structure, and function of the lead wires 150a and 150b and the fixing wires 152a and 152b are the same as described with reference to FIG. 52, the detailed description shall not be repeated. The hole fixed part 20 is formed at the end of each of the lead wires 150a and 150b and the fixing wires 152a and 152b. Accordingly, the base mount 210d is supported by the lead wires 150a and 150b, and the fixing wires 152a and 152b.

With the structure described above, the cross-shaped base mount 210d is supported at the four parts by the lead wires 150 and the fixing wires 152 each having the hole fixed part 20 at the end. The hole fixed part 20 is firmly fixed to the base mount 210d. With this structure, even if the base mount is cross-shaped, the LED module 200E (the base mount 210d) can be fixed firmly.

Note that, the LED module 200E may be fixed by the rod part 120a of the fixing part 120 at the center part on the back surface of the base mount 210d, as illustrated in the fixing structure according to the variation 1 of the embodiment 4 (FIG. 51).

Note that, the fixing wires 152a and 152b may be wires for supplying power to the group of light-emitting devices 300a in the same manner as the lead wires 150a and 150b. In this case, the fixing wires 152a and 152b are electrically connected to the lighting circuit 180 such that the DC power from the lighting circuit 180 can be transmitted therethrough. In this case, the fixing wires 152a and 152b and the lead wires 150a and 150b are electrically connected to group of light-emitting devices 300a such that the power can be supplied to the group of light-emitting devices 300a.

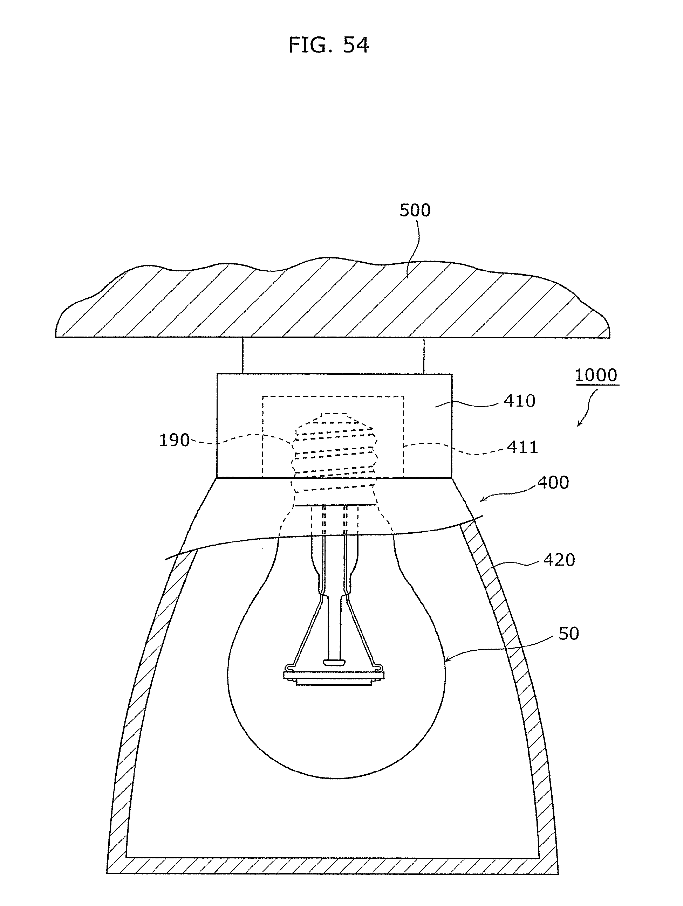

For example, the present invention may not only be implemented as the light bulb shaped lamp, but also as a lighting apparatus including the light bulb shaped lamp. The following shall describe the lighting apparatus according to an aspect of the present invention with reference to FIG. 54.

FIG. 54 is a schematic cross-sectional view of the lighting apparatus 1000 according to an aspect of the present invention.

The lighting apparatus 1000 according to the embodiment is used attached to a ceiling 500 in a room, for example. As illustrated in FIG. 54, the lighting apparatus 1000 includes a light bulb shaped lamp 50 and a lighting equipment 400.

The lightbulb-shaped lamp 50 is a lightbulb-shaped lamp according to the embodiments or the variations of the embodiments. Stated differently, the lightbulb-shaped lamp 50 is one of the lightbulb-shaped lamps 100, 100A, 100B, and 100C, the lightbulb-shaped lamps according any one of the embodiments 1 to 4, and the lightbulb-shaped lamps according to the variations of any one of the embodiments 1 to 4.

For example, the lightbulb-shaped lamp 50 is the lightbulb-shaped lamp 100 in FIG. 1. Accordingly, the lightbulb-shaped lamp 50 has a base 190.

The lighting equipment 400 is for turning the light bulb shaped lamp 50 on and off. The lighting equipment 400 includes an equipment body 410 attached to the ceiling 500 and a lamp cover 420 covering the light bulb shaped lamp 50.

The equipment body 410 has a socket 411. The base 190 of the light bulb shaped lamp 50 is screwed into the socket 411. Power is supplied to the light bulb shaped lamp 50 through the socket 411.

Note that the lighting apparatus 1000 described here is an example of the lighting apparatus 1000 according to an aspect of the present invention. The lighting apparatus according to an aspect of the present invention may hold the lightbulb-shaped lamp 50 and includes a socket for supplying power to the lightbulb-shaped lamp 50. Note that, the base 190 does not screwed into the base 190, but may be simply inserted.

Furthermore, the lighting apparatus 1000 illustrated in FIG. 54 includes one lightbulb-shaped lamp 50. However, the lighting apparatus 1000 may include more than one lightbulb-shaped lamp 50.

Although only some exemplary embodiments of the light bulb shaped lamp according to the present invention have been described in detail above, those skilled in the art will readily appreciate that many modifications are possible in the exemplary embodiments without materially departing from the novel teachings and advantages of the present invention. Accordingly, all such modifications are intended to be included within the scope of the present invention.

The herein disclosed subject matter is to be considered descriptive and illustrative only, and the appended Claims are of a scope intended to cover and encompass not only the particular embodiments disclosed, but also equivalent structures, methods, and/or uses.

### [Industrial Applicability]

The present invention may be used as a lightbulb-shaped lamp which suppresses that the large amount of the light emitted from the semiconductor light-emitting device is blocked.

### [Reference Signs List]

20 Hole fixed part
21 Lead
30, 31 Conductive component
40a, 40b, 40c, 40d End portion fixing part
50, 100, 100A, 100B, 100C Lightbulb-shaped lamp
61, 62, 63, 70 Connecting part
110 Globe
120 Fixing part
120a Rod part
130a, 130b, 132a, 132b, 140a, 140b, 150a, 150b, 170a, 170b, 174a, 174b, 175a, 175b Lead wire
131a, 131b, 133a, 133b, 142a, 142b, 152a, 152b, 160a, 160b, 161a, 161b, 162a, 162b Fixing wire
180 Lighting circuit
190 Base
200, 200A, 200Aa, 200Ab, 200Ac, 200Ad, 200D, 200E, 200B, 200C, 200N, 200Na, 200Nb, 200Nc, 200Nd, 201A, 202A LED module
210, 210a, 210aa, 210ab, 210ac, 210ad, 210b, 210c, 210d, 210n, 210na, 210nb, 210nc, 210nd Base mount
220 Sealing part
250a, 250b, 250c, 250d, 251a, 251b, 251c, 251d Hole
300 Semiconductor light-emitting device
1000 Lighting apparatus

## Claims

1. A light bulb shaped lamp comprising:
a light-emitting module including: a base mount; and a semiconductor light-emitting device mounted on the base mount; and
a lead wire for supplying power to the light-emitting module, wherein the base mount is supported by the lead wire.

2. The light bulb shaped lamp according to Claim 1,
wherein the lead wire includes an elastic part which is elastic.

3. The light bulb shaped lamp according to Claim 2,
wherein the elastic part is provided in the vicinity of the base mount.

4. The light bulb shaped lamp according to Claim 2 or 3,
wherein the base mount has a first surface and a second surface opposite to the first surface, and
the base mount has a hole passing through the base mount from the first surface to the second surface.

5. The light bulb shaped lamp according to Claim 4,
wherein the lead wire is provided such that a part of the lead wire passes through the hole from the second surface toward the first surface of the base mount,
the elastic part is at least a part of the lead wire not passing though the hole, and
the base mount is supported by the elastic part of the lead wire.

6. The light bulb shaped lamp according to Claim 4,
wherein a hole fixed part inserted into the hole and fixed to the hole is formed at an end portion of the lead wire,
the hole fixed part includes a board-shaped supporting part and a conductive lead fixed to a main surface of the supporting part,
a part of the lead passes through the hole from the second surface toward the first surface of the base mount and is crimped such that the part of the lead contacts the first surface of the base mount, and
the supporting part supports a periphery of the hole on the second surface of the base mount.

7. The light bulb shaped lamp according to Claim 4,
wherein the hole is filled with a conductive component electrically connected to the semiconductor light-emitting device, and
the lead wire is electrically connected to the conductive component from a side closer to the second surface of the base mount.

8. The light bulb shaped lamp according to any one of Claims 1 to 3,
wherein a bent part clipping an end portion of the base mount is formed at an end portion of the lead wire.

9. The light bulb shaped lamp according to any one of Claims 1 to 3,
wherein an end portion fixing part clipping an end portion of the base mount is provided at the end portion of the base mount, and
the end portion of the lead wire is connected to the end portion fixing part.

10. The light bulb shaped lamp according to any one of Claims 1 to 3, further comprising
a plurality of the lead wires,
wherein a bent part is formed at an end portion of each of the lead wires, and
each of the bent parts in the lead wires clips one of the end portions of the base mount.

11. The light bulb shaped lamp according to Claim 10,
wherein at least two end portions of the base mount clipped by the bent parts are parallel to the same direction.

12. The light bulb shaped lamp according to Claim 10,
wherein at least two end portions of the base mount clipped by the bent parts are corners of the base mount.

13. The light bulb shaped lamp according to any one of Claims 1 to 3, further comprising
a plurality of the base mounts,
wherein the semiconductor light-emitting device is mounted on each of the base mounts,
the base mounts are integrated by a connecting part having a shape for integrating the base mounts, and
an end portion of at least one of the base mounts integrated is supported by the lead wire.

14. The light bulb shaped lamp according to Claim 13, further comprising
at least two of the lead wires,
wherein the integrated base mounts are supported by the at least two lead wires.

15. The light bulb shaped lamp according to Claim 14,
wherein an end portion fixing part is provided at each of at least two end portions of the integrated base mounts, the end portion fixing part clipping a corresponding one of the two end portions, and
the two lead wires are connected to the two end portion fixing parts.

16. The light bulb shaped lamp according to any one of Claims 2 to 15,
wherein the elastic part is U-shaped.

17. The light bulb shaped lamp according to Claim 1,
wherein an end portion clipping part is formed at an end portion of the lead wire, the end portion clipping part clipping an end portion of the base mount, and
the base mount is clipped and supported by the end portion clipping part in the lead wire.

18. The light bulb shaped lamp according to Claim 17,
wherein the end portion clipping part is a bent part which is the end portion of the lead wire bent.

19. The light bulb shaped lamp according to Claim 18,
wherein the bent part is U-shaped.

20. The light bulb shaped lamp according to Claim 17,
wherein a shape of a main surface of the base mount is a quadrilateral, and
the end portion clipping part clips a part of the base mount corresponding to one side of the quadrilateral.

21. The light bulb shaped lamp according to Claim 17, further comprising
a plurality of the lead wires,
wherein a plurality of the end portion clipping parts are provided such that each of the end portion clipping parts is provided for a corresponding one of the lead wires and clips a corresponding one of a plurality of end portions of the base mount.

22. The light bulb shaped lamp according to Claim 21,
wherein each of the end portion clipping parts is a bent part which is the end portion of the lead wire corresponding to the end portion clipping part.

23. The light bulb shaped lamp according to Claim 22,
wherein at least two end portions of the base mount clipped by the bent parts are parallel to the same direction.

24. The light bulb shaped lamp according to Claim 22,
wherein at least two end portions of the base mount clipped by the bent parts are corners of the base mount.

25. The light bulb shaped lamp according to Claim 17, further comprising
a plurality of the base mounts,
wherein the semiconductor light-emitting device is mounted on each of the base mounts,
the base mounts are integrated by a connecting part having a shape for integrating the base mounts,
the end portion clipping part clipping at least one of the base mounts integrated is formed at the end portion of the lead wire, and
at least one of the base mounts integrated is supported by the lead wire.

26. The light bulb shaped lamp according to Claim 25, further comprising
at least two of the lead wires,
wherein the end portion clipping part is formed at the end portion of each of the two lead wires, the end portion clipping part being for clipping a different end portion of the integrated base mounts, and
the integrated base mounts are supported by the at least two lead wires.

27. The light bulb shaped lamp according to Claim 26,
wherein a shape of a main surface of each of the base mounts is a quadrilateral, and
the end portion clipping part clips a part corresponding to one side of a quadrilateral of a different base mount.

28. The light bulb shaped lamp according to Claim 1,
wherein the base mount has a hole passing through the base mount,
the hole is filled with a conductive component electrically connected to the semiconductor light-emitting device,
the conductive component is connected to the lead wire, and the base mount is supported by the lead wire connected to the conductive component.

29. The light bulb shaped lamp according to Claim 28,
wherein the base mount has a first surface and a second surface opposite to the first surface,
an end portion of the lead wire is bent such that a part parallel to the second surface is formed, and
the part of the end portion of the lead wire parallel to the second surface is connected to the conductive component.

30. The light bulb shaped lamp according to Claim 28 or 29,
wherein the base mount has a first surface and a second surface opposite to the first surface, and
the lead wire is electrically connected to the conductive component from a side closer to the second surface of the base mount.

31. The light bulb shaped lamp according to any one of Claims 28 to 30,
wherein the conductive component is composed of cermet.

32. The light bulb shaped lamp according to Claim 1,
wherein the base mount has a hole passing through the base mount,
a hole fixed part inserted into the hole and fixed to the hole is formed at an end portion of the lead wire, and
the base mount is supported by the lead wire.

33. The light bulb shaped lamp according to Claim 32,
wherein the base mount has a first surface and a second surface opposite to the first surface,
the hole passes through the first surface and the second surface, and
the hole fixed part is fixed to the hole by clipping the base mount in a peripheral part of the hole on the first surface and in a peripheral part of the hole on the second surface.

34. The light bulb shaped lamp according to Claim 32 or 33,
wherein the hole fixed part and the lead wire are integrally formed.

35. The light bulb shaped lamp according to any one of Claims 1 to 34,
wherein the base mount has a first surface and a second surface opposite to the first surface,
the light bulb shaped lamp further comprises
a fixing part which fixes the lead wire, with a part of the lead wire exposed,
the fixing part includes a rod part which is rod-shaped,
the fixing part is provided on a side closer to the second surface of the base mount, and
the second surface of the base mount is fixed to a tip of the rod part of the fixing part.

36. The light bulb shaped lamp according to Claim 35,
wherein the second surface of the base mount is fixed to the tip of the rod part of the fixing part by adhesive.

37. The light bulb shaped lamp according to Claim 35 or 36,
wherein the fixing part is made of a material transparent to visible light.

38. The light bulb shaped lamp according to Claim 32, further comprising
a plurality of the base mounts,
wherein the semiconductor light-emitting device is mounted on each of the base mounts,
each of the base mounts has a first hole and a second hole that pass through the base mount,
a plurality of the hole fixed parts are fixed to the first hole and the second hole in the base mount,
the base mounts are arranged such that one end portions of the base mounts are close to one another,
the second holes are provided in the one end portions of the base mounts close to one another,
the base mounts are integrated by a connecting part integrating the hole fixed parts fixed to the second holes in the base mounts,
the hole fixed part fixed to the first hole provided in at least one of the base mounts integrated is formed at an end portion of the lead wire, and
at least one of the base mounts integrated is supported by the lead wire.

39. The light bulb shaped lamp according to Claim 38, further comprising
at least two of the lead wires,
wherein a plurality of the hole fixed parts are formed at end portions of the two lead wires and at the base mounts integrated, and
the integrated base mounts are supported by the at least two lead wires.

40. A lighting apparatus comprising
the light bulb shaped lamp according to any one of Claims 1 to 39.
